# EUROPEAN PATENT APPLICATION

(11) **EP 4 819 118 A1**
(43) Date of publication of application: **07.10.2026**
(21) Application number: 25905994.7
(22) Date of filing: 29.07.2025
(51) Int. Cl.: G09G 3/3225

(54) **DISPLAY PANEL AND DISPLAY DEVICE**

(30) Priority: 16.12.2024 CN 202411855857
(71) Applicant: Wuhan Tianma Microelectronics Co., Ltd., Wuhan, Hubei 430205 (CN)
(72) Inventor: ZHANG, Wenshuai, Wuhan, Hubei 430205 (CN)
(74) Representative: Völkl Siebenson Patentanwälte - Partnerschaft mbB
(86) International application number: PCT/CN2025/111072
(87) International publication number: WO 2026/129654

(57) **Abstract**

The present disclosure provides a display panel and a display device, which relates to the field of display technologies, for optimizing the design of a shift register and reducing the space of the shift register occupied by the shift register in a panel bezel. The display panel includes: a pixel circuit including a first transistor and a second transistor; and a shift register including a plurality of cascaded shift units. The shift unit includes a first terminal and at least one second terminal, and the first terminal and the second terminal output different signals. the first terminal is electrically connected to a gate of the first transistor, and the second terminal is electrically connected to a gate of the second transistor.

## Description

The present application claims priority to Chinese Patent Application No. 202411855857.1, entitled "Display Panel and Display Device", filed on December 16, 2024, with the China Intellectual Property Administration, the content of which is incorporated herein by reference in its entirety.

### TECHNICAL FIELD

The present disclosure relates to the field of display technologies, and in particular, to a display panel and a display device.

### BACKGROUND

A display panel includes a pixel circuit and a shift register. The shift register is configured to provide a gate signal to a gate of a transistor in the pixel circuit, so as to control the transistor to be turned on or off. However, at present, due to the poor design of the shift register in the display panel, the shift register occupies a large space in a bezel, which is not conducive to optimizing the narrow bezel design of the display panel.

### SUMMARY

Embodiments of the present disclosure provides a display panel and a display device for optimizing the design of a shift register and reducing the space occupied by the shift register in a panel bezel.

In a first aspect, an embodiment of the present disclosure provides a display panel, including: a pixel circuit including a first transistor and a second transistor; and a shift register including a plurality of shift units that are cascaded. The shift unit include a first terminal and at least one second terminal, the first terminal and the second terminal are configured to respectively output signals different from each other, the first terminal is electrically connected to a gate of the first transistor, and the second terminal is electrically connected to a gate of the second transistor.

In a second aspect, based on the same inventive idea, an embodiment of the present disclosure further provides a display device including the above-described display panel.

The technical solutions according to the embodiments of the present disclosure have the following beneficial effects.

In the related art, when the gates of the first transistor and the second transistor need to receive different signals, two different shift registers respectively provide these two different signals independently. These two shift registers are independent of each other, resulting in a relatively large number of shift registers in the display panel, and the shift registers need to occupy a relatively large space in the bezel.

In the embodiments of the present disclosure, the original two shift registers are merged into one shift register capable of simultaneously outputting two different signals. In the merged shift register, part of the circuit logic of the original two shift registers can be shared, so as to simplify the circuit structure of the shift register. The shift register has a higher level of circuit integration, which not only can reduce the number of shift registers in the display panel, but also can reduce the number of switching transistors required in the shift registers, thereby greatly reducing the space occupied by the shift registers in the bezel, so as to optimize the narrow bezel design of the display panel.

### BRIEF DESCRIPTION OF DRAWINGS

In order to more clearly illustrate technical solutions of embodiments of the present disclosure, the drawings used in the embodiments are briefly described below. It should be noted that the drawings described below are merely some embodiments of the present disclosure, and other drawings may be obtained by those skilled in the art according to these drawings without any creative efforts.
FIG. 1 is a structural schematic diagram of a display panel according to an embodiment of the present disclosure;
FIG. 2 is a schematic diagram of an output signal of a shift register corresponding to FIG. 1;
FIG. 3 is another structural schematic diagram of a display panel according to an embodiment of the present disclosure;
FIG. 4 is a schematic diagram of an output signal of a shift register corresponding to FIG. 3;
FIG. 5 is a structural schematic diagram of a pixel circuit according to an embodiment of the present disclosure;
FIG. 6 is a structural schematic diagram of a shift unit according to an embodiment of the present disclosure;
FIG. 7 is a structural schematic diagram of a shift register according to an embodiment of the present disclosure;
FIG. 8 is a timing diagram corresponding to FIG. 7;
FIG. 9 is a schematic diagram of partitioning of a display panel according to an embodiment of the present disclosure;
FIG. 10 is a timing diagram in a first display mode according to an embodiment of the present disclosure;
FIG. 11 is a timing diagram in a second display mode according to an embodiment of the present disclosure;
FIG. 12 is another structural schematic diagram of a pixel circuit according to an embodiment of the present disclosure;
FIG. 13 is a structural schematic diagram of a second circuit according to an embodiment of the present disclosure;
FIG. 14 is a timing diagram corresponding to FIG. 13;
FIG. 15 is another structural schematic diagram of a second circuit according to an embodiment of the present disclosure;
FIG. 16 is a timing diagram corresponding to FIG. 15;
FIG. 17 is another timing diagram corresponding to FIG. 15;
FIG. 18 is another structural schematic diagram of a second circuit according to an embodiment of the present disclosure;
FIG. 19 is another structural schematic diagram of a second circuit according to an embodiment of the present disclosure;
FIG. 20 is a timing diagram corresponding to FIG. 19;
FIG. 21 is another structural schematic diagram of a second circuit according to an embodiment of the present disclosure;
FIG. 22 is another structural schematic diagram of a display panel according to an embodiment of the present disclosure;
FIG. 23 is a schematic diagram of a connection between a shift register and a clock line according to an embodiment of the present disclosure;
FIG. 24 is a timing diagram of signals provided by a plurality of clock lines corresponding to FIG. 23;
FIG. 25 is another structural schematic diagram of a shift register according to an embodiment of the present disclosure;
FIG. 26 is a timing diagram corresponding to FIG. 25;
FIG. 27 is another structural schematic diagram of a display panel according to another embodiment of the present disclosure;
FIG. 28 is a timing diagram corresponding to FIG. 27;
FIG. 29 is another structural schematic diagram of a display panel according to an embodiment of the present disclosure;
FIG. 30 is a timing diagram corresponding to FIG. 29;
FIG. 31 is another structural schematic diagram of a second circuit according to an embodiment of the present disclosure;
FIG. 32 is a structural schematic diagram of a first circuit according to an embodiment of the present disclosure;
FIG. 33 is a timing diagram corresponding to FIG. 32;
FIG. 34 is a structural schematic diagram of a first circuit according to an embodiment of the present disclosure;
FIG. 35 is another structural schematic diagram of a first circuit according to an embodiment of the present disclosure;
FIG. 36 is another structural schematic diagram of a first circuit according to an embodiment of the present disclosure;
FIG. 37 is another structural schematic diagram of a first circuit according to an embodiment of the present disclosure;
FIG. 38 is a timing diagram corresponding to FIG. 37;
FIG. 39 is another structural schematic diagram of a display panel according to an embodiment of the present disclosure;
FIG. 40 is a timing diagram corresponding to FIG. 39;
FIG. 41 is another structural schematic diagram of a first circuit according to an embodiment of the present disclosure;
FIG. 42 is a timing diagram corresponding to FIG. 41;
FIG. 43 is another structural schematic diagram of a first circuit according to an embodiment of the present disclosure;
FIG. 44 is another structural schematic diagram of a shift unit according to an embodiment of the present disclosure;
FIG. 45 is a timing diagram corresponding to FIG. 44;
FIG. 46 is another structural schematic diagram of a first circuit according to an embodiment of the present disclosure;
FIG. 47 is another structural schematic diagram of a shift unit according to an embodiment of the present disclosure;
FIG. 48 is another structural schematic diagram of a shift unit according to an embodiment of the present disclosure;
FIG. 49 is another structural schematic diagram of a shift unit according to an embodiment of the present disclosure;
FIG. 50 is another structural schematic diagram of a shift unit according to an embodiment of the present disclosure;
FIG. 51 is another structural schematic diagram of a shift unit according to an embodiment of the present disclosure;
FIG. 52 is another structural schematic diagram of a first circuit according to an embodiment of the present disclosure;
FIG. 53 is another structural schematic diagram of a first circuit according to an embodiment of the present disclosure;
FIG. 54 is a timing diagram corresponding to FIG. 53;
FIG. 55 is another structural schematic diagram of a first circuit according to an embodiment of the present disclosure;
FIG. 56 is a timing diagram corresponding to FIG. 55;
FIG. 57 is another structural schematic diagram of a first circuit according to an embodiment of the present disclosure;
FIG. 58 is a timing diagram corresponding to FIG. 57;
FIG. 59 is a schematic diagram of a connection between a shift register and a control line according to an embodiment of the present disclosure;
FIG. 60 is another structural schematic diagram of a pixel circuit according to an embodiment of the present disclosure;
FIG. 61 is a timing diagram of a signal output by a first terminal of a shift unit according to an embodiment of the present disclosure;
FIG. 62 is another schematic diagram of a connection between a shift register and a control line according to an embodiment of the present disclosure;
FIG. 63 is a timing diagram corresponding to FIG. 62;
FIG. 64 is another schematic diagram of a connection between a shift register and a control line according to an embodiment of the present disclosure;
FIG. 65 is a timing diagram corresponding to FIG. 64;
FIG. 66 is another timing diagram corresponding to FIG. 64;
FIG. 67 is another schematic diagram of a connection between a shift register and a control line according to an embodiment of the present disclosure;
FIG. 68 is a timing diagram corresponding to FIG. 67;
FIG. 69 is another timing diagram corresponding to FIG. 67;
FIG. 70 is another structural schematic diagram of a first circuit according to an embodiment of the present disclosure;
FIG. 71 is another schematic diagram of a connection between a shift register and a control line according to an embodiment of the present disclosure;
FIG. 72 is a timing diagram corresponding to FIG. 71;
FIG. 73 is another timing diagram corresponding to FIG. 71;
FIG. 74 is another structural schematic diagram of a first circuit according to an embodiment of the present disclosure;
FIG. 75 is another structural schematic diagram of a first circuit according to an embodiment of the present disclosure;
FIG. 76 is a timing diagram corresponding to FIG. 12;
FIG. 77 is another structural schematic diagram of a display panel according to an embodiment of the present disclosure;
FIG. 78 is a timing diagram corresponding to FIG. 77;
FIG. 79 is a structural schematic diagram of a display panel in the related art;
FIG. 80 is another structural schematic diagram of a display panel according to an embodiment of the present disclosure;
FIG. 81 is a timing diagram corresponding to FIG. 80;
FIG. 82 is another structural schematic diagram of a display panel according to an embodiment of the present disclosure; and
FIG. 83 is a structural schematic diagram of a display device according to an embodiment of the present disclosure.

### DESCRIPTION OF EMBODIMENTS

In order to better understand technical solutions of the present disclosure, embodiments of the present disclosure are described in detail below in conjunction with the drawings.

It should be clear that the described embodiments are only some rather than all of the embodiments of the present disclosure. All other embodiments obtained by those skilled in the art based on the embodiments of the present disclosure without creative efforts should fall within the protection scope of the present disclosure.

Terms used in the embodiments of the present disclosure are merely for the purpose of describing specific embodiments, but not intended to limit the present disclosure. Singular forms of "a/an", "the" and "said" used in the embodiments of the present disclosure and the appended claims are also intended to include plural forms, unless clearly indicating others.

It should be understood that the term "and/or" used herein is merely an association relationship describing associated objects, indicating that there may be three relationships, for example, A and/or B, and may indicate: only A, both A and B, and only B. In addition, the character "/" herein generally indicates an "or" relationship between the associated objects.

An embodiment of the present disclosure provides a display panel, which may be an organic light emitting diode (Organic Light Emitting Diode, OLED) display panel, a light emitting diode (Light Emitting Diode, LED) display panel, a micro light emitting diode (Micro Light Emitting Diode, micro LED) or other types.

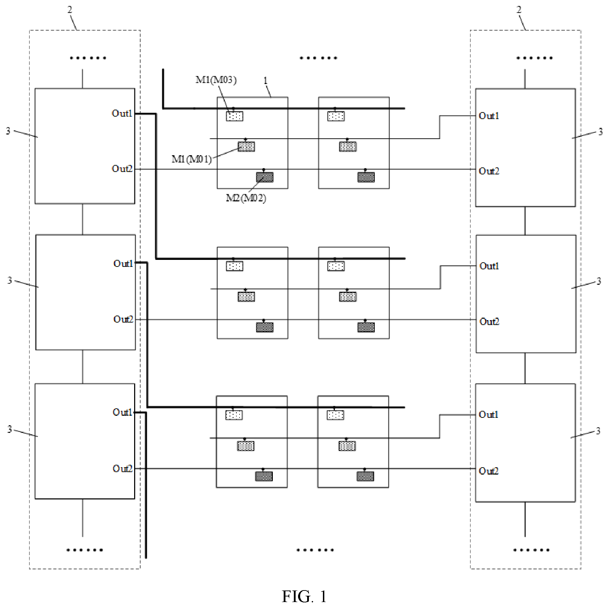

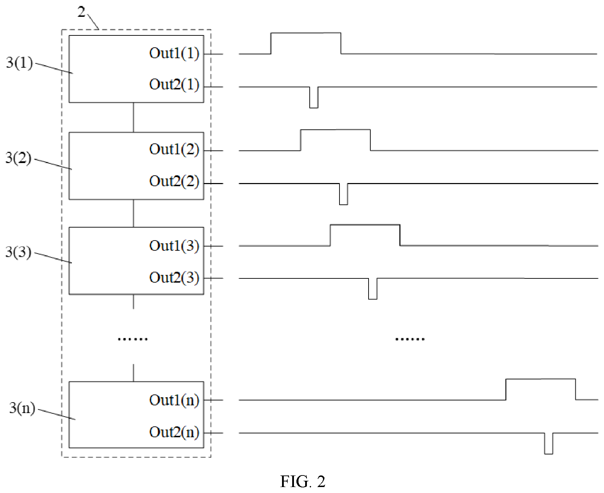

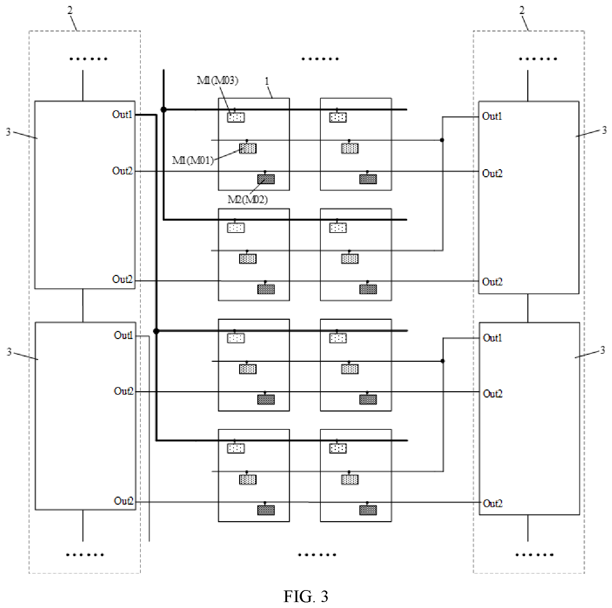

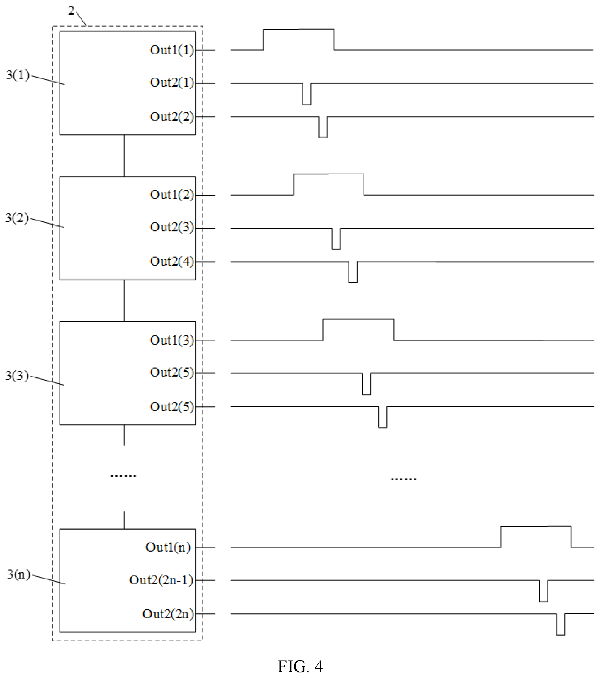

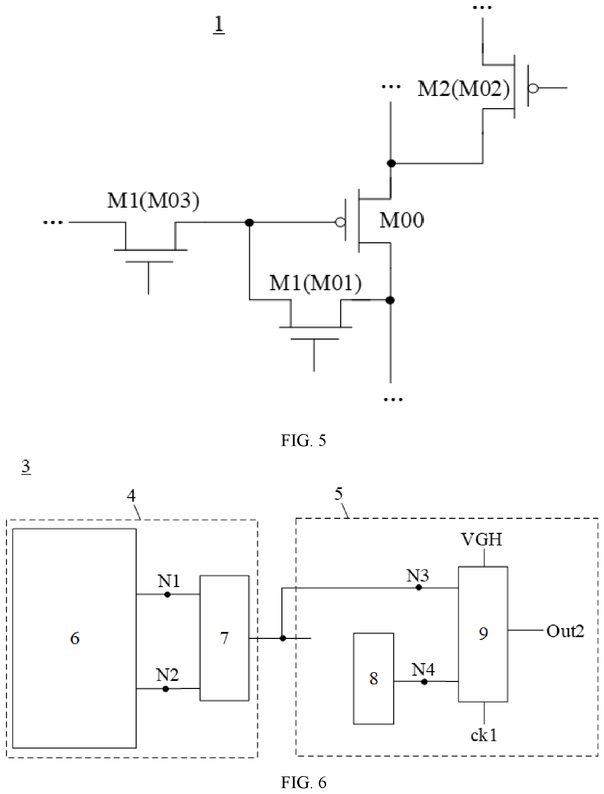

As shown in FIG. 1 to FIG. 5, where FIG. 1 is a structural schematic diagram of a display panel according to an embodiment of the present disclosure, FIG. 2 is a schematic diagram of an output signal of a shift register 2 corresponding to FIG. 1, FIG. 3 is another structural schematic diagram of a display panel according to an embodiment of the present disclosure, FIG. 4 is a schematic diagram of an output signal of a shift register 2 corresponding to FIG. 3, and FIG. 5 is a structural schematic diagram of a pixel circuit 1 according to an embodiment of the present disclosure, the display panel includes a pixel circuit 1 and a shift register 2.

The pixel circuit 1 includes a first transistor M1 and a second transistor M2.

The shift register 2 includes a plurality of shift units 3 that are cascaded. The shifting unit 3 includes a first terminal Out1 and at least one second terminal Out2. The first terminal Out1 is electrically connected to a gate of the first transistor M1, and the second terminal Out2 is electrically connected to a gate of the second transistor M2. The first terminal Out1 and the second terminal Out2 respectively output signals different from each other.

In some embodiments of the present disclosure, the shift unit 3 includes m second terminals Out2. Referring to FIG. 1 and FIG. 2, m may be equal to 1, or referring to FIG. 3 and FIG. 4, m may also be an integer greater than or equal to 2, for example, m=2, 4, 6, etc.

For ease of understanding, in the drawings of the embodiments of the present disclosure, an i-th-stage shift unit is marked with the reference sign 3(i). The first terminal of the i-th-stage shift unit 3(i) is marked with the reference sign Out1(i). The shift unit 3 includes m second terminals. When m=1, the second terminal of the i-th-stage shift unit 3(i) is marked with the reference sign Out2(i). When m≥2, the m second terminals of the i-th-tage shift unit 3(i) are respectively marked with reference signs Out2(m×i-m+1), Out2(m×i-m+2), ..., Out2(m×i). For example, referring to FIG. 4, m=2, and two second terminals of the i-th-stage shift unit 3(i) are respectively marked with reference signs Out2(2i-1) and Out2(2i).

The signals output by the first terminal Out1 and the second terminal Out2 of the shift unit 3 are different, meaning that the gate signals of the first transistor M1 and the second transistor M2 in the pixel circuit 1 are different. The difference of such signals refers to that waveforms of two signals are different, including at least the two following cases.

In the first case, device types of the first transistor M1 and the second transistor M2 are different, and active level states of signals output by the first terminal Out1 and the second terminal Out2 are opposite. For example, with reference to FIG. 2, FIG. 4 and FIG. 5, the first transistor M1 is an N-type transistor, an active level of the signal output by the first terminal Out1 is a high level; and the second transistor M2 is a P-type transistor, and an active level of the signal output by the second terminal Out2 is a low level.

In the second case, the device types of the first transistor M1 and the second transistor M2 are the same, and the active level states of the signals output by the first terminal Out1 and the second terminal Out2 are the same, but the durations of the active levels in the two signals are different. For example, the first transistor M1 and the second transistor M2 are both P-type transistors, and active levels of the signals output by the first terminal Out1 and the second terminal Out2 are both low levels, but pulse widths of the two signals are different.

The first case is taken as an example for explanation in the following description of the present disclosure.

In the related art, when the gates of the first transistor M1 and the second transistor M2 need to receive different signals, two different shift registers respectively provide these two different signals independently. These two shift registers are independent of each other, resulting in a relatively large number of shift registers in the display panel, and the shift registers need to occupy a relatively large space in the bezel.

In the embodiments of the present disclosure, the original two shift registers are merged into one shift register capable of simultaneously outputting two different signals. In the merged shift register, part of the circuit logic of the original two shift registers can be shared, so as to simplify the circuit structure of the shift register. The shift register has a higher level of circuit integration, which not only can reduce the number of shift registers in the display panel, but also can reduce the number of switching transistors required in the shift registers, thereby greatly reducing the space occupied by the shift registers in the bezel, so as to optimize the narrow bezel design of the display panel.

In a feasible implementation, as shown in FIG. 6, which is a structural schematic diagram of a shift unit 3 according to an embodiment of the present disclosure, the shift unit 3 includes a first circuit 4 and a second circuit 5, the first circuit 4 includes a first terminal Out1, and the second circuit 5 includes a second terminal Out2.

The first circuit 4 includes a first driving module 6 and a first output module 7.

The first driving module 6 controls signals of the first node N1 and the second node N2. The first output module 7 outputs a signal in response to voltages of the first node N1 and the second node N2.

That is, the first node N1 and the second node N2 are two output control nodes of the first output module 7, and the first output module 7 is configured to output a high level or a low level according to level states of the first node N1 and the second node N2.

The second circuit 5 includes a second driving module 8 and at least one second output module 9.

The second output module 9 outputs a voltage of a first power terminal VGH to the second terminal Out2 in response to a voltage of a third node N3, and outputs a voltage of a first clock terminal ck1 to the second terminal Out2 in response to a voltage of a fourth node N4. The first power terminal VGH is configured to provide a constant voltage signal with a high level. The third node N3 is electrically connected to the first circuit 4, and within at least a subset of time periods, the level states of the signals of the third node N3 and the second node N2 are consistent with each other. The second driving module 8 controls the signal of the fourth node N4.

That is, the third node N3 and the fourth node N4 are two output control nodes of the second output module 9. The second output module 9 is configured to output the high level of the first power terminal VGH to the second terminal Out2 when the third node N3 is at a low level, and output the pulse of the first clock terminal ck1 to the second terminal Out2 when the fourth node N4 is at a low level.

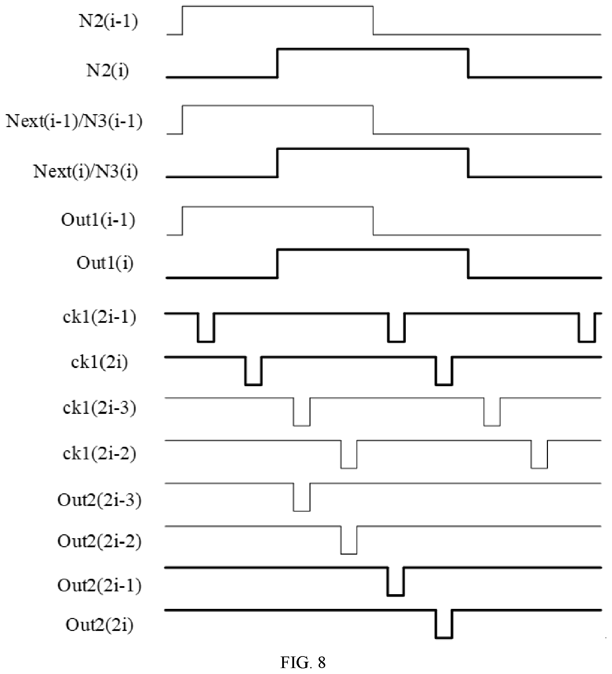

Regarding "within at least a subset of time periods, the level states of the signals of the third node N3 and the second node N2 are consistent with each other", in one structure, when the second node N2 is at a low level, the third node N3 is at a low level, and within at least a subset of time periods when the second node N2 is at a high level, the third node N3 is at a high level. For example, referring to FIG. 8, signals of the third node N3 and the second node N2 are concurrently at a high level or at a low level.

Within at least a subset of time periods, the level states of the signals of the third node N3 and the second node N2 are consistent with each other, which means that the signal of the third node N3 is correlated with the signal of the second node N2. The third node N3 may be directly connected to the second node N2, or the third node N3 may alternatively be connected to other nodes in the first circuit 4 that have a correlation with the second node N2, such as a shift output terminal Next, a sixth node N6, a seventh node N7, an eighth node N8 etc., which are described in the following.

The correlation between the signal of the third node N3 and the signal of the second node N2 indicates that the third node N3 and the second node N2 share a set of logic circuits for providing a voltage. Referring to FIG. 6, the first driving module 6 in the first circuit 4 provides a voltage to the second node N2, thereby directly or indirectly determining the voltage of the third node N3. In this way, in the second circuit 5, it is unnecessary to additionally configure another driving module for the third node N3, so that the shift unit 3 has a higher integration level and a simplified circuit structure, thereby significantly reducing the space occupied by the shift unit 3 in the bezel.

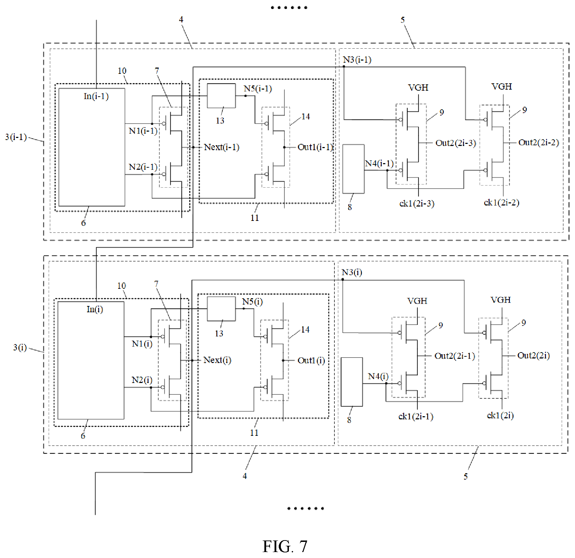

Regarding the connection between the third node N3 and the first circuit 4, in a feasible implementation, as shown in FIG. 7 and FIG. 8, where FIG. 7 is a structural schematic diagram of a shift register 2 according to an embodiment of the present disclosure, and FIG. 8 is a timing diagram corresponding to FIG. 7, the first circuit 4 includes a shift control sub-circuit 10 and a region-wise control sub-circuit 11.

The shift control sub-circuit 10 includes a first driving module 6 and a first output module 7. The first driving module 6 includes a shift input terminal In, and the first output module 7 includes a shift output terminal Next. , In two consecutive shift units 3, the shift output terminal Next of an upstream shift unit 3is electrically connected to the shift input terminal In of a downstream shift unit 3.

The region-wise control sub-circuit 11 includes a first terminal Out1, and outputs a signal to the first terminal Out1 according to the region-wise control signal.

The third node N3 is electrically connected to the shift output terminal Next.

For ease of understanding, in the drawings of the embodiments of the present disclosure, the first circuit and the second circuit corresponding to the i-th-stage shift unit 3(i) are respectively marked with reference signs 4(i) and 5(i). The shift input terminal and the shift output terminal corresponding to the i-th-stage shift unit 3(i) are respectively marked with reference signs In(i) and Next(i). The first node to the fourth node N4 corresponding to the i-th-stage shift unit 3(i) are respectively marked with reference signs N1(i) to N4(i).

The shift unit 3 includes m second terminals Out2. When m=1, the first clock terminal corresponding to the i-th-stage shift unit 3(i) is marked with the reference sign ck(i). When m≥2, m first clock terminals corresponding to the i-th-stage shift unit 3(i) are respectively marked with the reference signs ck1(m×i-m+1), ck1(m×i-m+2), ..., ck1(m×i). For example, referring to FIG. 6, m=2, and two first clock terminals corresponding to the i-th-stage shift unit 3(i) are respectively marked with the reference signs ck1(2i-1) and ck1(2i).

The display panel with such structure has frequency-per-region function.

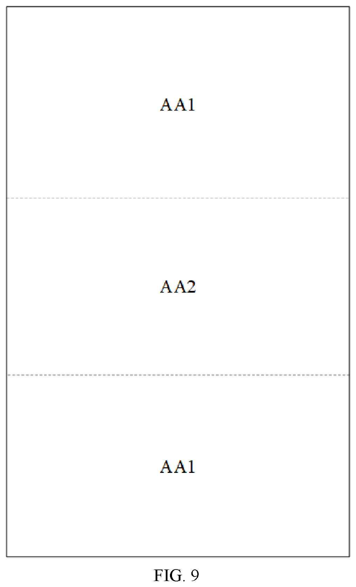

As shown in FIG. 9, which is a schematic diagram of partitioning of a display panel according to an embodiment of the present disclosure, the display panel includes a first region AA1 and a second region AA2.

In the first display mode FD, the driving frequency of the first region AA1 is the same as the driving frequency of the second region AA2. In the second display mode SD, the driving frequency of the first region AA1 is different from the driving frequency of the second region AA2. The first region AA1 is driven at a high frequency, and the second region AA2 is driven at a low frequency. The driving frequency may be understood as a data refresh frequency.

It should be noted that, in the second display mode SD, the positions of the first region AA1 and the second region AA2 may be fixed or unfixed.

The pixel circuit 1 further includes a driving transistor M00. In some embodiments of the present disclosure, the signal output by the first terminal Out1 of at least one shift unit 3 is configured to control whether the driving transistor M00 in the pixel circuit 1 can perform data writing. When the first terminal Out1 of the shift register 2 outputs a high level, the first transistor M1 connected to the first terminal Out1 is turned on, so that the data voltage can be written into the gate of the driving transistor M00, and the driving transistor M00 is charged. When the first terminal Out1 of the shift register 2 outputs a low level, the first transistor M1 connected to the first terminal Out1 is turned off, so that the data voltage cannot be written into the gate of the driving transistor M00, and the driving transistor M00 is not charged.

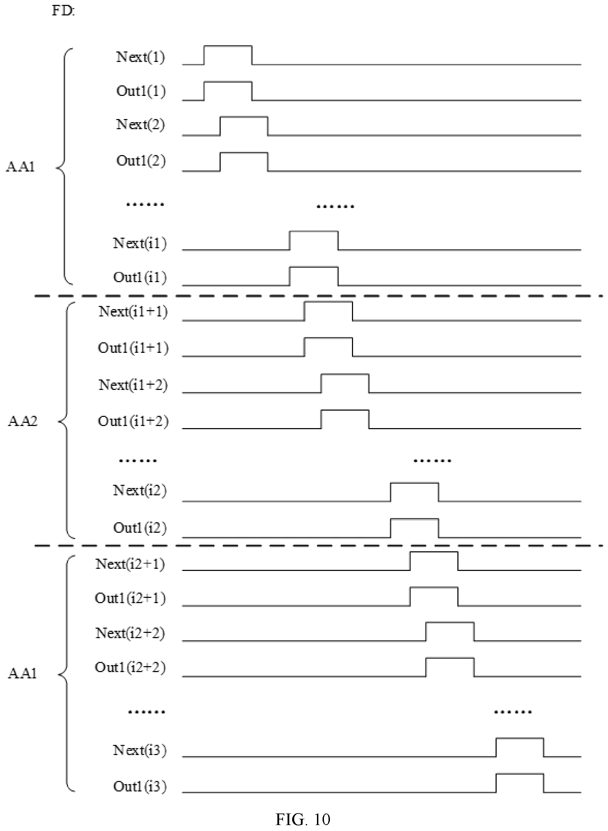

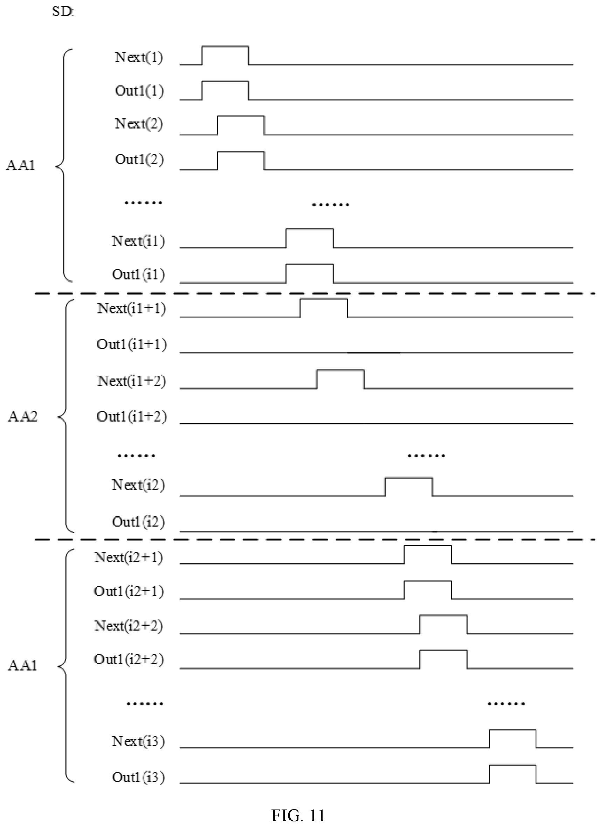

As shown in FIG. 10 and FIG. 11, where FIG. 10 is a timing diagram in a first display mode FD according to an embodiment of the present disclosure, and FIG. 11 is a timing diagram in a second display mode SD according to an embodiment of the present disclosure, for the shift control sub-circuit 10, whether in the first display mode FD or in the second display mode SD, the shift output terminals Next of the shift control sub-circuits 10 in all shift units 3 normally output a high level sequentially to ensure that all shift units 3 can shift normally.

For the region-wise control sub-circuit 11, in the first display mode FD, referring to FIG. 10, under the control of the region-wise control signal, the second terminals Out2 of the region-wise control sub-circuits 11 in all shift units 3 normally output a high level sequentially, so that the pixel circuits 1 in the first region AA1 and the second region AA2 can normally perform charging operations, and the data refresh frequencies of the two regions are the same. In the same shift unit 3, the level states of the signals output by the second terminal Out2 and the shift output terminal Next are consistent with each other.

In the second display mode SD, referring to FIG. 11, under the control of the region-wise control signal, the first terminals Out1 of the region-wise control sub-circuits 11 of the multiple shift units 3 corresponding to the first region AA1 normally output a high level sequentially, so that the pixel circuits 1 in the first region AA1 can normally perform charging operations, and the region has a higher data refresh frequency. In a subset of frames, the first terminals Out1 of the region-wise control sub-circuits 11 of the multiple shift units 3 corresponding to the second region AA2 stop outputting a high level, so that the pixel circuits 1 in the second region AA2 do not perform charging operations, thereby reducing the data refresh frequency of the region. One frame herein may be understood as a frame time corresponding to the driving frequency of the first region.

In the shift register 2 with frequency-per-region control, there is a correlation between the signals of the shift output terminal Next and the second node N2. For example, referring to FIG. 8, the level states of the signals of the shift output terminal Next and the second node N2 are consistent with each other, and are concurrently at a high level or at a low level. Therefore, in some embodiments of the present disclosure, the third node N3 may be configured to be electrically connected to the shift output terminal Next, so as to provide a signal to the third node N3 using the shift control sub-circuit 10, thereby improving the integration level between the first circuit 4 and the second circuit 5.

Further, different from the first terminal Out1, the shift output terminals Next of all shift units 3 normally output a high level sequentially in any display mode. The third node N3 is electrically connected to the shift output terminal Next. In the second display mode SD, the third node N3 of each shift units 3 can still be normally set high, so as to ensure that the second terminals Out2 of all shift units 3 can sequentially output a low level, so that the second transistor M2 of the pixel circuit 1 in the second region AA2 can be normally turned on. Taking the first transistor M1 including a threshold compensation transistor M01 and the second transistor M2 including a data writing transistor M02 as an example, in the second display mode SD, the threshold compensation transistor M01 of the pixel circuit 1 in the second region AA2 is turned off, but the data writing transistor M02 of the pixel circuit 1 in the second region AA2 is turned on. In this case, the voltage may be written to the first electrode of the driving transistor M00 using the turned-on data writing transistor M02 to adjust the bias state of the driving transistor M00, so as to prevent the threshold voltage of the driving transistor M00 from drifting during low-frequency driving.

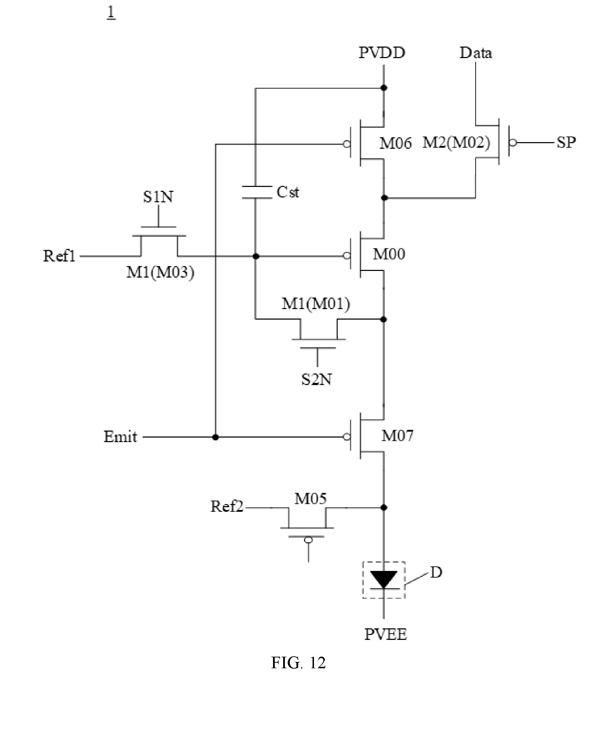

Further, as shown in FIG. 12, which is another structural schematic diagram of a pixel circuit 1 according to an embodiment of the present disclosure, the pixel circuit 1 further includes a driving transistor M00.

The first transistor M1 includes a threshold compensation transistor M01 electrically connected between the second electrode and the gate of the driving transistor M00. The first terminal Out1 of at least one shift register 2 is electrically connected to the gate of the threshold compensation transistor M01.

In the second display mode SD, when switching from the high-frequency first region AA1 to the low-frequency second region AA2, the first terminal Out1 of the shift register 2 continuously stops outputting an active level (for example, when the threshold compensation transistor M01 is an N-type transistor, the active level is a high level), so that the threshold compensation transistor M01 of the pixel circuit 1 in the second region AA2 is turned off, cutting off the path for the data voltage to be written into the gate of the driving transistor M00, thereby stopping charging of such pixel circuit 1.

Alternatively, the first transistor M1 includes a data writing transistor M02 electrically connected between the data line and the first electrode of the driving transistor M00. The first terminal Out1 of at least one shift register 2 is electrically connected to the gate of the data writing transistor M02.

In the second display mode SD, when switching from the high-frequency first region AA1 to the low-frequency second region AA2, the first terminal Out1 of the shift register 2 continuously stops outputting an active level (for example, when the data writing transistor M02 is a P-type transistor, the active level is a low level), so that the data writing transistor M02 of the pixel circuit 1 in the second region AA2 is turned off, cutting off the path for the data voltage to be written into the gate of the driving transistor M00, thereby stopping charging of such pixel circuit 1.

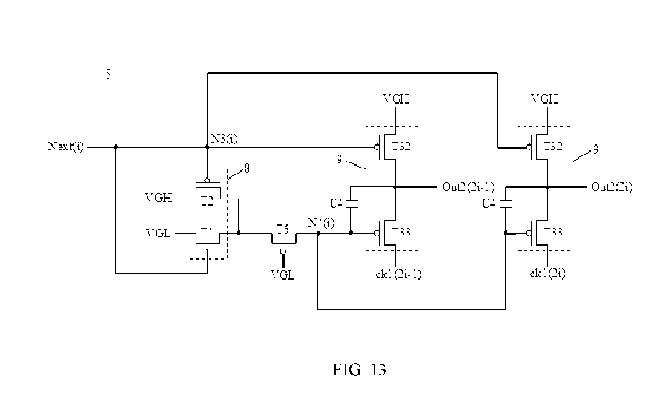

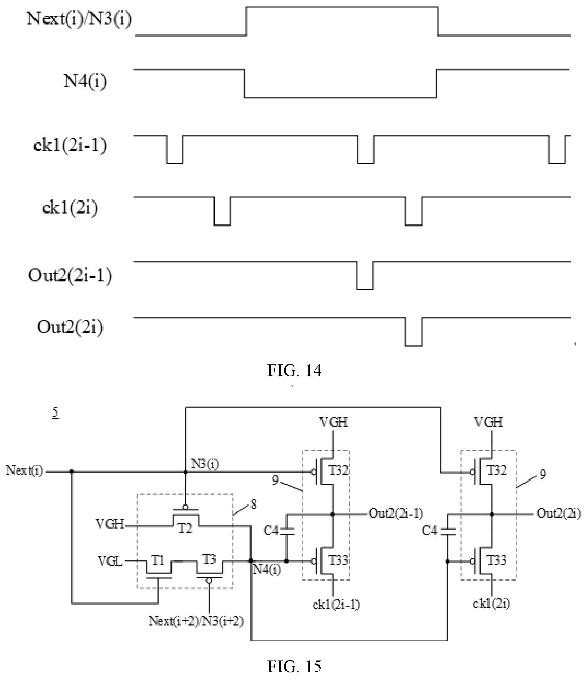

Regarding the second driving module 8, in a feasible implementation, as shown in FIG. 13 and FIG. 14, where FIG. 13 is a structural schematic diagram of a second circuit 5 according to an embodiment of the present disclosure, and FIG. 14 is a timing diagram corresponding to FIG. 13, the second driving module 8 includes a first switching transistor T1 and a second switching transistor T2.

The first switching transistor T1 is an N-type transistor. The first switching transistor T1 has a gate electrically connected to the third node N3, a first electrode electrically connected to the second power terminal VGL, and a second electrode electrically connected to the fourth node N4. The second power terminal VGL is configured to provide a constant voltage signal with a low level.

The second switching transistor T1 is a P-type transistor. The second switching transistor T2 has a gate electrically connected to the third node N3, a first electrode electrically connected to the first power terminal VGH, and a second electrode electrically connected to the fourth node N4.

Based on the above structure, when the third node N3 is at a high level, the first switching transistor T1 is turned on, so that the fourth node N4 is at a low level, and the second output module 9 outputs the pulse of the first clock terminal ck1 to the second terminal Out2. When the third node N3 is at a low level, the second switching transistor T2 is turned on, so that the fourth node N4 is at a high level, and the second output module 9 does not output the signal of the first clock terminal ck1.

The above structure achieves that the level states of the signals of the fourth node N4 and the third node N3 are opposite, merely with the N-type first switching transistor T1 and the P-type second switching transistor T2, so that the second output module 9 can output a signal at a time in response to either the low level of the third node N3 or the low level of the fourth node N4, thereby improving the accuracy of the output signal. In addition, the second driving module 8 in such configuration has a simple structure and a small number of switching transistors.

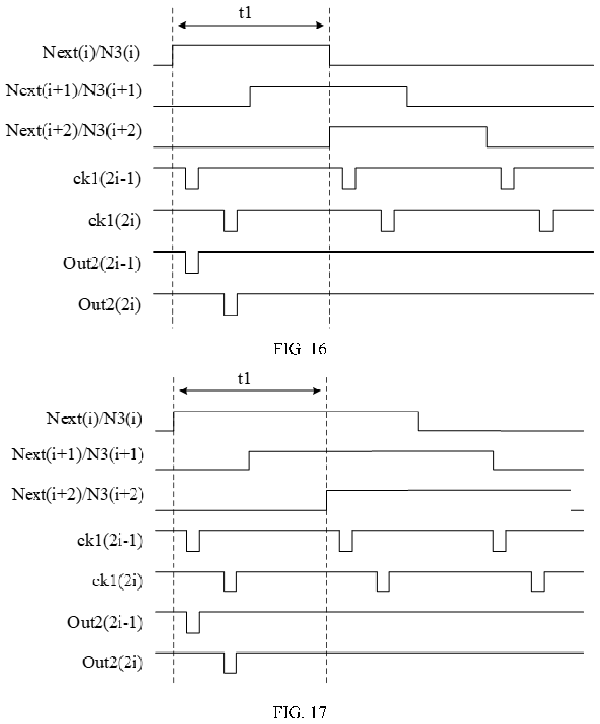

In a feasible implementation, as shown in FIG. 15 to FIG. 17, where FIG. 15 is another structural schematic diagram of a second circuit 5 according to an embodiment of the present disclosure, FIG. 16 is a timing diagram corresponding to FIG. 15, and FIG. 17 is another timing diagram corresponding to FIG. 15, a second electrode of the first switching transistor T1 is electrically connected to the fourth node N4 through a third switching transistor T3.

The gate of the first switching transistor T1 in the i-th-stage shift unit 3(i) is electrically connected to the third node N3(i) in the i-th-stage shift unit 3(i), and the gate of the third switching transistor T3 in the i-th-stage shift unit 3(i) is electrically connected to the third node N3(i0) in the i0-th-stage shift unit 3(i0), where i≠i0.

Referring to FIG. 16, during the time period t1 in which the first switching transistor T1 and the third switching transistor T3 in the i-th-stage shift unit 3(i) are both turned on, the first clock terminal ck1 connected to the i-th-stage shift unit 3(i) provides an active pulse. That is, during the time period t1 in which the high level of the third node N3(i) in the i-th-stage shift unit 3(i) overlaps with the low level of the third node N3(i0) in the i0-th-stage shift unit 3(i0), both the first clock terminal ck1(2i-1) and the first clock terminal ck1(2i) that are connected to the i-th-stage shift unit 3(i) provide only one active pulse.

In FIG. 15, "i0" is illustrated as "i+2".

In some driving manners, the second terminal Out2 of the shift unit 3 performs single-pulse output.

Under such design requirement, when the third switching transistor T3 is not provided in the second driving module 8, with reference to FIG. 13 and FIG. 14, for the i-th-stage shift unit 3(i), to ensure that the single-pulse output of the second terminal Out2 of the i-th-stage shift unit 3(i), the high level of the third node N4(i) can only cover one active pulse of the first clock terminal ck1 connected to the i-th-stage shift unit 3(i), which means that the high levels of the shift output terminal Next(i) and the first terminal Out1(i) of the i-th-stage shift unit 3(i) can only correspondingly cover one active pulse of the first clock terminal ck1 connected to the i-th-stage shift unit 3(i), which, as a result, imposes limitions on the pulse width of the signal output by the first terminal Out1.

In the structure shown in FIG. 15, by further providing the third switching transistor T3, it is only necessary to ensure that the active pulse of the first clock terminal ck1 connected to the i-th-stage shift unit 3(i) is covered during the time period t1. The high level of the third node N4(i) of the i-th-stage shift unit 3(i) can be stretched longer as shown in FIG. 17, thereby eliminating the limitation on the duration during which the third node N3, the shift output terminal Next and the first terminal Out1 of the shift unit 3 are at a high level, and allowing more flexible design of the pulse width of the signal output by the first terminal Out1 of the shift unit 3.

It should be noted that "i0=i+2" is merely for purpose of example.Provided that the time period t1 only covers one active pulse of the first clock terminal ck1 connected to the i-th-stage shift unit 3(i), the value of i0 may be configured according to the actual timing situation.

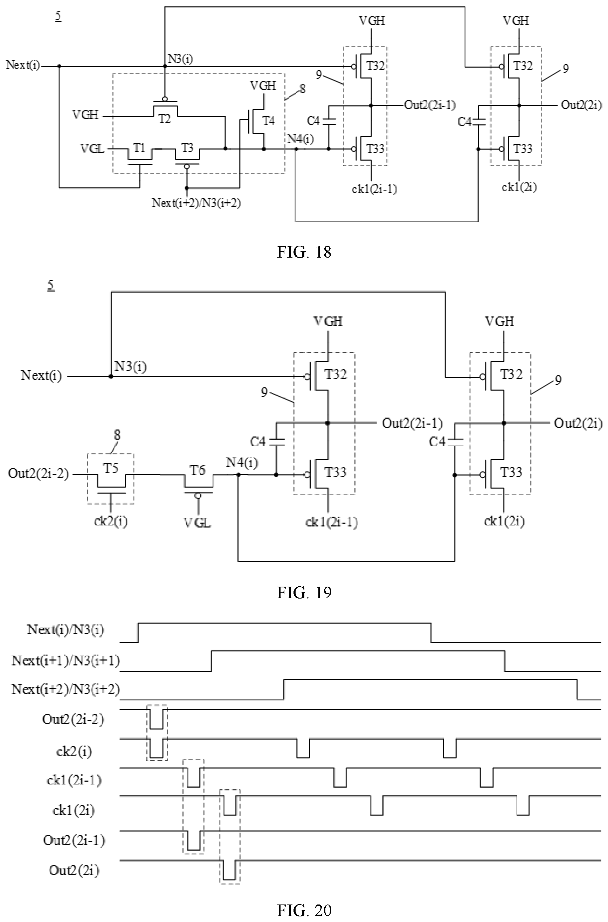

Further, as shown in FIG. 18, which is another structural schematic diagram of a second circuit 5 according to an embodiment of the present disclosure, the second driving module 8 further includes a fourth switching transistor T4, and the fourth switching transistor T4 is an N-type transistor. The fourth switching transistor T4 has a gate electrically connected to the gate of the third switching transistor T3, a first electrode electrically connected to the first power terminal VGH, and a second electrode electrically connected to the fourth node N4.

With reference to FIG. 17, when the third node N3(i) in the i-th-stage shift unit 3(i) and the third node N3(i0) in the i0-th-stage shift unit 3(i0) are both at a high level, the second switching transistor T2 and the third switching transistor T3 are turned off. After the fourth switching transistor T is added, the fourth switching transistor T4 is turned on in response to the high level of the third node N3(i0), thereby providing a stable high level to the fourth node N4, and protecting the fourth node N4 from floating and being disturbed by the signal transition of the first clock terminal ck1.

Regarding the second driving module 8, in another feasible implementation, as shown in FIG. 19 and FIG. 20, where FIG. 19 is another structural schematic diagram of a second circuit 5 according to an embodiment of the present disclosure, and FIG. 20 is a timing diagram corresponding to FIG. 19, the second output module 9 outputs the voltage of the first power terminal VGH to the second terminal Out2 in response to the first level of the third node N3, and outputs the voltage of the first clock terminal ck1 to the second terminal Out2 in response to the first level of the fourth node N4.

The second driving module 8 includes a fifth switching transistor T5. The fifth switching transistor T5 has a gate electrically connected to the second clock terminal ck2, and a second electrode electrically connected to the fourth node N4.

A first electrode of the fifth switching transistor T5 in the i-th-stage shift unit 3(i) is electrically connected to the second terminal Out2 in the (i-1)-th-stage shift unit 3. For the same shift unit 3, during a time period in which the third node N3 is at a second level, the second terminal Out2 connected to the fifth switching transistor T5 outputs a first level, and the first level overlaps with the first level provided by the second clock terminal ck2 connected to the fifth switching transistor T5.

The first level is a low level, and the second level is a high level.

For ease of understanding, in the drawings of the embodiments of the present disclosure, the second clock terminal corresponding to the i-th-stage shift unit 3(i) is marked with ck2(i).

As described above, in some driving manners, the second terminal Out2 of the shift unit 3 performs single-pulse output.

In the above structure, with reference to FIG. 20, during the time period in which the third node N3(i) of the i-th-stage shift unit 3(i) is at a high level, when the second terminal Out2(2i-2) outputs a low level, the second clock terminal ck2(i) provides a pulse. For the i-th-stage shift unit 3(i), the fifth switching transistor T5 is turned on to set the fourth node N4(i) to a low level. Then, the second clock terminal ck2 (i) jumps to a high level, the fifth switching transistor T5 is turned off, and the fourth node N4(i) maintains a low level. When the first clock terminal ck1(2i-1) provides a pulse, the second terminal Out2(2i-1) outputs a low level. When the first clock terminal ck1(2i) provides a pulse, the second terminal Out2(2i) outputs a low level. Then, the second clock terminal ck2 (i) is set to a low level again, but since the second terminal Out2(2i-2) outputs a high level at this time, the fourth node N4 (i) jumps to a high level. When the first clock terminal ck1(2i-1) and the first clock terminal ck1(2i) provide pulses subsequently, the second terminal Out2(2i-1) and the second terminal Out2(2i) no longer output low levels, thereby enabling the second terminal Out2 to realize single-pulse output.

With such structure, when realizing the single-pulse output of the second terminal Out2, the restrictions on the duration during which the third node N3, the shift output terminal Next and the first terminal Out1 of the shift unit 3 are at a high level can also be eliminated, thereby enabling more flexible design of the pulse width of the signal output by the first terminal Out1 of the shift unit 3. In addition, the second driving module 8 of such structure includes fewer transistors, and the structure of the second circuit 5 is simpler.

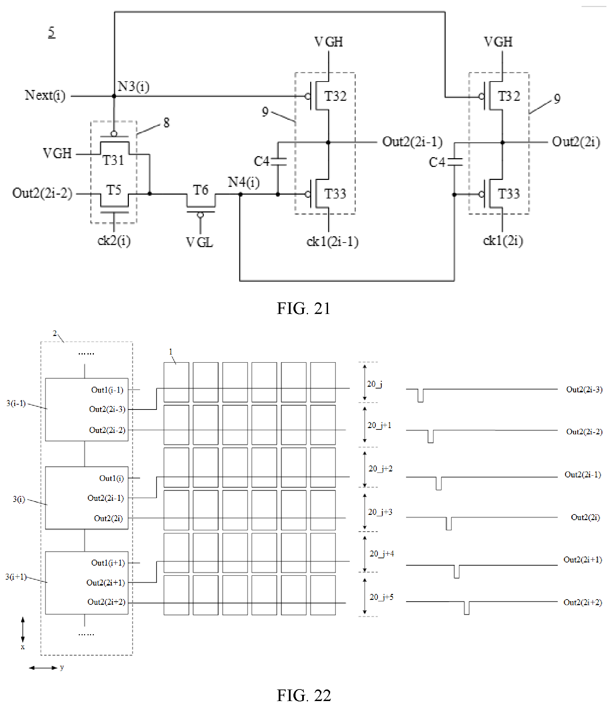

Further, as shown in FIG. 21, which is another structural schematic diagram of a second circuit 5 according to an embodiment of the present disclosure, the second driving module 8 may further include a thirty-first switching transistor T31. The thirty-first switching transistor T31 has a gate electrically connected to the third node N3, a first electrode electrically connected to the first power terminal VGH, and a second electrode electrically connected to the fourth node N4.

When the third node N3(i) is at a low level, the thirty-first switching transistor T31 is turned on, and a stable high level is written into the fourth node N4(i), so that the potential of the fourth node N4 is stable and not easily disturbed.

Further, with reference to FIG. 19, FIG. 20 and FIG. 22, where FIG. 22 is another structural schematic diagram of a display panel according to an embodiment of the present disclosure, the pixel circuit 1 includes a plurality of circuit rows 20 arranged along a first direction, and the circuit row 20 include a plurality of pixel circuits 1 arranged along a second direction. The first direction intersects with the second direction.

The second circuit 5 includes m second output modules 9, and m≥2. The m second output modules 9 are respectively electrically connected to the second transistors M2 in the m circuit rows 20 through m second terminals Out2, and the m second output modules 9 are also respectively electrically connected to m first clock terminals ck1. FIG. 22 is illustrated by taking m=2 as an example.

The m second terminals Out2 from number one to number m in the (i-1)-th-stage shift unit 3(i-1) are respectively electrically connected to m circuit rows 20 from number j to number (j+(m-1)), where j≥1. The fifth switching transistor T5 in the (i)-th-stage shift unit 3(i) is electrically connected to the m-th second terminal Out2 in the (i-1)-th-stage shift unit 3(i-1).

The fifth switching transistor T5 in the i-th-stage shift unit 3(i) is electrically connected to the last second terminal Out2 outputting a low level in the (i-1)-th-stage shift unit 3(i-1), so that the second terminals Out2 of all shift units 3 can output a low level sequentially.

The first clock terminal ck1 and the second clock terminal ck2 in the shift unit 3 are respectively electrically connected to clock lines, and signals are transmitted to the clock terminals by means of the clock lines.

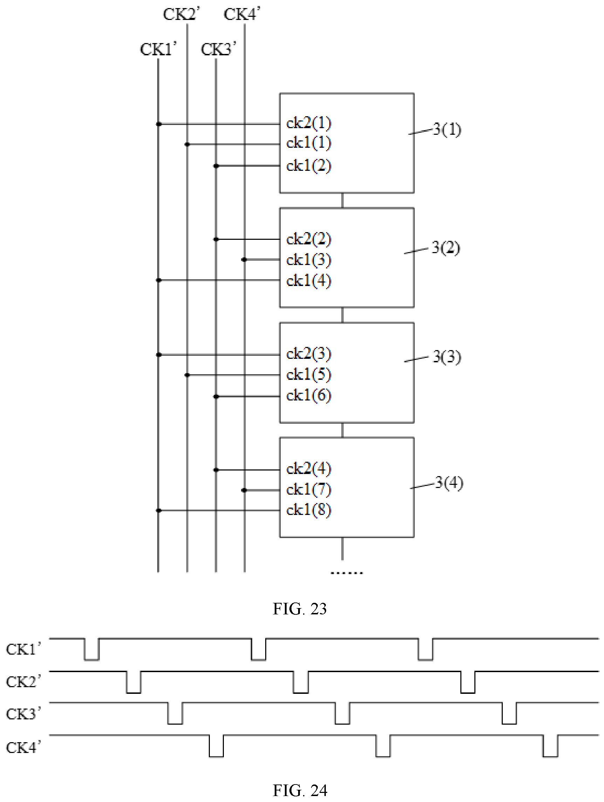

Regarding the connection between the clock terminals of the shift unit 3 and the clock lines, in a feasible implementation, with reference to Table 1 and FIG. 21, as shown in FIG. 23 and FIG. 24, where FIG. 23 is a schematic diagram of a connection between the shift register 2 and clock lines according to an embodiment of the present disclosure, and FIG. 24 is a timing diagram of signals provided by a plurality of clock lines corresponding to FIG. 23, m=2.

The display panel includes a first clock line CK1', a second clock line CK2', a third clock line CK3', and a fourth clock line CK4'.

The second clock terminal ck2 corresponding to the odd-stage shift unit 3 is electrically connected to the first clock line CK1', and two first clock terminals ck1 corresponding to the odd-stage shift unit 3 are respectively electrically connected to the second clock line CK2' and the third clock line CK3'. The second clock terminal ck2 corresponding to the even-stage shift unit 3 is electrically connected to the third clock line CK3', and two first clock terminals ck1 corresponding to the even-stage shift unit 3 are respectively electrically connected to the fourth clock line CK4' and the first clock line CK1'.

**Table 1**

| | ck2 | ck1-1 | ck1-2 |
|---|---|---|---|
| First-stage shift unit 3(1) | CK1' | CK2' | CK3' |
| Second-stage shift unit 3(2) | CK3' | CK4' | CK1' |
| Third-stage shift unit 3(3) | CK1' | CK2' | CK3' |
| Fourth-stage shift unit 3(4) | CK3' | CK4' | CK1' |
| Fifth-stage shift unit 3(5) | CK1' | CK2' | CK3' |
| Sixth-stage shift unit 3(6) | CK3' | CK4' | CK1' |
| ...... | | | |

ck-1 and ck1-2 in the table respectively represent two first clock terminals ck1 of the shift unit 3.

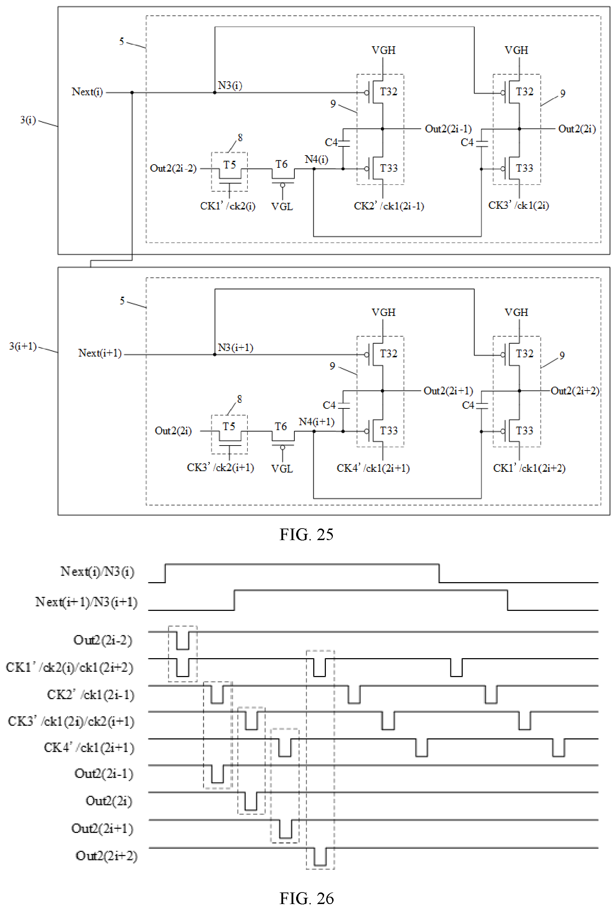

Exemplarily, as shown in FIG. 25 and FIG. 26, where FIG. 25 is another structural schematic diagram of a shift register 2 according to an embodiment of the present disclosure, and FIG. 26 is a timing diagram corresponding to FIG. 25, it is assumed that the i-th-stage shift unit 3(i) is the odd-stage shift unit, and the (i+1)-th-stage shift unit 3 is the even-stage shift unit 3.

In the i-th-stage shift unit 3(i), the second clock terminal ck2(i) is connected to the first clock line CK1', the first clock terminal ck1(2i-1) is connected to the second clock line CK2', and the first clock terminal ck1(2i) is connected to the third clock line CK3'.

In the (i+1)-th-stage shift unit 3(i+1), the second clock terminal ck2(i+1) is connected to the third clock line CK3', the first clock terminal ck1(2i+1) is connected to the fourth clock line CK4', and the first clock terminal ck1(2i+2) is connected to the first clock line CK1'.

One second clock terminal ck2 and two first clock terminals ck1 of the shift unit 3 are connected to three clock lines that sequentially output active pulses. For the i-th-stage shift unit 3(i), the low levels output by the second terminal Out2(2i-1) and the second terminal Out2(2i) are provided by the second clock line CK2' and the third clock line CK3'. If it is desired that the second terminal Out2(2i+1) and the second terminal Out2(2i+2) of the (i+1)-th-stage shift unit 3(i+1) continue to sequentially output low levels, the low levels output by the second terminal Out2(2i+1) and the second terminal Out2(2i+2) need to be provided by the fourth clock line CK4' and the first clock line CK1'. Correspondingly, the second clock terminal ck2(i+1) of the (i+1)-th-stage shift unit 3(i+1) is connected to the third clock line CK3', so as to realize the normal operation of the shift register 2.

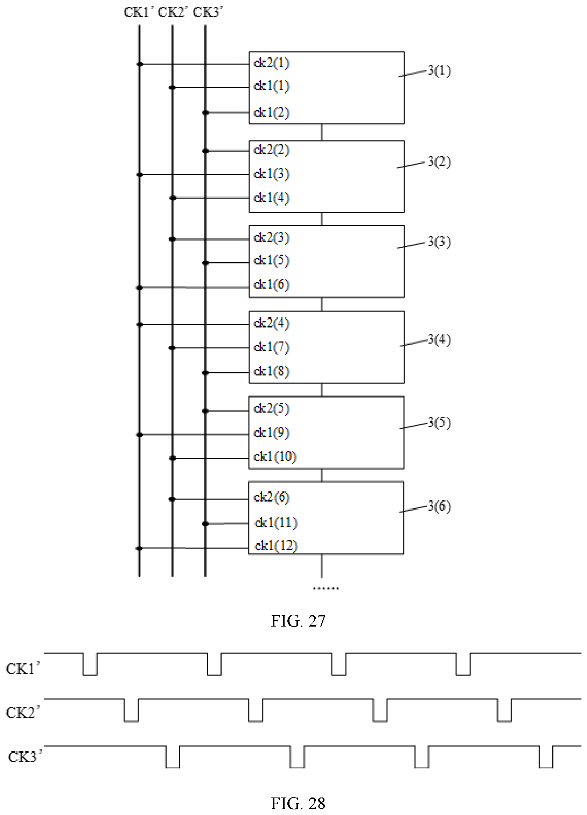

Regarding the connection between the clock terminals of the shift unit 3 and the clock lines, in another feasible implementation, with reference to Table 2 and FIG. 21, as shown in FIG. 27 and FIG. 28, where FIG. 27 is another structural schematic diagram of a display panel according to an embodiment of the present disclosure, and FIG. 28 is a timing diagram corresponding to FIG. 27, m=2.

The display panel includes a first clock line CK1', a second clock line CK2' and a third clock line CK3'.

The second clock terminal ck2 corresponding to the (3x-2)-th-stage shift unit 3 is electrically connected to the first clock line CK1', and two first clock terminals ck1 corresponding to the (3x-2)-th-stage shift unit 3 are respectively electrically connected to the second clock line CK2' and the third clock line CK3', where x is a positive integer, such as 1, 2, 3, and so on.The second clock terminal ck2 corresponding to the (3x-1)-th-stage shift unit 3 is electrically connected to the third clock line CK3', and two first clock terminals ck1 corresponding to the (3x-1)-th-stage shift unit 3 are respectively electrically connected to the first clock line CK1' and the second clock line CK2'. The second clock terminal ck2 corresponding to the 3x-th-stage shift unit 3 is electrically connected to the second clock line CK2', and two first clock terminals ck1 corresponding to the 3x-th-stage shift unit 3 are respectively electrically connected to the third clock line CK3' and the first clock line CK1'.

**Table 2**

| | ck2 | ck1-1 | ck1-2 |
|---|---|---|---|
| First-stage shift unit 3(1) | CK1' | CK2' | CK3' |
| Second-stage shift unit 3(2) | CK3' | CK1' | CK2' |
| Third-stage shift unit 3(3) | CK2' | CK3' | CK1' |
| Fourth-stage shift unit 3(4) | CK1' | CK2' | CK3' |
| Fifth-stage shift unit 3(5) | CK3' | CK1' | CK2' |
| Sixth-stage shift unit 3(6) | CK2' | CK3' | CK1' |
| ...... | | | |

The display panel with such structure includes an odd number of clock lines. Similar to the foregoing embodiments, based on the connection between the clock terminals of the shift unit 3 and the clock lines, the second terminals Out2 of the shift register 2 can also sequentially output low levels.

In addition, the first circuit 4 may also include some clock terminals. In some structures, a subset of clock terminals in the first circuit 4 may transmit the same signal as the second clock terminal ck2 in the second circuit 5, that is, the subset of clock terminals in the first circuit 4 and the second clock terminal ck2 in the second circuit 5 are connected to the same clock line, which will be described in detail in the following embodiments. Such arrangement may increase the load of the clock line connected to the second clock terminal ck2. By adopting the connection between the clock terminals of the shift unit 3 and the clock lines, and with reference to Table 2, each clock line is connected to the second clock terminal ck2 in turn, so that the loads of the clock lines are more balanced.

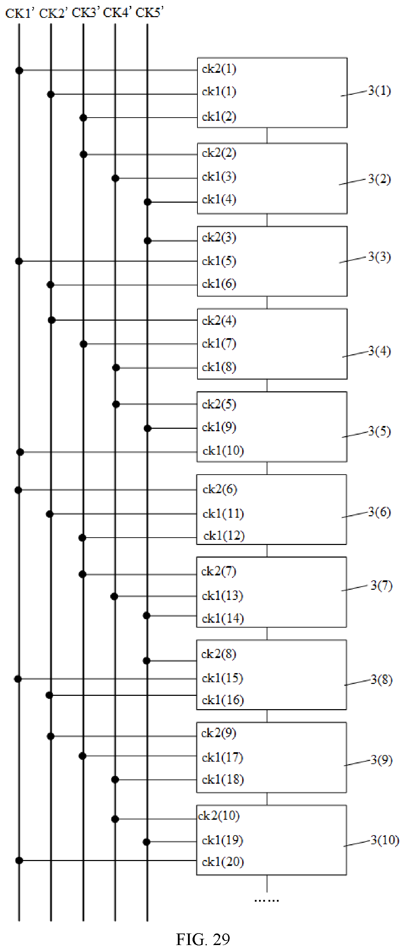

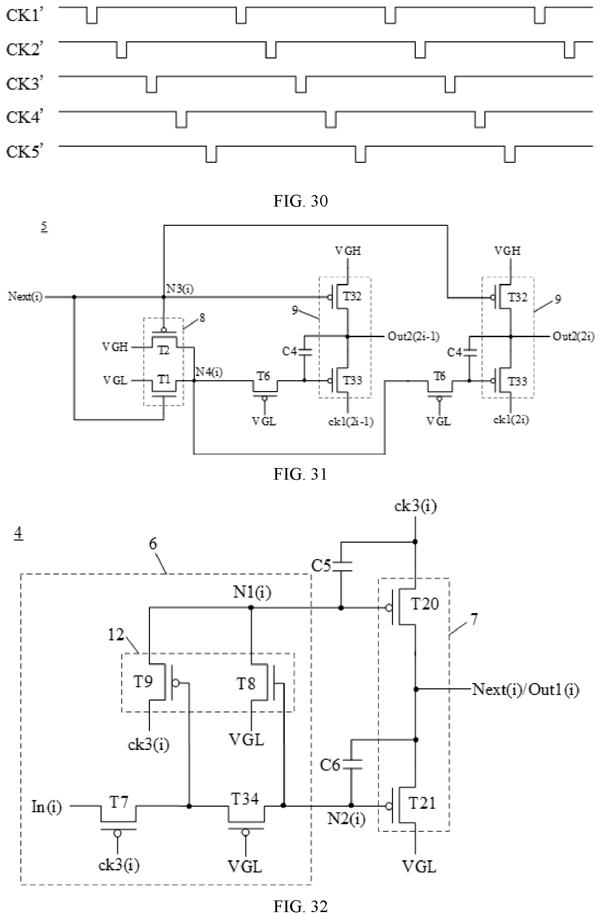

Regarding the connection between the clock terminals of the shift unit 3 and the clock lines, in another feasible implementation, with reference to Table 3 and FIG. 21, as shown in FIG. 29 and FIG. 30, where FIG. 29 is another structural schematic diagram of a display panel according to an embodiment of the present disclosure, and FIG. 30 is a timing diagram corresponding to FIG. 29, m=2.

The display panel includes a first clock line CK1', a second clock line CK2', a third clock line CK3', a fourth clock line CK4', and a fifth clock line CK5'.

The second clock terminal ck2 corresponding to the (5x-4)-th-stage shift unit 3 is electrically connected to the first clock line CK1', and two first clock terminals ck1 corresponding to the (5x-4)-th-stage shift unit 3 are respectively electrically connected to the second clock line CK2' and the third clock line CK3', where x is a positive integer, such as 1, 2, 3, and so on. The second clock terminal ck2 corresponding to the (5x-3)-th-stage shift unit 3 is electrically connected to the third clock line CK3', and two first clock terminals ck1 corresponding to the (5x-3)-th-stage shift unit 3 are respectively electrically connected to the fourth clock line CK4' and the fifth clock line CK5'. The second clock terminal ck2 corresponding to the (5x-2)-th-stage shift unit 3 is electrically connected to the fifth clock line CK5', and two first clock terminals ck1 corresponding to the (5x-2)-th-stage shift unit 3 are respectively electrically connected to the first clock line CK1' and the second clock line CK2'. The second clock terminal ck2 corresponding to the (5x-1)-th-stage shift unit 3 is electrically connected to the second clock line CK2', and two first clock terminals ck1 corresponding to the (5x-1)-th-stage shift unit 3 are respectively electrically connected to the third clock line CK3' and the fourth clock line CK4'. The second clock terminal ck2 corresponding to the 5x-th-stage shift unit 3 is electrically connected to the fourth clock line CK4', and two first clock terminals ck1 corresponding to the 5x-th-stage shift unit 3 are respectively electrically connected to the fifth clock line CK5' and the first clock line CK1'.

**Table 3**

| | ck2 | ck1-1 | ck1-2 |
|---|---|---|---|
| First-stage shift unit 3(1) | CK1' | CK2' | CK3' |
| Second-stage shift unit 3(2) | CK3' | CK4' | CK5' |
| Third-stage shift unit 3(3) | CK5' | CK1' | CK2' |
| Fourth-stage shift unit 3(4) | CK2' | CK3' | CK4' |
| Fifth-stage shift unit 3(5) | CK4' | CK5' | CK1' |
| Sixth-stage shift unit 3(6) | CK1' | CK2' | CK3' |
| Seventh-stage shift unit 3(7) | CK3' | CK4' | CK5' |
| Eighth-stage shift unit 3(8) | CK5' | CK1' | CK2' |
| Ninth-stage shift unit 3(9) | CK2' | CK3' | CK4' |
| Tenth-stage shift unit 3(10) | CK4' | CK5' | CK1' |
| ...... | | | |

The display panel with such structure includes an odd number of clock lines. Similar to the foregoing embodiments, based on the connection between the clock terminals of the shift unit 3 and the clock lines, the second terminals Out2 of the shift register 2 can also sequentially output low levels.

In addition, the first circuit 4 may also include some clock terminals. In some structures, a subset of clock terminals in the first circuit 4 may transmit the same signal as the second clock terminal ck2 in the second circuit 5, that is, the subset of clock terminals in the first circuit 4 and the second clock terminal ck2 in the second circuit 5 are connected to the same clock line, which will be described in detail in the following embodiments. Such arrangement may increase the load of the clock line connected to the second clock terminal ck2. By adopting the connection between the clock terminals of the shift unit 3 and the clock lines, and with reference to Table 3, each clock line is connected to the second clock terminal ck2 in turn, so that the loads of the clock lines are more balanced.

In a feasible implementation, referring to FIG. 19, the second circuit 5 further includes a sixth switching transistor T6. The second driving module 8 is electrically connected to the fourth node N4 through the sixth switching transistor T6, and a gate of the sixth switching transistor T6 is electrically connected to the second power terminal VGL.

Alternatively, as shown in FIG. 31, which is another structural schematic diagram of a second circuit 5 according to an embodiment of the present disclosure, the second circuit 5 further includes at least one sixth switching transistor T6, and the at least one sixth switching transistor T6 and the at least one second output module 9 are in a one-to-one correspondence with each other. The sixth switching transistor T6 is electrically connected between the fourth node N4 and the respective second output module 9 corresponding to the sixth switching transistor T6, and a gate of the sixth switching transistor T6 is electrically connected to the second power terminal VGL.

The sixth switching transistor T6 may play a protective role in the circuit. When the potential of the second electrode of the sixth switching transistor T6 is too low, the sixth switching transistor T6 can protect the switching transistor in the second driving module 8, such as the first switching transistor T1 or the fifth switching transistor T5, from being broken down.

In a feasible implementation, referring to FIG. 13, the second output module 9 includes a thirty-second switching transistor T32 and a thirty-third switching transistor T33.

The thirty-second switching transistor T32 has a gate electrically connected to the third node N3, a first electrode electrically connected to the first power terminal VGH, and a second electrode electrically connected to the second terminal Out2. The thirty-third switching transistor T33 has a gate electrically connected to the fourth node N4, a first electrode electrically connected to the first clock terminal ck1, and a second electrode electrically connected to the second terminal Out2.

When the third node N3 is at a low level, the thirty-second switching transistor T32 is turned on, so that the high level provided by the first power terminal VGH is written into the second terminal Out2. When the fourth node N4 is at a low level, the thirty-third switching transistor T33 is turned on, so that the pulse of the first clock terminal ck1 is written into the second terminal Out2.

In addition, the second output module 9 may further include a fourth capacitor C4. The fourth capacitor C4 has a first plate electrically connected to the gate of the thirty-third transistor T33, and a second plate electrically connected to the second terminal Out2.

In a feasible implementation, referring to FIG. 7 and FIG. 8, the second circuit 5 includes m second output modules 9, where m≥2. The m second output modules 9 are respectively electrically connected to m second terminals Out2 and respectively electrically connected to m first clock terminals ck1, and the m first clock terminals ck1 sequentially provide active pulses.

In such structure, one shift unit 3 is configured to provide gate signals to the second transistors M2 in at least two circuit rows 20. Compared with one shift unit 3 driving only the second transistors M2 in one circuit row 20, such structure can reduce the number of shift units 3, thereby reducing the space occupied by the shift register 2 in the bezel.

In addition, when the second circuit 5 includes m second terminals Out2, only the m second output modules 9 are independent of each other, and the m second output modules 9 share one second driving module 8 for driving, so that the overall structure of the second circuit 5 is simpler.

In some embodiments of the present disclosure, m may be equal to 2, 4, 6, or the like. When the value of m is relatively large, the size of the switching transistors in the second output module 9 may be increased to improve the stability of the second circuit 5.

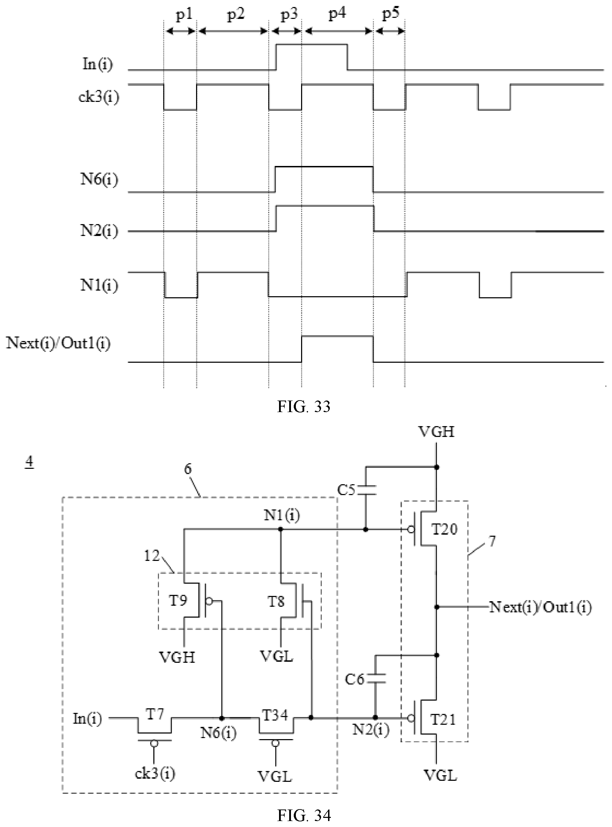

Regarding the first driving module 6, in a feasible implementation, as shown in FIG. 32 and FIG. 33, where FIG. 32 is a structural schematic diagram of a first circuit 4 according to an embodiment of the present disclosure, and FIG. 33 is a timing diagram corresponding to FIG. 32, the first driving module 6 includes a seventh switching transistor T7 and a first control unit 12.

The seventh switching transistor T7 has a gate electrically connected to the third clock terminal ck3, a first electrode electrically connected to the shift input terminal In, and a second electrode electrically connected to the second node N2. The first control unit 12 controls the signal of the first node N1.

For ease of understanding, in the drawings of the embodiments of the present disclosure, the third clock terminal corresponding to the i-th-stage shift unit 3(i) is marked with reference sign ck3(i).

In the first driving module 6, the first control unit 12 controls the voltage of the first node N1, and the seventh switching transistor T7 controls the voltage of the second node N2. The control logic circuits of the first node N1 and the second node N2 are independent of each other, so that the signal stability of the two nodes is stronger. In addition, the voltage of the second node N2 is determined only by the seventh switching transistor T7, so that the control logic circuit corresponding to the second node N2 has a simple structure and a small number of switching transistors.

In a feasible implementation, referring to FIG. 32 and FIG. 33, the first control unit 12 includes an eighth switching transistor T8 and a ninth switching transistor T9.

The eighth switching transistor T8 is an N-type transistor. The eighth switching transistor T8 has a gate electrically connected to the second node N2, a first electrode electrically connected to the second power terminal VGL, and a second electrode electrically connected to the first node N1. The ninth switching transistor T9 is a P-type transistor. The ninth switching transistor T9 has a gate electrically connected to the second node N2, a first electrode electrically connected to the third clock terminal ck3, and a second electrode electrically connected to the first node N1.

The first output module 7 outputs the signal of the third clock terminal ck3 in response to the voltage of the first node N1.

In an example, the first output module 7 includes a twentieth switching transistor T20 and a twenty-first switching transistor T21. The twentieth switching transistor T20 has a gate electrically connected to the first node N1, and a first electrode electrically connected to the third clock terminal ck3. The twentieth switching transistor T20 has a gate electrically connected to the second node N2, and a first electrode electrically connected to the second power terminal VGL. A second electrode of the twentieth switching transistor T20 and a second electrode of the twenty-first switching transistor T21 are both electrically connected to the shift output terminal Next or the first terminal Out1.

Referring to FIG. 33, the operating process of the first driving module 6 includes time periods p1 to p5.

In the time period p1, the third clock terminal ck3 is at a low level, and the shift input terminal In is at a low level. The seventh switching transistor T7 is turned on to set the second node N2 to a low level. The ninth switching transistor T9 is controlled to be turned on to set the first node N1 to a low level. The first output module 7 outputs the low level of the third clock terminal ck3 in response to the low level of the first node N1.

In the time period p2, the third clock terminal ck3 is at a high level, the seventh switching transistor T7 is turned off, and the second node N2 maintains a low level. The ninth switching transistor T9 remains turned on to set the first node N1 to a high level, and the first output module 7 maintains outputting a low level.

In the time period p3, the third clock terminal ck3 is at a low level. The shift input terminal In jumps to a high level to set the second node N2 to a high level. The eighth switching transistor T8 is controlled to be turned on to set the first node N1 to a low level. The first output module 7 outputs the low level of the third clock terminal ck3 in response to the low level of the first node N1.

In the time period p4, the third clock terminal ck3 is at a high level, the second node N2 maintains a high level, and the first node N1 maintains a low level. The first output module 7 outputs the high level of the third clock terminal ck3 in response to the low level of the second node N2. The pulse width of the signal output by the first output module 7 is the duration of one high level output by the third clock terminal ck3.

In the time period p5, the third clock terminal ck3 is at a low level, the shift input terminal In is at a low level, and the second node N2 is set to a low level. The ninth switching transistor T9 is turned on to set the first node N1 to a low level. The first output module 7 outputs the low level of the third clock terminal ck3 in response to the low level of the first node N1.

In such structure, by providing an N-type transistor in the first driving module 6, the pulse output by the first output module 7 can be normally shifted with respect to the pulse of the shift input terminal In only using the seventh switching transistor T7, the eighth switching transistor T8 and the ninth switching transistor T9, so that the structure of the first circuit 4 is simpler.

Alternatively, in another feasible implementation, as shown in FIG. 34, which is a structural schematic diagram of a first circuit 4 according to an embodiment of the present disclosure, the first control unit 12 includes an eighth switching transistor T8 and a ninth switching transistor T9.

The eighth switching transistor T8 is an N-type transistor. The eighth switching transistor T8 has a gate electrically connected to the second node N2, a first electrode electrically connected to the second power terminal VGL, and a second electrode electrically connected to the first node N1. The ninth switching transistor T9 is a P-type transistor. The ninth switching transistor T9 has a gate electrically connected to the second node N2, a first electrode electrically connected to the first power terminal VGH, and a second electrode electrically connected to the first node N1.

The first output module 7 outputs the signal of the first power terminal VGH in response to the voltage of the first node N1.

In an example, the first output module 7 includes a twentieth switching transistor T20 and a twenty-first switching transistor T21. The twentieth switching transistor T20 has a gate electrically connected to the first node N1, and a first electrode electrically connected to the first power terminal VGH. The twentieth switching transistor T20 has a gate electrically connected to the second node N2, and a first electrode electrically connected to the second power terminal VGL. A second electrode of the twentieth switching transistor T20 and a second electrode of the twenty-first switching transistor T21 are both electrically connected to the shift output terminal Next or the first terminal Out1.

In such structure, the first output module 7 outputs a high level in response to the low level of the first node N1 and outputs a low level in response to the low level of the second node N2. When the second node N2 is at a low level, the ninth switching transistor T9 is turned on to set the first node N1 to a high level. When the second node N2 is at a high level, the eighth switching transistor T8 is turned on to set the first node N1 to a low level. Therefore, the level states of the signals of the first node N1 and the second node N2 remain opposite, so that the first output module 7 can only operate in response to either the low level of the first node N1 or the low level of the second node N2 at the same time, thereby ensuring the accuracy of the signal output by the first output module 7.

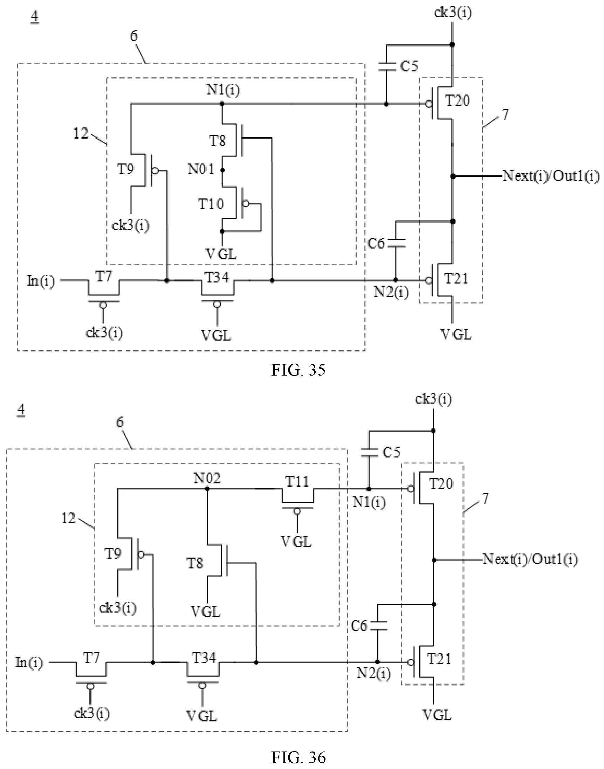

In a feasible implementation, as shown in FIG. 35, which is another structural schematic diagram of a first circuit 4 according to an embodiment of the present disclosure, a first electrode of the eighth switching transistor T8 is electrically connected to the second power terminal VGL through the tenth switching transistor T10, and a gate of the tenth switching transistor T10 is electrically connected to the second power terminal VGL.

There is a node N01 between the eighth switching transistor T8 and the tenth switching transistor T10. The tenth switching transistor T10 is a P-type transistor, and the gate and the first electrode of the tenth switching transistor T10 are both electrically connected to the second power terminal VGL. When the voltage of the node N01 is higher than VGL+|Vth|, the tenth switching transistor T10 is turned on. The low level of the second power terminal VGL pulls the voltage of the node N01 down until the voltage written to the node N01 is equal to VGL+|Vth|, at which point the tenth switching transistor T10 is turned off. That is, it can be understood that the tenth switching transistor T10 is turned on only when the tenth switching transistor T10 is powered on or the node N01 is disturbed. After the tenth switching transistor T10 is turned on and the voltage written into the node N01 reaches the target voltage, the tenth switching transistor T10 remains in a state of being just turned off. For example, if VGL is -8V, when the voltage of the node N01 is higher than -8V+|Vth|, the tenth switching transistor T10 is turned on, and the VGL signal pulls the node N01 down until the potential of the node N01 becomes -8V+|Vth|, at which point the tenth switching transistor T10 is turned off, and then the potential of the node N01 is maintained at -8V+|Vth|, for example, maintained at -6V, thereby making the potential of the first electrode of the eighth switching transistor T8 less negative. The eighth switching transistor T8 is an N-type transistor, and is turned off when the gate-source voltage of the eighth switching transistor T8 is less than the threshold voltage. Compared with the eighth switching transistor T8 being directly connected to the second power terminal VGL, the above design can keep the eighth switching transistor T8 in a turned-off state even when the voltage of the second node N2 is less negative, thereby preventing the eighth switching transistor T8 and the ninth switching transistor T9 from being simultaneously turned on, improving the circuit operation reliability, and avoiding the deterioration of power consumption.

In a feasible implementation, as shown in FIG. 36, which is another structural schematic diagram of a first circuit 4 according to an embodiment of the present disclosure, the second electrode of the ninth switching transistor T9 and the second electrode of the eighth switching transistor T8 are electrically connected to the first node N1 through the eleventh switching transistor T11, and the gate of the eleventh switching transistor T11 is electrically connected to the second power terminal VGL.

There is a node N02 between the second electrode of the ninth switching transistor T9, the second electrode of the eighth switching transistor T8, and the eleventh switching transistor T11. When the ninth switching transistor T9 or the eighth switching transistor T8 writes a low level to the node N02, the eleventh switching transistor T11 has a voltage drop, which can make the voltage of the first node N1 more negative, thereby eliminating the tail of the signal output by the first output module 7.

In a feasible implementation, referring to FIG. 36, the seventh switching transistor T7 may be electrically connected to the second node N2 through the first protection switching transistor T34, and a gate of the first protection switching transistor T34 is electrically connected to the second power terminal VGL. The gate of the ninth switching transistor T9 is electrically connected to the second node N2 through the first protection switching transistor T34. The first protection switching transistor T34 can protect the seventh switching transistor T7 from being broken down when the potential of the second node N2 is too low.

In addition, referring to FIG. 36, the first circuit 4 may further include a fifth capacitor C5 and/or a sixth capacitor C6. The fifth capacitor C5 is connected between the first electrode of the twentieth switching transistor T20 and the first node N1. The sixth capacitor C6 is connected between the second electrode of the twenty-first switching transistor T21 and the second node N2.

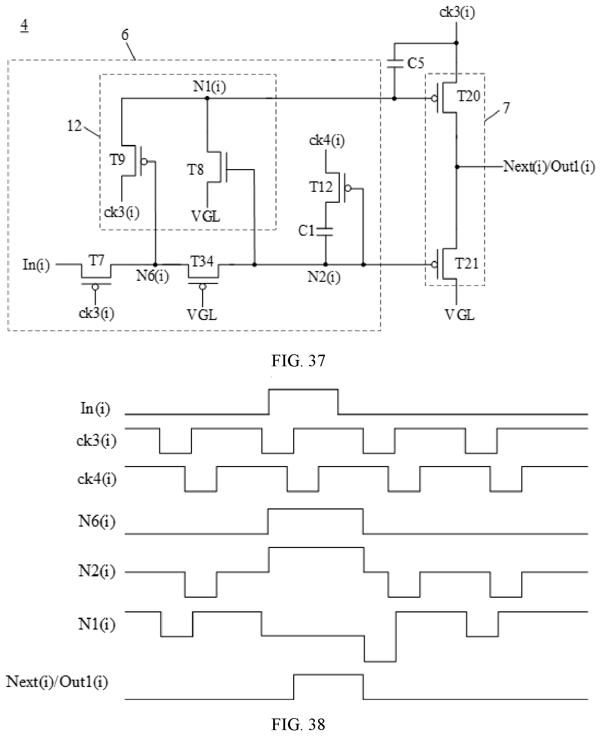

In a feasible implementation, as shown in FIG. 37 and FIG. 38, where FIG. 37 is another structural schematic diagram of a first circuit 4 according to an embodiment of the present disclosure, and FIG. 38 is a timing diagram corresponding to FIG. 37, the first driving module 6 further includes a twelfth switching transistor T12. The twelfth switching transistor T12 has a gate electrically connected to the second node N2, a first electrode electrically connected to the fourth clock terminal ck4, and a second electrode electrically connected to the second node N2 through the first capacitor C1.

For ease of understanding, in the drawings of the embodiments of the present disclosure, the fourth clock terminal corresponding to the i-th-stage shift unit 3(i) is marked with ck4(i).

With reference to FIG. 38, when the second node N2 is at a low level, the twelfth switching transistor T12 is turned on. When the fourth clock terminal ck4 jumps to a low level, with the first capacitor C1, the potential of the second node N2 may be pulled lower, thereby enabling the first output module 7 to output a low level more stably.

In the above structure, the third clock terminal ck3 and the fourth clock terminal ck4 are respectively connected to different clock lines.

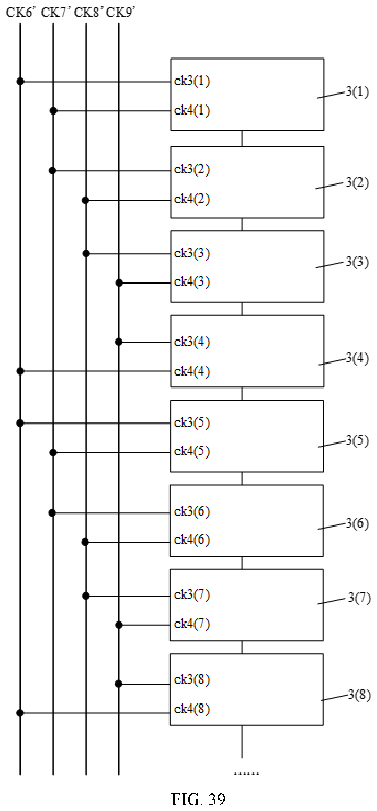

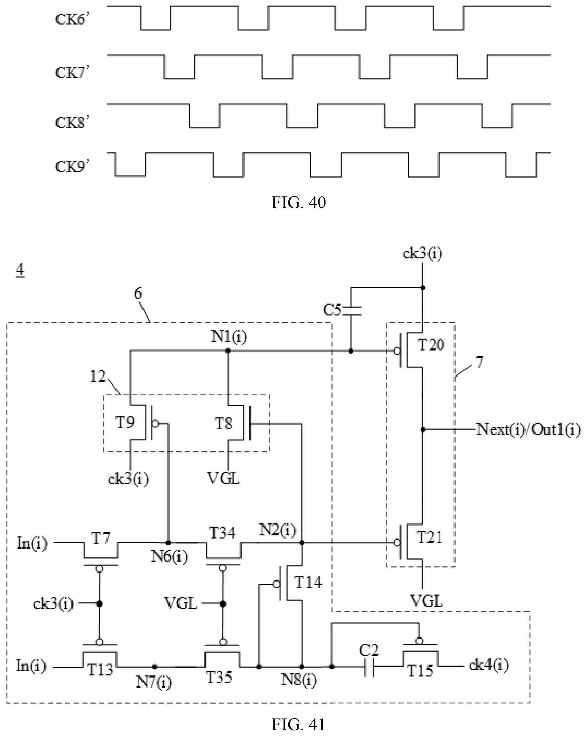

In a feasible implementation, as shown in FIG. 39 and FIG. 40, where FIG. 39 is another structural schematic diagram of a display panel according to an embodiment of the present disclosure, and FIG. 40 is a timing diagram corresponding to FIG. 39, the display panel also includes a sixth clock line CK6', a seventh clock line CK7', an eighth clock line CK8' and a ninth clock line CK9'.

The third clock terminal ck3 and the fourth clock terminal ck4 in the (4x-3)-th-stage shift unit 3 are respectively electrically connected to the sixth clock line CK6' and the seventh clock line CK7'. The third clock terminal ck3 and the fourth clock terminal ck4 in the (4x-2)-th-stage shift unit 3 are respectively electrically connected to the seventh clock line CK7' and the eighth clock line CK8'. The third clock terminal ck3 and the fourth clock terminal ck4 in the (4x-1)-th-stage shift unit 3 are respectively electrically connected to the eighth clock line CK8' and the ninth clock line CK9'. The third clock terminal ck3 and the fourth clock terminal ck4 in the 4x-th-stage shift unit 3 are respectively electrically connected to the ninth clock line CK9' and the sixth clock line CK6', where x is a positive integer, such as 1, 2, 3,...., and so on.

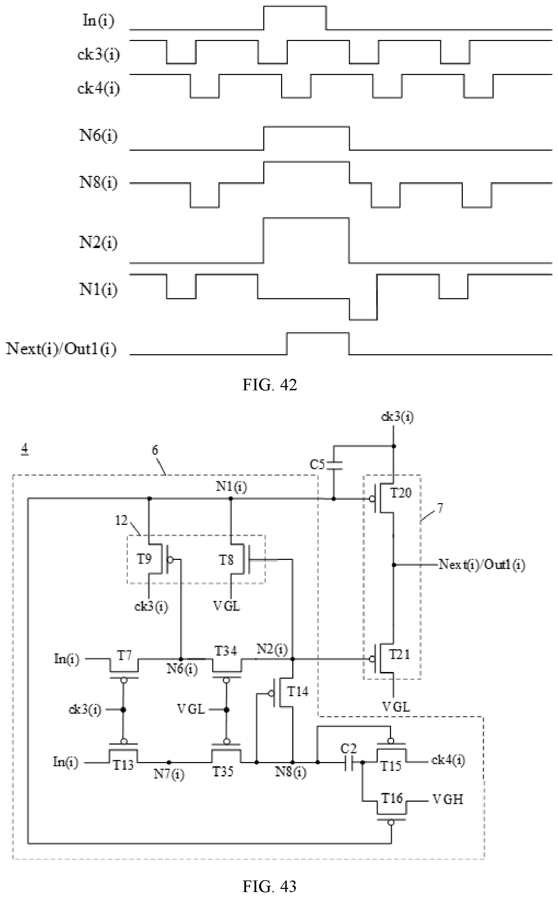

In a feasible implementation, as shown in FIG. 41 and FIG. 42, where FIG. 41 is another structural schematic diagram of a first circuit 4 according to an embodiment of the present disclosure, and FIG. 42 is a timing diagram corresponding to FIG. 41, the first driving module 6 further includes a thirteenth switching transistor T13, a fourteenth switching transistor T14, and a fifteenth switching transistor T15.

The thirteenth switching transistor T13 has a gate electrically connected to the third clock terminal ck3, and a first electrode electrically connected to the shift input terminal In. A gate and a first electrode of the fourteenth switching transistor T14 are both electrically connected to a second electrode of the thirteenth switching transistor T13, and a second electrode of the fourteenth switching transistor T14 is electrically connected to the second node N2. The fifteenth switching transistor T15 has a gate electrically connected to the second electrode of the thirteenth switching transistor T13, a first electrode electrically connected to the fourth clock terminal ck4, and a second electrode electrically connected to the gate of the fourteenth switching transistor T14 through the second capacitor C2.

With reference to FIG. 42, when the thirteenth switching transistor T13 is turned on, and the eighth node N8 is set to be a low level, the fifteenth switching transistor T15 is turned on. During the process in which the fifteenth switching transistor T15 is turned on, when the fourth clock terminal ck4 jumps to be a low level, with the second capacitor C2, the potential of the eighth node N8 is pulled lower, thereby stabilizing the low potential of the second node N2. In this way, on the one hand, the eighth switching transistor T8 can be prevented from being turned on due to the voltage of the second node N2 not being low enough. On the other hand, when the display panel performs low-frequency driving, the problem that the low level output by the first output module 7 is not negative enough due to the leakage current of the second node N2 can also be mitigated.

Further, as shown in FIG. 43, which is another structural schematic diagram of a first circuit 4 according to an embodiment of the present disclosure, the first driving module 6 further includes a sixteenth switching transistor T16. The sixteenth switching transistor T16 has a gate electrically connected to the first node N1, a first electrode electrically connected to the first power terminal VGH, and a second electrode electrically connected to the second electrode of the fifteenth switching transistor T15.

When the first node N1 is at a low level, the sixteenth switching transistor T16 is turned on, setting the potential of the first plate of the second capacitor C2 to a high level, and further setting the potential of the second plate of the second capacitor C2, i.e., the potential of the eighth node N8, to a high level, thereby cutting off the path for the fourteenth switching transistor T14 to transmit a signal to the second node N2.

In a feasible implementation, referring to FIG. 43, the thirteenth switching transistor T13 may be electrically connected to the eighth node N8 through the second protection switching transistor T35, and a gate of the second protection switching transistor T35 is electrically connected to the second power terminal VGL.

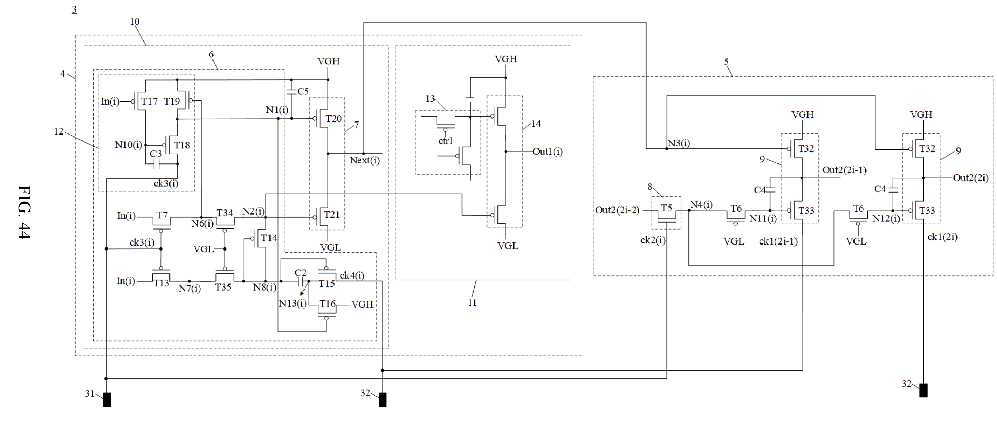

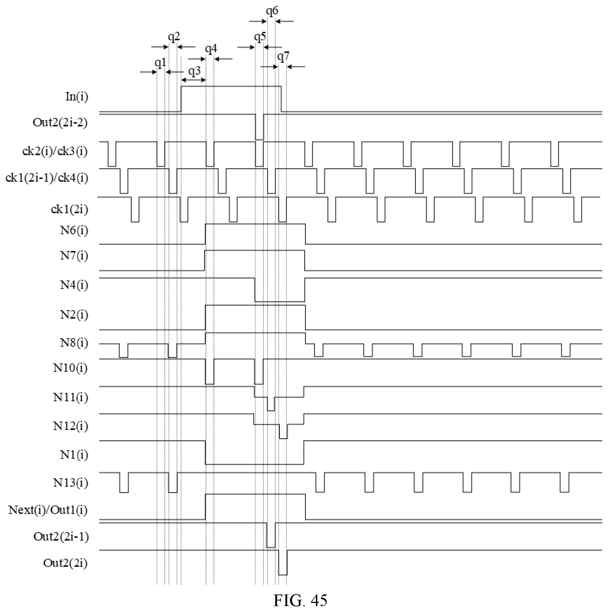

Regarding the first control unit 12, in another feasible implementation, as shown in FIG. 44 and FIG. 45, where FIG. 44 is another structural schematic diagram of a shift unit 3 according to an embodiment of the present disclosure, and FIG. 45 is a timing diagram corresponding to FIG. 44, the first control unit 12 includes a seventeenth switching transistor T17, an eighteenth switching transistor T18, and a nineteenth switching transistor T19.

The seventeenth switching transistor T17 has a gate electrically connected to the shift input terminal In, a first electrode electrically connected to the first power terminal VGH, and a second electrode electrically connected to the third clock terminal ck3 through the third capacitor C3. The eighteenth switching transistor T18 has a gate electrically connected to the second electrode of the seventeenth switching transistor T17, a first electrode electrically connected to the third clock terminal ck3, and a second electrode electrically connected to the first node N1. The nineteenth switching transistor T19 has a gate electrically connected to the second node N2, a first electrode electrically connected to the first power terminal VGH, and a second electrode electrically connected to the first node N1.

The second output module 9 outputs the voltage of the first power terminal VGH to the second terminal Out2 in response to the first level of the third node N3, and outputs the voltage of the first clock terminal ck1 to the second terminal Out2 in response to the first level of the fourth node N4. The first level is a low level.

The second driving module 8 includes a fifth switching transistor T5. The fifth switching transistor T5 has a gate electrically connected to the second clock terminal ck2, and a second electrode electrically connected to the fourth node N4.

A first electrode of the fifth switching transistor T5 in the i-th-stage shift unit 3(i) is electrically connected to the second terminal Out2 of the i-th-stage shift unit 3. For the same shift unit 3, during a time period in which the third node N3 is at the second level, the second terminal Out2 connected to the fifth switching transistor T5 outputs a first level, and the first level overlaps with the first level provided by the second clock terminal ck2 connected to the fifth switching transistor T5.

In the same shift unit 3, the third clock terminal ck3 and the second clock terminal ck2 are electrically connected to the same first signal pin 31.

In an example, the third clock terminal ck3 and the second clock terminal ck2 are connected to the same clock line, and then the clock line is connected to the same first signal pin 31. Alternatively, the third clock terminal ck3 is electrically connected to one clock line, the second clock terminal ck2 is electrically connected to one clock line, and the two clock lines are connected to the same first signal pin 31.

Further, when the first driving module 6 further includes the twelfth switching transistor T12 or the fifteenth switching transistor T15, in the same stage of shift unit 3, the fourth clock terminal ck4 and the first clock terminal ck1 are electrically connected to the same second signal pin 32. When the second circuit 5 includes at least two first clock terminals ck1, the fourth clock terminal ck4 may be electrically connected to any one of the at last two first clock terminals ck1.

Based on the above structure, the operating process of the shift unit 3 includes time periods q1 to q7.

In the time period q1, the shift input terminal In(i) is at a low level, and the second clock terminal ck2(i) and the third clock terminal ck3(i) are at a low level. The seventh switching transistor T7 is turned on to set the second node N2 (i) to a low level. The seventeenth switching transistor T17 is turned on to set the tenth node N10 (i) to a high level, and to control the eighteenth switching transistor T18 to be turned off. The nineteenth switching transistor T19 is turned on to set the first node N1 (i) to a high level. In this time period, the shift output terminal Next(i) and the first terminal Out1(i) output a low level. For the second circuit 5, the third node N3(i) is at a low level, and both the second terminal Out2(2i-1) and the second terminal Out2(2i) output a high level.

In the time period q2, the shift input terminal In(i) is at a low level, and the first clock terminal ck1(2i-1) and the fourth clock terminal ck4(i) are at a low level. The shift output terminal Next(i) and the first terminal Out1(i) continuously output a low level, and two second terminals Out2 continuously output a high level.

In the time period q3, the shift input terminal In(i) is at a high level, and the second clock terminal ck2(i) and the third clock terminal ck3(i) are at a high level. The shift output terminal Next(i) and the first terminal Out1(i) continuously output a low level, and the second terminal Out2(2i-1) and the second terminal Out2(2i) continuously output a high level.

In the time period q4, the shift input terminal In(i) is at a high level, and the second clock terminal ck2(i) and the third clock terminal ck3(i) are at a low level. The seventh switching transistor T7 is turned on to set the second node N2 to a high level. The tenth node N10 (i) is set to a low level, and the eighteenth switching transistor T18 is turned on to set the first node N1 to a low level. The shift output terminal Next(i) and the first terminal Out1(i) output a high level. For the second circuit 5, since the second terminal Out2(2i-2) of the preceding-stage shift unit 3(i-1) is at a high level, the second terminal Out2(2i-1) and the second terminal Out2(2i) continuously output a high level.

In the time period q5, the shift input terminal In(i) is at a high level, and the second clock terminal ck2(i) and the third clock terminal ck3(i) are at a low level. The seventh switching transistor T7 is turned on to write a high level to the second node N2. The tenth node N10(i) is set to a low level, and the eighteenth switching transistor T18 is turned on, to write a low level to the first node N1. The shift output terminal Next(i) and the first terminal Out1(i) output a high level. For the second circuit 5, the fifth switching transistor T5 is turned on, and the second terminal Out2(2i-2) of the preceding-stage shift unit 3(i-1) is at a low level, to write a low level to the fourth node N4.

In the time period q6, the first clock terminal ck1(2i-1) outputs an active pulse, and the second terminal Out2(2i-1) outputs a low level.

In the time period q7, the first clock terminal ck1(2i) outputs an active pulse, and the second terminal Out2(2i) outputs a low level.

In the above configuration, the third clock terminal ck3 and the second clock terminal ck2 are electrically connected to the same first signal pin 31, which can reduce the number of clock lines and/or signal pins in the display panel on the premise of ensuring the normal operation of the circuit.

In addition, when the third clock terminal ck3 and the second clock terminal ck2 are electrically connected to the same clock line, the number of clock terminals connected to this type of clock line is larger, and the load will be correspondingly larger. In this case, the clock terminals and the clock lines may be connected to each other according to the connections shown in FIG. 27 and FIG. 29. Under these two connections, each clock line is connected to the second clock terminal ck2 and the fourth clock terminal ck4 in turn, thereby making the loads of the clock lines more balanced.

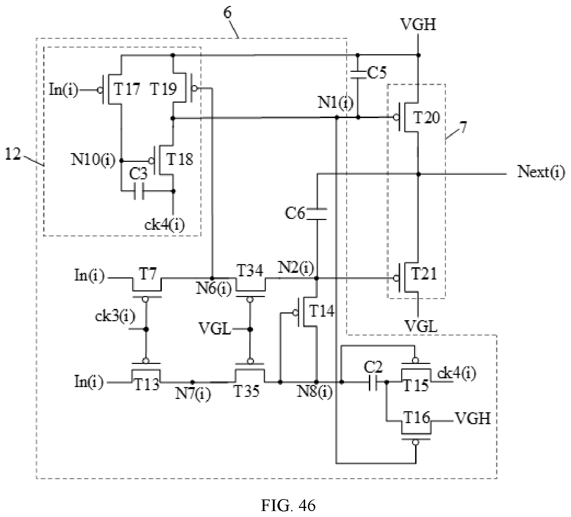

Alternatively, in another feasible implementation, as shown in FIG. 46, which is another structural schematic diagram of a first circuit 4 according to an embodiment of the present disclosure, the first control unit 12 includes a seventeenth switching transistor T17, an eighteenth switching transistor T18, and a nineteenth switching transistor T19.

The seventeenth switching transistor T17 has a gate electrically connected to the shift input terminal In, a first electrode electrically connected to the first power terminal VGH, and a second electrode electrically connected to the fourth clock terminal ck4 through the third capacitor C3. The eighteenth switching transistor T18 has a gate electrically connected to the second electrode of the seventeenth switching transistor T17, a first electrode electrically connected to the fourth clock terminal ck4, and a second electrode electrically connected to the first node N1. The nineteenth switching transistor T19 has a gate electrically connected to the second node N2, a first electrode electrically connected to the first power terminal VGH, and a second electrode electrically connected to the first node N1.

Compared with FIG. 44, the first electrode of the eighteenth switching transistor T18 is electrically connected to the fourth clock terminal ck4, which can also ensure the normal operation of the first circuit 4, except that the transition time of the high level output by the shift output terminal Next and the first terminal Out1 is changed from the time when the first clock terminal ck1 jumps to a low level to the time when the fourth clock terminal ck4 jumps to a low level, and that the duration of the high level output by the shift output terminal Next and the first terminal Out1 is shorter.

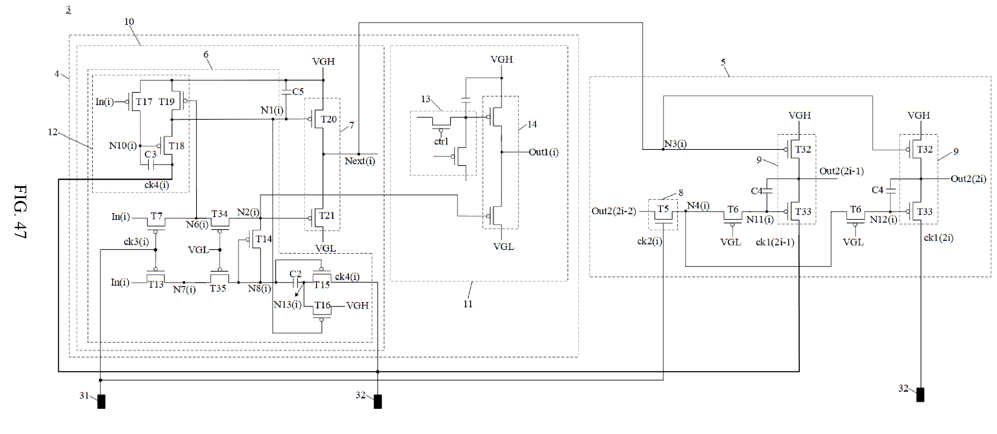

Further, as shown in FIG. 47, which is another structural schematic diagram of a shift unit 3 according to an embodiment of the present disclosure, the second output module 9 outputs the voltage of the first power terminal VGH to the second terminal Out2 in response to the first level of the third node N3, and outputs the voltage of the first clock terminal ck1 to the second terminal Out2 in response to the first level of the fourth node N4.

The second driving module 8 includes a fifth switching transistor T5. The fifth switching transistor T5 has a gate electrically connected to the second clock terminal ck2, and a second electrode electrically connected to the fourth node N4.

A first electrode of the fifth switching transistor T5 in the i-th-stage shift unit 3(i) is electrically connected to the second terminal Out2 of the i-th-stage shift unit 3. For the same shift unit 3, during a time period in which the third node N3 is at the second level, the second terminal Out2 connected to the fifth switching transistor T5 outputs a first level, and the first level overlaps with the first level provided by the second clock terminal ck2 connected to the fifth switching transistor T5.

The third clock terminal ck3 and the second clock terminal ck2 are electrically connected to the same first signal pin 31, and the fourth clock terminal ck4 and one first clock terminal ck1 are electrically connected to the same second signal pin 32.

In an example, the third clock terminal ck3 and the second clock terminal ck2 are connected to the same clock line, and then the clock line is connected to the same first signal pin 31. Alternatively, the third clock terminal ck3 is electrically connected to one clock line, the second clock terminal ck2 is electrically connected to one clock line, and these two clock lines are then electrically connected to each other and further connected to the same first signal pin 31.

The fourth clock terminal ck4 and one first clock terminal ck1 are connected to the same clock line, and then the clock line is connected to the same second signal pin 32. Alternatively, the fourth clock terminal ck4 is electrically connected to one clock line, one first clock terminal ck1 is electrically connected to one clock line, and these two clock lines are then electrically connected to each other and further connected to the same second signal pin 32.

In a feasible implementation, the fourth clock terminal ck4 and the first clock terminal ck1(2i-1) of the i-th-stage shift unit 3(i) are electrically connected to the same second signal pin 32. In this way, the transition time of the high level output by the shift output terminal Next(i) and the first terminal Out1(i) is the time when the first clock terminal ck1(2i-1) jumps to a low level, and the pulse width of the signal output by the shift output terminal Next(i) and the first terminal Out1(i) can be larger.

According to the above configuration, on the premise of ensuring the normal operation of the circuit, the number of the clock lines and/or the signal pins arranged in the display panel can be reduced.

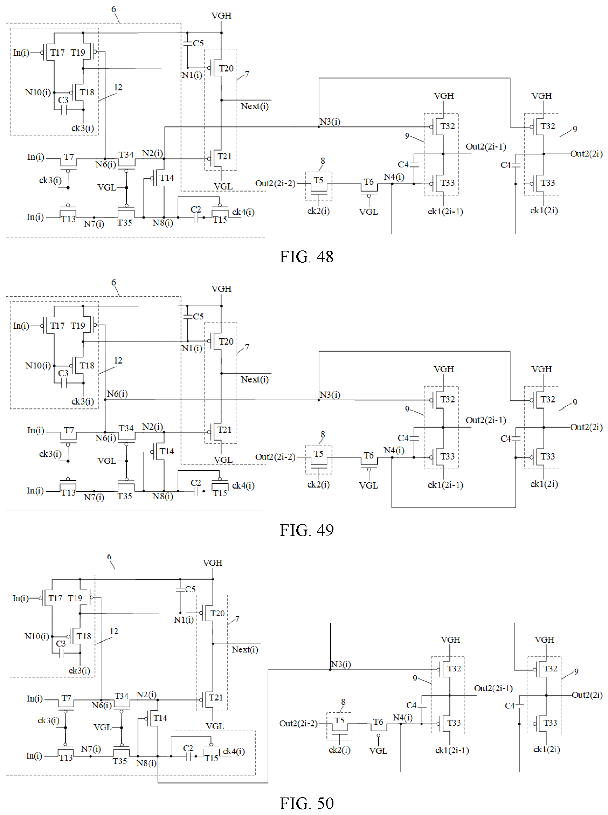

In a feasible implementation, as shown in FIG. 48, which is another structural schematic diagram of a shift unit 3 according to an embodiment of the present disclosure, the third node N3 is electrically connected to the second node N2.

Alternatively, as shown in FIG. 49, which is another structural schematic diagram of a shift unit 3 according to an embodiment of the present disclosure, the seventh switching transistor T7 is electrically connected to the second node N2 through the first protection switching transistor T34, the gate of the first protection switching transistor T34 is electrically connected to the second power terminal VGL, and the third node N3 is electrically connected to the second electrode of the seventh switching transistor T7, that is, electrically connected to the sixth node N6.

Alternatively, as shown in FIG. 50, which is another structural schematic diagram of a shift unit 3 according to an embodiment of the present disclosure, the third node N3 is electrically connected to the first electrode of the fourteenth switching transistor T14, that is, the third node N3 is electrically connected to the eighth node N8.

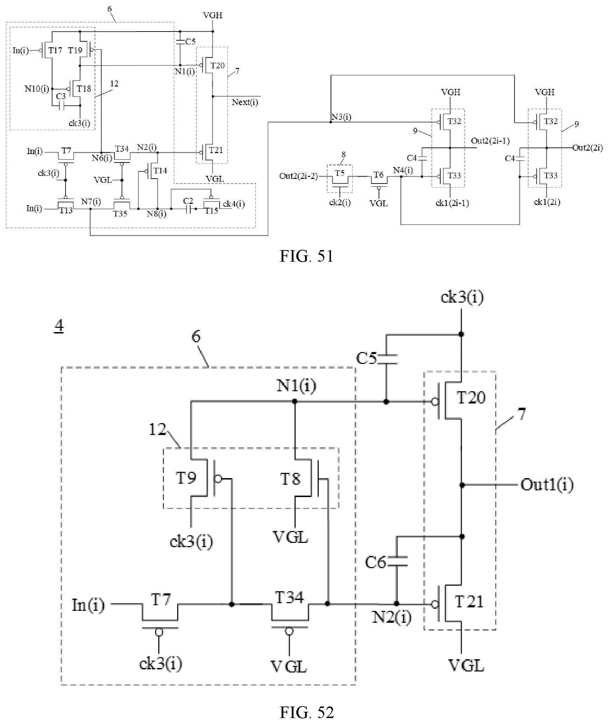

Alternatively, as shown in FIG. 51, which is another structural schematic diagram of a shift unit 3 according to an embodiment of the present disclosure, the thirteenth switching transistor T13 is electrically connected to the fourteenth switching transistor T14 through the second protection switching transistor T35, the gate of the second protection switching transistor T35 is electrically connected to the second power terminal VGL, and the third node N3 is electrically connected to the second electrode of the thirteenth switching transistor T13, that is, the third node N3 is electrically connected to the seventh node N7.

With reference to FIG. 45, based on the structure of the first circuit 4, the level states of the signals of the second node N2, the sixth node N6, the eighth node N8 and the seventh node N7 are basically consistent with each other. Whether the third node N3 is configured to be electrically connected to the second node N2, the sixth node N6, the eighth node N8, or the seventh node N7, the normal operation of the second circuit 5 can be ensured.

In a feasible implementation, referring to FIG. 32 and FIG. 34, the first output module 7 includes a twentieth switching transistor T20 and a twenty-first switching transistor T21.

The twentieth switching transistor T20 has a gate electrically connected to the first node N1, a first electrode electrically connected to the third clock terminal ck3 or the first power terminal VGH, and a second electrode electrically connected to the output terminal. The twenty-first switching transistor T21 has a gate electrically connected to the second node N2, a first electrode electrically connected to the second power terminal VGL, and a second electrode electrically connected to the output terminal. The output terminal may be a shift output terminal Next, or may be a first terminal Out1.

When the first node N1 is at a low level, the twentieth switching transistor T20 is turned on, to output the signal of the third clock terminal ck3 or the high level of the first power terminal VGH. When the second node N2 is at a low level, the twenty-first switching transistor T21 is turned on, to output the low level provided by the second power terminal VGL.

When the twentieth switching transistor T20 is connected to the third clock terminal ck3, the first electrode of the ninth switching transistor T9 may be connected to the third clock terminal ck3. When the twentieth switching transistor T20 is electrically connected to the first power terminal VGH, the first electrode of the ninth switching transistor T9 may be electrically connected to the first power terminal VGH. The operating processes of these two structures have been described in the above embodiments, and will not be repeated herein.

In a feasible implementation, as shown in FIG. 52, which is another structural schematic diagram of a first circuit 4 according to an embodiment of the present disclosure, the first output module 7 includes a first terminal Out1, and provides a signal to the first terminal Out1. In such structure, the signal output by the first output module 7 directly serves as the gate signal of the first transistor M1.

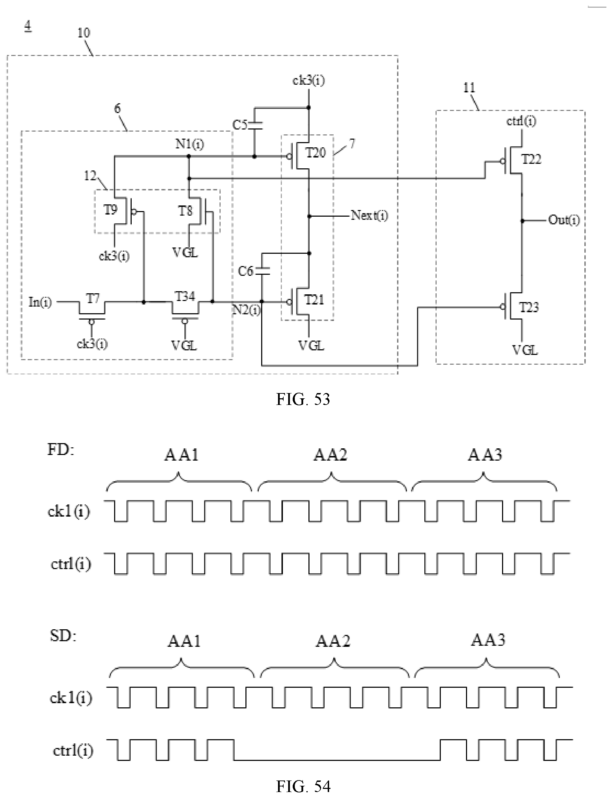

In a feasible implementation, as shown in FIG. 53, which is another structural schematic diagram of a first circuit 4 according to an embodiment of the present disclosure, the first circuit 4 includes a shift control sub-circuit 10 and a region-wise control sub-circuit 11.

The shift control sub-circuit 10 includes a first driving module 6 and a first output module 7. The first driving module 6 includes a shift input terminal In, and the first output module 7 includes a shift output terminal Next. In two consecutive shift units 3, the shift output terminal Next of an upstream shift unit 3 is electrically connected to the shift input terminal In of a downstream shift unit 3.

The region-wise control sub-circuit 11 includes a first terminal Out1, and the region-wise control sub-circuit 11 outputs a signal to the first terminal Out1 according to the region-wise control signal.

In such structure, the signal output by the first output module 7 serves as the shift control signal, and the signal output by the region-wise control sub-circuit 11 serves as the gate signal of the first transistor M1.

In a feasible implementation, referring to FIG. 53, the region-wise control sub-circuit 11 includes a twenty-second switching transistor T22 and a twenty-third switching transistor T23.

The twenty-second switching transistor T22 has a gate electrically connected to the first node N1, a first electrode electrically connected to the region-wise control terminal ctrl, and a second electrode electrically connected to the first terminal Out1. The twenty-third switching transistor T23 has a gate electrically connected to the second node N2, a first electrode electrically connected to the second power terminal VGL, and a second electrode electrically connected to the first terminal Out1.

In such structure, the signal output by the first terminal Out1 is controlled by the signal of the region-wise control terminal ctrl. When part of the display area needs to be driven at a low frequency, in a subset of frames, the region-wise control terminal ctrl may control the first terminal Out1 of the shift unit 3 corresponding to this part of the display area not to output any pulse.

Further, with reference to FIG. 9, FIG. 53, and FIG. 54, where FIG. 54 is a timing diagram corresponding to FIG. 53, the first output module 7 outputs the signal of the third clock terminal ck3 in response to the voltage of the first node N1.

The display panel includes a first region AA1 and a second region AA2.

In the first display mode FD, the driving frequency of the first region AA1 is the same as the driving frequency of the second region AA2, and the level state of the signal provided by the region-wise control terminal ctrl is consistent with the level state of the signal provided by the third clock terminal ck3. In the second display mode SD, the driving frequency of the second region AA2 is less than the driving frequency of the first region AA1. In a subset of frames, when driving the second region AA2, the region-wise control terminal ctrl provides a level for controlling the first transistor M1 to be turned off, that is, a low level.

In the first display mode FD, the region-wise control terminal ctrl provides the same signal as the third clock terminal ck3, that is, the first electrodes of the twentieth control terminal T20 and the twenty-second switching transistor T22 receive the same signal, the twentieth switch T20 and the twenty-second control terminal T22 are synchronously turned on and off, so that the first terminal Out1 and the shift output terminal Next output the same signal, and the first terminals Out1 of the plurality of shift units 3 sequentially output high levels.

In the second display mode SD, the second region AA2 is driven at a low frequency. In a subset of frames, when driving the second region AA2, the region-wise control terminal ctrl provides a low level, so that the first terminal Out1 of the shift unit 3 corresponding to the second region AA2 cannot output a high level, thereby reducing the data refresh frequency of the second region AA2.

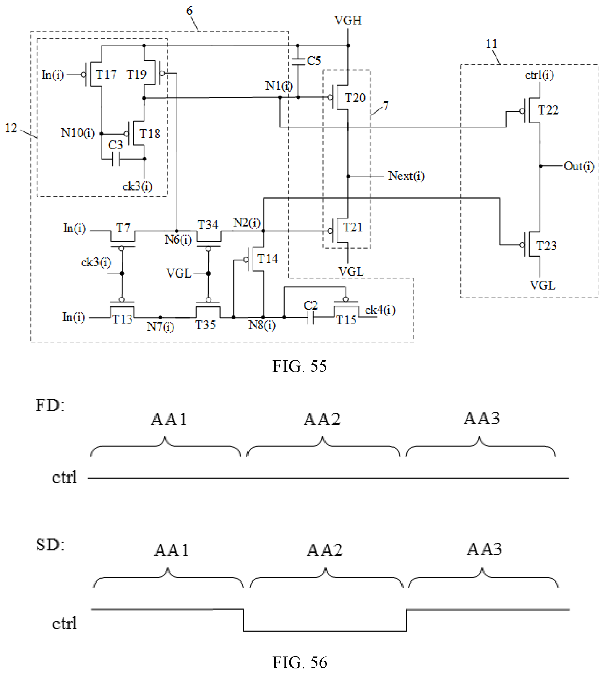

Alternatively, with reference to FIG. 9, FIG. 55 and FIG. 56, where FIG. 55 is another structural schematic diagram of a first circuit 4 according to an embodiment of the present disclosure, and FIG. 56 is a timing diagram corresponding to FIG. 55, the first output module 7 outputs the signal of the first power terminal VGH in response to the voltage of the first node N1.

The display panel includes a first region AA1 and a second region AA2.

In the first display mode FD, the driving frequency of the first region AA1 is the same as the driving frequency of the second region AA2, and the region-wise control terminal ctrl provides a level for controlling the first transistor M1 to be turned on, i.e., a high level. In the second display mode SD, the driving frequency of the second region AA2 is less than the driving frequency of the first region AA1. In a subset of frames, when driving the second region AA2, the region-wise control terminal ctrl provides a level for controlling the first transistor M1 to be turned off, that is, a low level.

In the first display mode FD, the region-wise control terminal ctrl provides the same signal as the third clock terminal ck3, that is, the first electrodes of the twentieth control terminal T20 and the twenty-second switching transistor T22 receive the same signal, the twentieth switch T20 and the twenty-second control terminal T22 are synchronously turned on and off, so that the first terminal Out1 and the shift output terminal Next output the same signal, and the first terminals Out1 of the plurality of shift units 3 sequentially output high levels.

In the second display mode SD, in a subset of frames, when driving the second region AA2, the region-wise control terminal ctrl provides a low level, so that the first terminal Out1 of the shift unit 3 corresponding to the second region AA2 cannot output a high level, thereby reducing the data refresh frequency of the second region AA2.

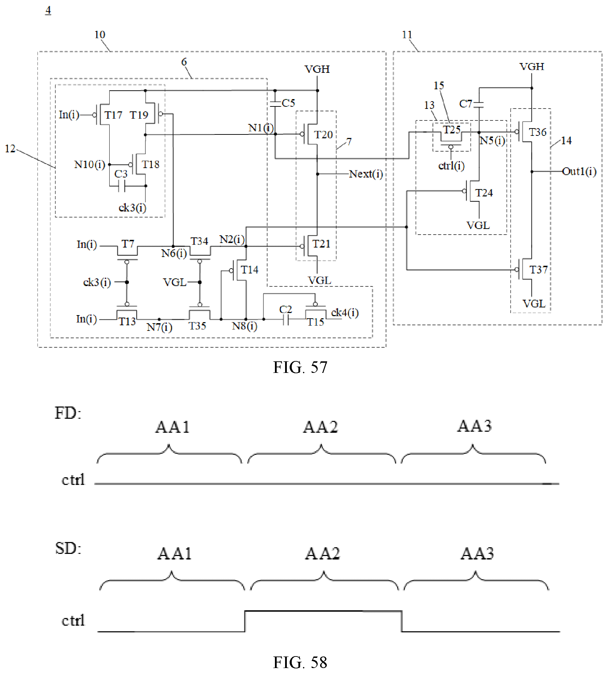

Regarding the region-wise control sub-circuit 11, in another feasible implementation, as shown in FIG. 57, which is another structural schematic diagram of a first circuit 4 according to an embodiment of the present disclosure, the region-wise control sub-circuit 11 includes a third driving module 13 and a third output module 14.

The third output module 14 outputs a level for controlling the first transistor M1 to be turned on, i.e., a high level, to the first terminal Out1 in response to the voltage of the fifth node N5, and outputs a level for controlling the first transistor M1 to be turned off, i.e., a low level, to the first terminal Out1 in response to the voltage of the second node N2.

In an example, the third output module 14 includes a thirty-sixth switching transistor T36 and a thirty-seventh switching transistor T37. The thirty-sixth switching transistor T36 has a gate electrically connected to the fifth node N5, a first electrode electrically connected to the first power terminal VGH, and a second electrode electrically connected to the first terminal Out1. The thirty-seventh switching transistor T37 has a gate electrically connected to the second node N2, a first electrode electrically connected to the second power terminal VGL, and a second terminal Out2 electrically connected to the first terminal Out1.

The third driving module 13 includes a twenty-fourth switching transistor T24 and a second control unit 15. The twenty-fourth switching transistor T24 has a gate electrically connected to the shift control sub-circuit 10, a first electrode electrically connected to the second power terminal VGL, and a second electrode electrically connected to the fifth node N5. In at least some time periods, the level state of the signal at the gate of the twenty-fourth switching transistor T24 is consistent with that of the signal at the second node N2. The second control unit 15 is electrically connected to the region-wise control terminal ctrl and the first driving module 6, and the second control unit 15 controls the signal of the fifth node N5.

In the above structure, the thirty-seventh switching transistor T37 for outputting a low level in the third output module 14 and the twenty-first switching transistor T21 for outputting a low level in the first output module 7 both respond to the voltage of the second node N2, and the two switching transistors are turned on or turned off simultaneously, so that the second terminal Out2 and the shift output terminal Next output low levels at the same time. The thirty-sixth switching transistor T36 for outputting a high level in the third output module 14 operates in response to the voltage of the fifth node N5. The signal of the fifth node N5 is independently controlled by the second control unit 15, and the second control unit 15 can provide a corresponding signal to the fifth node N5 according to whether the display panel performs frequency-per-region driving, thereby controlling whether the first terminal Out1 can output a high level.

In a feasible implementation, referring to FIG. 57, the second control unit 15 includes a twenty-fifth switching transistor T25. The twenty-fifth switching transistor T25 has a gate electrically connected to the region-wise control terminal ctrl, a first electrode electrically connected to the first node N1, and a second electrode electrically connected to the fifth node N5.

With reference to FIG. 58, which is a timing diagram corresponding to FIG. 57, in the first display mode FD, the driving frequency of the first region AA1 is the same as the driving frequency of the second region AA2. In this case, the region-wise control terminal ctrl of each shift unit 3 may be controlled to provide a low level, so that the voltage of the fifth node N5 is consistent with the voltage of the first node N1. Further, the operating states of the thirty-sixth switching transistor T36 and the thirty-seventh switching transistor T37 are consistent with each other. When the shift output terminal Next outputs a pulse, the first terminal Out1 also outputs a pulse synchronously.

In the second display mode SD, the driving frequency of the second region AA2 is less than the driving frequency of the first region AA1. In a subset of frames, when driving the second region AA2, the region-wise control terminal ctrl of the shift unit 3 corresponding to the second region AA2 may be controlled to provide a high level, so that the low level of the first node N1 cannot be written into the fifth node N5, and the second terminal Out2 cannot output a high level.

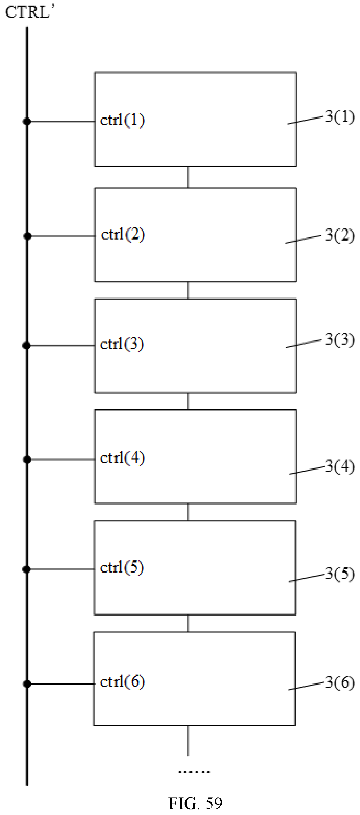

In a feasible implementation, as shown in FIG. 59, which is a schematic diagram of a connection between a shift register 2 and a control line according to an embodiment of the present disclosure, the region-wise control terminals ctrl of a plurality of shift units 3 may be electrically connected to one control line CTRL'.

In the first display mode FD, the control line CTRL' provides a low level. In the second display mode SD, when driving the first region AA1, the control line CTRL' provides a low level. When driving the second region AA2, the control line CTRL' provides a high level.

However, the inventor founds out during researching that when the pulse width of the signal output by the first terminal Out1 is large, or when the first terminal Out1 performs multi-pulse output, by adopting such a structure, in the second display mode SD, the waveform output by the first terminal Out1 of some shift units 3 may be incomplete.

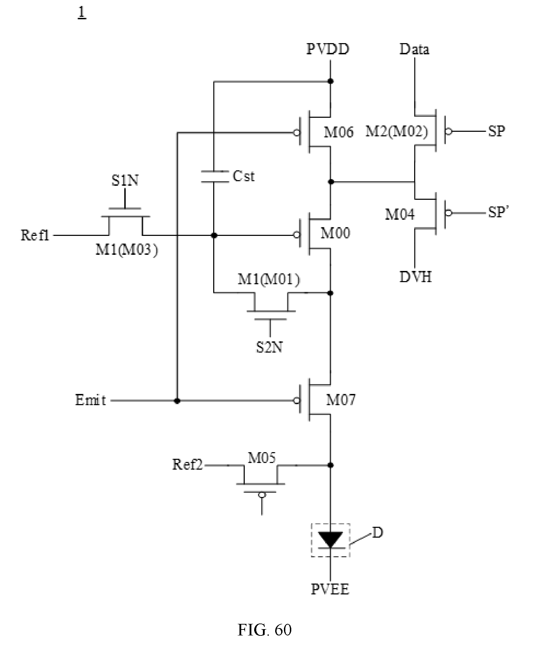

Taking the multi-pulse output of the first terminal Out1 as an example, as shown in FIG. 60, which is another structural schematic diagram of a pixel circuit 1 according to an embodiment of the present disclosure, the pixel circuit 1 further includes a bias transistor M04. The bias transistor M04 has a gate electrically connected to the fourth scan line SP', a first electrode electrically connected to a bias signal line DVH, and a second electrode electrically connected to the first electrode of the driving transistor M00.

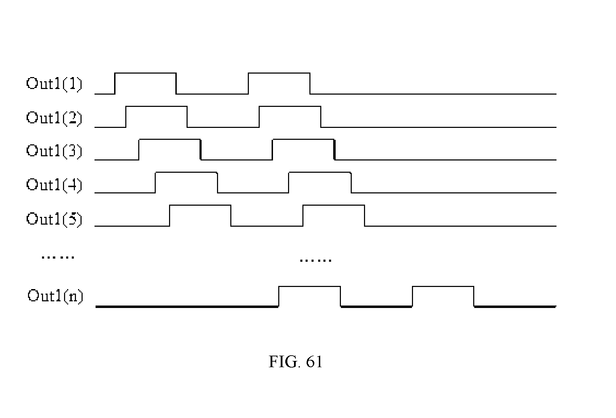

When the first terminal Out1 of the shift unit 3 is configured to provide a signal to the gate of the threshold compensation transistor M01, in one driving manner, as shown in FIG. 61, which is a timing diagram of a signal output by the first terminal Out1 of a shift unit 3 according to an embodiment of the present disclosure, the first terminal Out1 may perform dual-pulse output. When the first terminal Out1 outputs a first high level, the threshold compensation transistor M01 is turned on, writing a bias voltage into the driving transistor M00 to adjust a bias state of the driving transistor M00. When the first terminal Out1 outputs a second high level, the threshold compensation transistor M01 is turned on, writing a data voltage into the driving transistor M00 to charge the gate of the driving transistor M00.

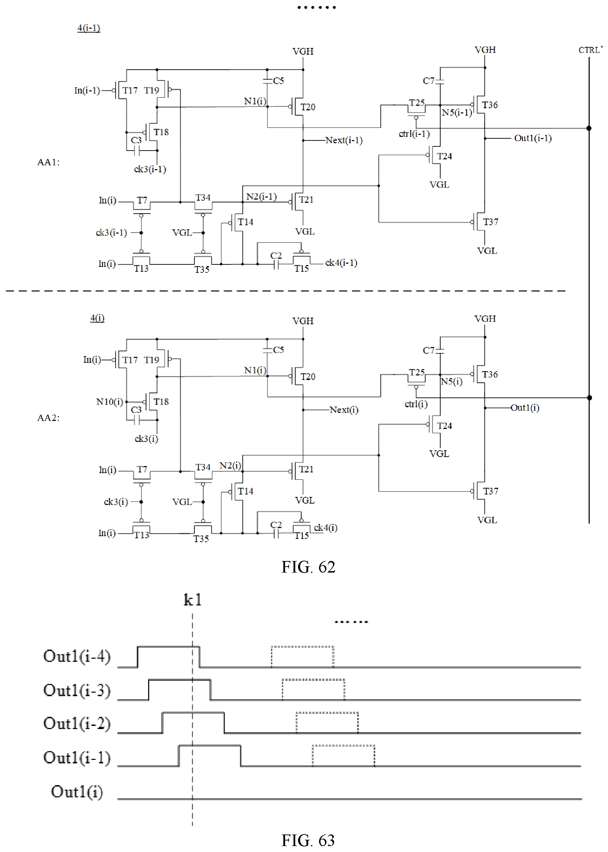

When the region-wise control terminals ctrl of the plurality of shift units 3 are electrically connected to one control line CTRL', as shown in FIG. 62, which is another schematic diagram of a connection between a shift register 2 and a control line according to an embodiment of the present disclosure, for adjacent first region AA1 and second region AA2, it is assumed that the (i-1)-th-stage shift unit 3(i-1) is the last-stage shift unit 3 corresponding to the first region AA1, and the i-th-stage shift unit 3(i) is the first-stage shift unit 3 corresponding to the second region AA2.

The time when the control line CTRL' jumps to a high level determines the time when the first terminal Out1(i) of the i-th-stage shift unit 3(i) stops outputting a high level.

As shown in FIG. 63, which is a timing diagram corresponding to FIG. 62, if the control line CTRL' jumps to a high level at time k1, although it can be ensured that the i-th-stage shift unit 3(i) stops outputting a high level, the twenty-fifth switching transistors T25 in the last several shift units 3 in the first region AA1 are turned off at time k1. As a result, the first terminals Out1(i-1) of these shift units 3 cannot output the second high level, thereby affecting the display of the last several rows of the first region AA1.

In this regard, the embodiments of the present disclosure further propose that the region-wise control terminals ctrl of the plurality of shift units 3 may be electrically connected to two control lines.

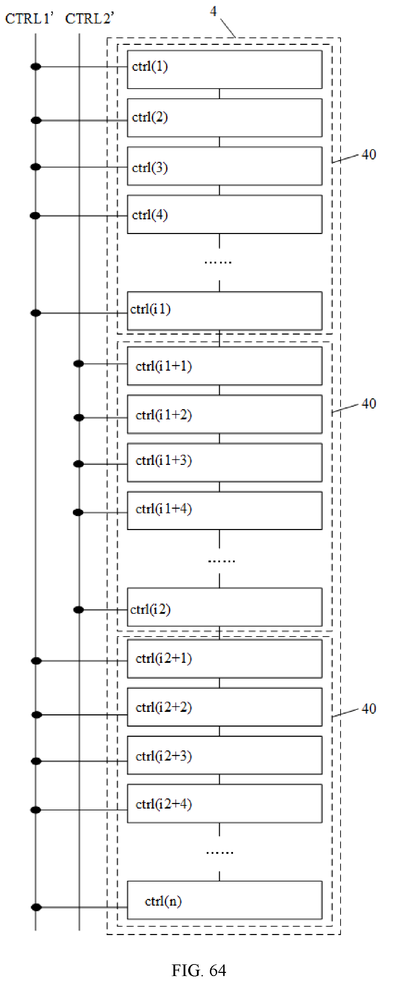

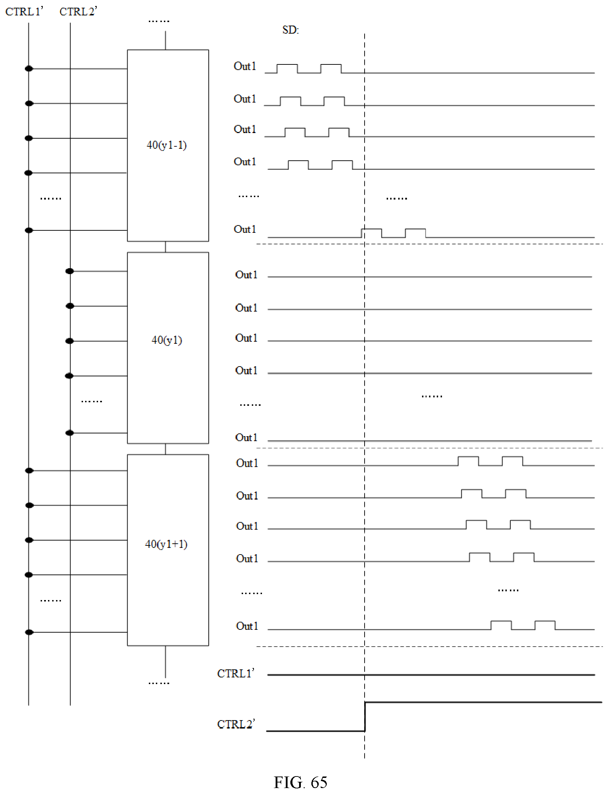

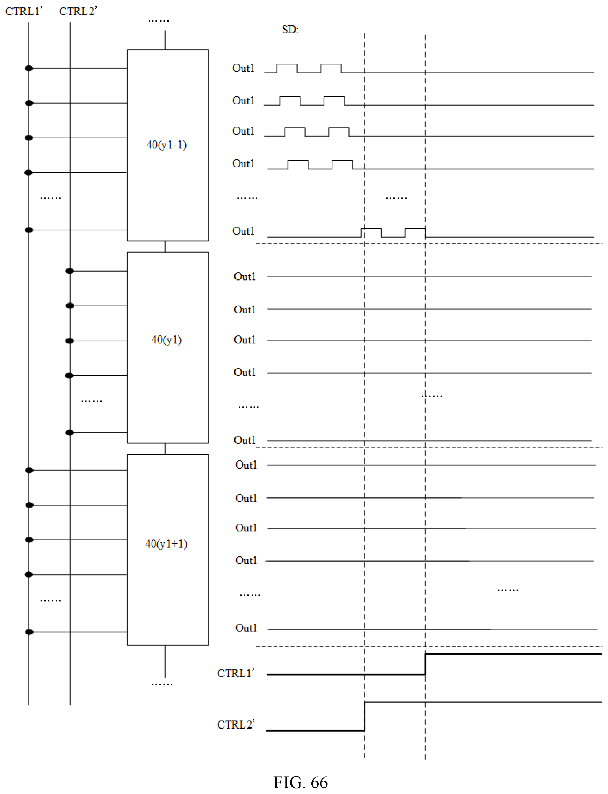

As shown in FIG. 64 to FIG. 66, where FIG. 64 is another schematic diagram of a connection between a shift register 2 and a control line according to an embodiment of the present disclosure, FIG. 65 is a timing diagram corresponding to FIG. 64, and FIG. 66 is another timing diagram corresponding to FIG. 64, the shift register 2 includes at least two unit groups 40 that are cascaded, and each unit group 40 includes a plurality of shift units 3 that are cascaded.

In two consecutive unit groups 40, the region-wise control terminals ctrl of the shift units 3 in one unit group 40 are electrically connected to the first control line CTRL1', and the region-wise control terminals ctrl of the shift units 3 in the other unit group 40 are electrically connected to the second control line CTRL2'.

In one structure, the region and the unit group are in a one-to-one correspondence. In the second display mode SD, referring to FIG. 65, it is assumed that the low-frequency region corresponds to the y1-th unit group 40(y1), and the y1-th unit group 40(y1) is connected to the second control line CTRL2'. When proceeding to the low-frequency region, the second control line CTRL2' is controlled to jump to a high level, and the first control line CTRL1' is controlled to continue outputting a low level, thereby ensuring that the first terminals Out1 of the y1-th unit group 40(y1) stop outputting high levels, and avoiding affecting the signal waveform output by the first terminals Out1 of the (y1-1)-th unit group 40(y1-1).

Alternatively, in another structure, one region corresponds to at least two unit groups. In the second display mode SD, referring to FIG. 66, it is assumed that the low-frequency region corresponds to the y1-th unit group 40(y1) and the (y1+1)-th unit group 40(y1+1), the y1-th unit group 40 (y1) is connected to the second control line CTRL2', and the (y1+1)-th unit group 40(y1+1) is connected to the first control line CTRL1'. When proceeding to the low-frequency region, the second control line CTRL2' is first controlled to jump to a high level, and the first control line CTRL1' is controlled to continue outputting a low level until the first terminal Out1 of the last shift unit 3 of the (y1+1)-th unit group 40 outputs a complete waveform, at which point the first control line CTRL1' is controlled to jump to a high level. In this way, it is ensured that the first terminals Out1 of the y1-th unit group 40(y1) and the (y1+1)-th unit group 40(y1+1) stop outputting high levels, while avoiding affecting the signal waveform output by the first terminals Out1 of the (y1-1)-th unit group 40(y1-1).

Such structure may enable the first terminal Out1 of the shift unit 3 corresponding to each region to output a complete waveform, which is more suitable for a driving manner in which the pulse width of the signal output by the first terminal Out1 is relatively large or in which the first terminal Out1 performs multi-pulse output.

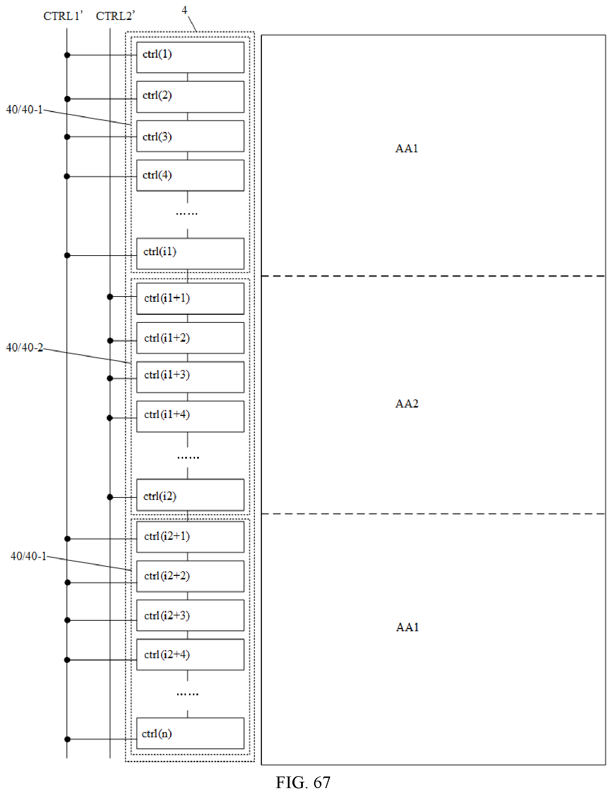

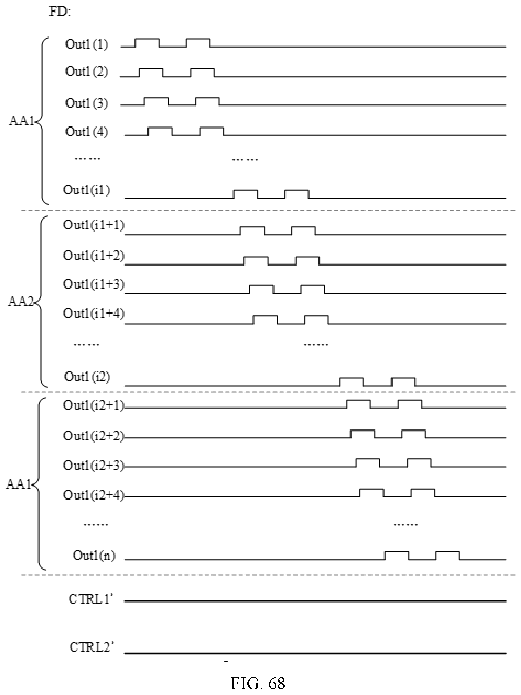

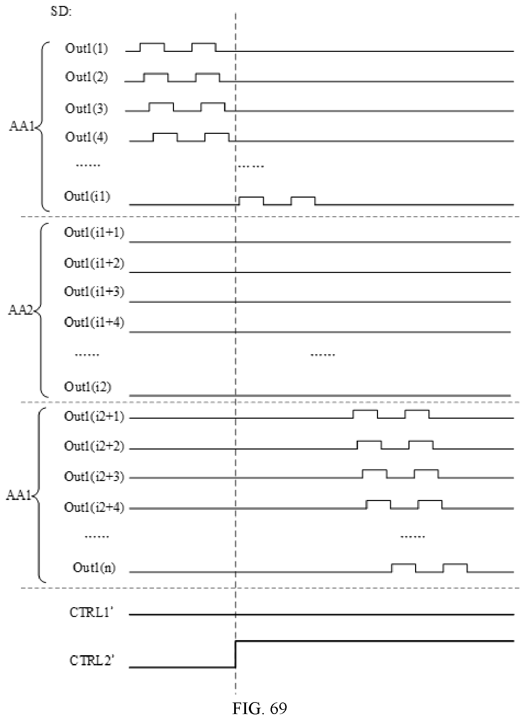

Based on the above connection between the unit groups 40 and the control lines, in a feasible structure, as shown in FIG. 67 to FIG. 69, where FIG. 67 is another schematic diagram of a connection between a shift register 2 and a control line according to an embodiment of the present disclosure, FIG. 68 is a timing diagram corresponding to FIG. 67, and FIG. 69 is another timing diagram corresponding to FIG. 67, the display panel includes a first region AA1 and a second region AA2. The unit groups 40 include a first unit group 40-1 and a second unit group 40-2.

The first region AA1 corresponds to the first unit group 40-1, and the second region AA2 corresponds to the second unit group 40-2. The first unit group 40-1 is electrically connected to the first control line CTRL1', and the second unit group 40-2 is electrically connected to the second control line CTRL2'.

In the first display mode FD, the first control line CTRL1' and the second control line CTRL2' both provide a low level, and the first terminals Out1 of the shift units 3 in the first unit group 40-1 and the second unit group 40-2 sequentially output high levels.

In the second display mode SD, the first control line CTRL1' provides a low level, and the second control line CTRL2' provides a high level. Alternatively, when proceeding to the second region AA2, the second control line CTRL2' jumps to a high level, so that the first terminals Out1 of the first unit group 40-1 sequentially output high levels, and the first terminals Out1 of the second unit group 40-2 do not output a high level.

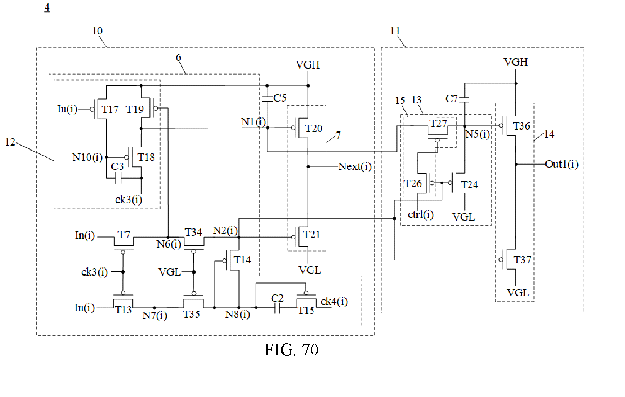

Regarding the second control unit 15, in another feasible implementation, as shown in FIG. 70, which is another structural schematic diagram of a first circuit 4 according to an embodiment of the present disclosure, the second control unit 15 may further include a twenty-sixth switching transistor T26 and a twenty-seventh switching transistor T27.

The twenty-sixth switching transistor T26 has a gate electrically connected to the shift control sub-circuit 10, and a first electrode electrically connected to the region-wise control terminal ctrl. In at least a subset of time periods, the level state of the signal at the gate of the twenty-sixth switching transistor T26 is consistent with that of the signal at the second node N2. The twenty-seventh switching transistor T27 has a gate electrically connected to the second electrode of the twenty-sixth switching transistor T26, a first electrode electrically connected to the first node N1, and a second electrode electrically connected to the fifth node N5.

Based on such structure, the shift output terminals Next of the plurality of shift units 3 are connected to only one control line CTRL', which can also ensure that the first terminals Out1 of all shift units 3 output a waveform normally.

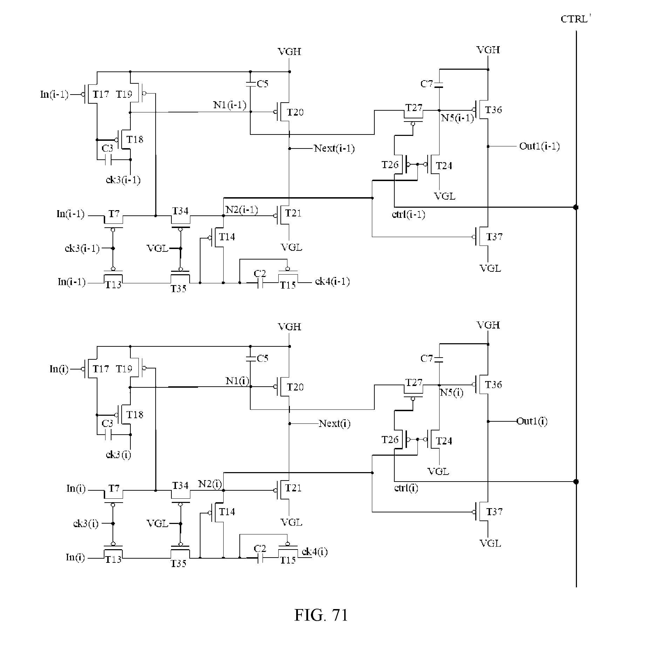

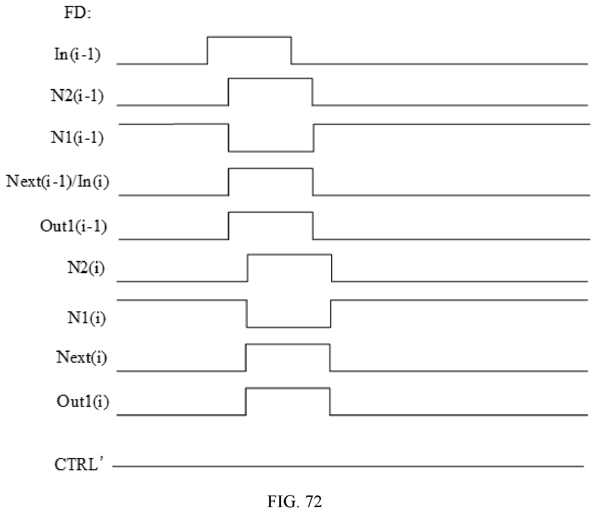

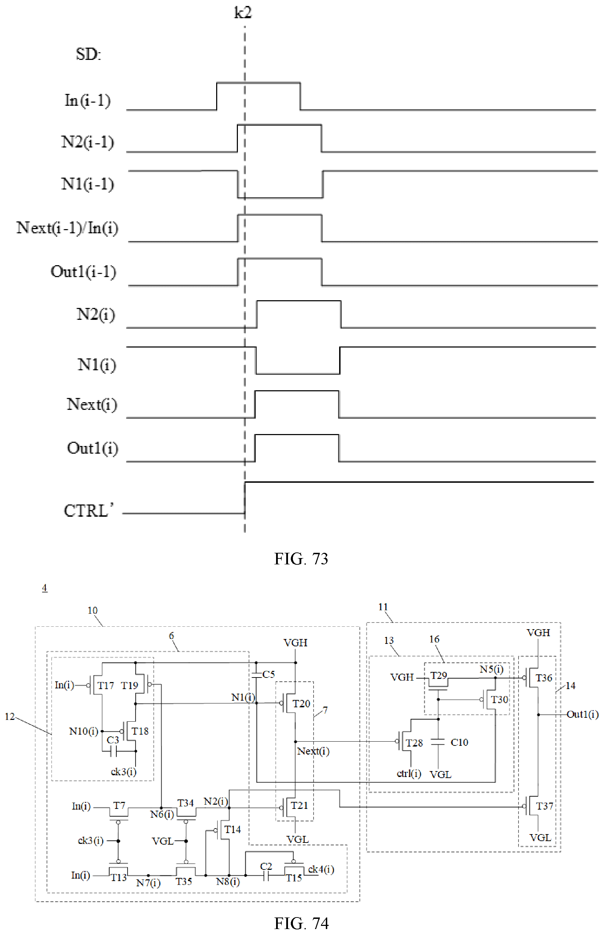

In an example, as shown in FIG. 71 to FIG. 73, where FIG. 71 is another schematic connection diagram of a shift register 2 and a control line according to an embodiment of the present disclosure, FIG. 72 is a timing diagram corresponding to FIG. 71, and FIG. 73 is another timing diagram corresponding to FIG. 71, in the first display mode FD, the control line CTRL' provides a low level. When the second node N2 is at a low level, the twenty-sixth switching transistor T26 is turned on to set the gate potential of the twenty-seventh switching transistor T27 to a low level, and the twenty-seventh switching transistor T27 is turned on, so that the potential of the fifth node N5 is consistent with the potential of the first node N1. When the second node N2 jumps to a high level, the twenty-sixth switching transistor T26 is turned off, the twenty-seventh switching transistor T27 remains turned on, and the potential of the fifth node N5 remains consistent with the potential of the first node N1. In this way, the gate signals of the thirty-sixth switching transistor T36 and the twentieth switching transistor T20 can be consistent with each other, and the gate signals of the thirty-seventh switching transistor T37 and the twenty-first switching transistor T21 can be consistent with each other, so that the level states of the signals output by the shift output terminal Next and the first terminal Out1 are consistent with each other.

In the second display mode SD, it is assumed that the (i-1)-th-stage shift unit 3 is the last-stage shift unit 3 corresponding to the first region AA1, and the i-th-stage shift unit 3(i) is the first-stage shift unit 3 corresponding to the second region AA2. Referring to FIG. 72, the control line CTRL' may jump to a high level at time k2. At time t2, the second node N2 in the i-th-stage shift unit 3 is at a high level, and the second node N2 in the i-th-stage shift unit 3(i) is at a low level. At this time, since the second node N2 in the i-th-stage shift unit 3(i) is at a low level, the high level provided by the control line CTRL' are written into the gate of the twenty-seventh switching transistor T27, so that the twenty-seventh switching transistor T27 is turned off. When the first node N1 is at a low level subsequently, the low level cannot be written into the fifth node N5, so that the first terminal Out1(i) cannot output the high level. At the same time, since the second node N2 in the (i-1)-th-stage shift unit 3 is at a high level, the high level will not be written into the twenty-seventh switching transistor T27 in the (i-1)-th-stage shift unit 3 even if the signal provided by the control line CTRL' jumps to a high level, and the twenty-seventh switching transistor T27 remains in a turned-on state, so that the potential of the fifth node N5 and the potential of the first node N1 remain consistent with each other subsequently, which will not affect the normal output of the first terminal Out1 of the (i-1)-th-stage shift unit 3.

From the above, such structure can enable, using only one control line, the first terminals Out1 of the shift units 3 corresponding to each region to output a complete waveform, which is more suitable for the driving manner in which the pulse width of the signal output by the first terminal Out1 is relatively large or in which the first terminal Out1 performs multi-pulse output, with a smaller number of signal lines.

In a feasible implementation, referring to FIG. 70, the gate of the twenty-sixth switching transistor T26 is electrically connected to the second node N2.

Alternatively, the gate of the twenty-sixth switching transistor T26 may be electrically connected to the shift output terminal Next.

Alternatively, in another optional implementation, the gate of the twenty-sixth switching transistor T26 may be electrically connected to the sixth node N6, the seventh node N7, or the eighth node N8.

Based on the structure of the shift control sub-circuit 10, the level states of the signals of the second node N2, the shift output terminal Next, the sixth node N6, the eighth node N8 and the seventh node N7 are basically consistent with each other. Therefore, whether the gate of the twenty-sixth output terminal T26 is configured to be electrically connected to the second node N2, the shift output terminal Next, the sixth node N6, the eighth node N8 or the seventh node N7, the normal operation of the region-wise control sub-circuit 11 can be ensured.

In a feasible implementation, referring to FIG. 70, the gate of the twenty-fourth switching transistor T24 is electrically connected to the second node N2.

Alternatively, in another optional implementation, the gate of the twenty-sixth switching transistor T26 may be electrically connected to the sixth node N6, the seventh node N7, or the eighth node N8.

Based on the structure of the shift control sub-circuit 10, the level states of the signals of the second node N2, the sixth node N6, the eighth node N8 and the seventh node N7 are basically consistent with each other. Therefore, whether the gate of the twenty-fourth switching transistor T24 is configured to be electrically connected to the second node N2, the sixth node N6, the eighth node N8 or the seventh node N7, the normal operation of the region-wise control sub-circuit 11 can be ensured.

In addition, compared with the shift output terminal Next, the second node N2, the sixth node N6, the eighth node N8 and the seventh node N7 are internal nodes of the circuit, and the signal stability thereof is relatively higher. Since the twenty-fourth switching transistor T24 directly affects the potential of the fifth node N5, the twenty-fourth switching transistor T24 is configured to be connected to one of the above nodes, so that the device stability thereof is better.

In some embodiments of the present disclosure, the gate of the twenty-sixth switching transistor T26 may be electrically connected to one of the second node N2, the shift output terminal Next, the sixth node N6, the seventh node N7 and the eighth node N8, and the gate of the twenty-fourth switching transistor T24 may be electrically connected to one of the second node N2, the sixth node N6, the seventh node N7 and the eighth node N8. The gate of the twenty-sixth switching transistor T26 and the gate of the twenty-fourth switching transistor T24 may be connected to the same node or different nodes.

In addition, referring to FIG. 70, the region-wise control sub-circuit 11 may further include a seventh capacitor C7. The seventh capacitor C7 has a first plate electrically connected to the first electrode of the thirty-sixth switching transistor T36, and a second plate electrically connected to the fifth node N5.

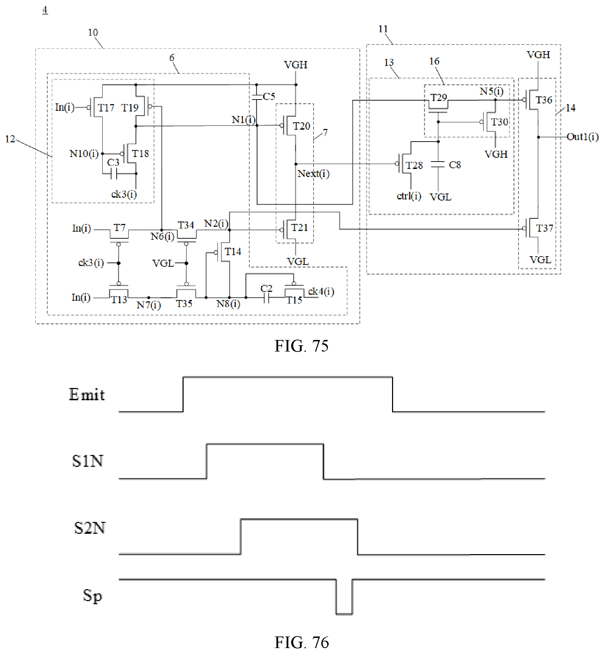

Regarding the region-wise control sub-circuit 11, in another feasible implementation, as shown in FIG. 74 and FIG. 75, where FIG. 74 is another structural schematic diagram of a first circuit 4 according to an embodiment of the present disclosure, and FIG. 75 is another structural schematic diagram of a first circuit 4 according to an embodiment of the present disclosure, the region-wise control sub-circuit 11 includes a third driving module 13 and a third output module 14.

The third output module 14 outputs a level for controlling the first transistor M1 to be turned on to the first terminal Out1 in response to the first level of the fifth node N5, and outputs a level for controlling the first transistor M1 to be turned off to the first terminal Out1 in response to the voltage of the second node N2. The first level may be a low level.

The first driving module 6 includes a twenty-eighth switching transistor T28 and a third control unit 16. The twenty-eighth switching transistor T28 has a gate electrically connected to the shift control sub-circuit 10, and a first electrode electrically connected to the region-wise control terminal ctrl. In at least a subset of time periods, the level state of the signal at the gate of the twenty-eighth switching transistor T28 is consistent with that of the signal at the second node N2. A control terminal of the third control unit 16 is electrically connected to the second electrode of the twenty-eighth switching transistor T28. The third control unit 16, when being turned on, provides a second level to the fifth node N5, and the second level may be a high level.

Based on the above structure, both the thirty-seventh switching transistor T37 and the twenty-first switching transistor T21 are configured to output a low level, and operate in response to the same potential level at the node, so that operating states of the two switching transistors are consistent with each other, both being turned on synchronously and turned off synchronously, thereby enabling the shift output terminal Next and the first terminal Out1 to synchronously output a low level.

The thirty-sixth switching transistor T36 operates in response to the voltage of the fifth node N5. The signal of the fifth node N5 is independently controlled by the third control unit 16. The third control unit 16 can provide a corresponding signal to the fifth node N5 according to whether the display panel needs to perform frequency-per-region driving, thereby controlling whether the first terminal Out1 can output a high level.

Further, referring to FIG. 74 and FIG. 75, the second control unit 15 includes a twenty-ninth switching transistor T29 and a thirtieth switching transistor T30. The twenty-ninth switching transistor T29 is an N-type transistor, and the thirtieth switching transistor T30 is a P-type transistor.

A gate of the twenty-ninth switching transistor T29 and a gate of the thirtieth switching transistor T30 are both electrically connected to the second electrode of the twenty-eighth switching transistor T28, and a second electrode of the twenty-ninth switching transistor T29 and a second electrode of the thirtieth switching transistor T30 are both electrically connected to the fifth node N5.

Referring to FIG. 75, a first electrode of the twenty-ninth switching transistor T29 is electrically connected to the first node N1, and a first electrode of the thirtieth switching transistor T30 is electrically connected to the first power terminal VGH.

In the first display mode FD, the region-wise control terminal ctrl provides a high level. The twenty-ninth switching transistor T29 keeps continuously turned on, and the potentials of the fifth node N5 and the first node N1 keeps consistent with each other. In the second display mode SD, in a subset of frames, when proceeding to the second region AA2, the signal provided by the region-wise control terminal ctrl jumps to a low level, the twenty-ninth switching transistor T29 is turned off, the thirtieth switching transistor T30 is turned on, and the fifth node N5 is set to a high level.

Alternatively, referring to FIG. 74, a first electrode of the twenty-ninth switching transistor T29 is electrically connected to the first power terminal VGH, and a first electrode of the thirtieth switching transistor T30 is electrically connected to the first node N1.

In the first display mode FD, the region-wise control terminal ctrl provides a low level. The thirtieth switching transistor T30 keeps turned on, and the potentials of the fifth node N5 and the first node N1 keep consistent with each other. In the second display mode SD, in a subset of frames, when proceeding to the second region AA2, the signal provided by the region-wise control terminal ctrl jumps to a high level, the thirtieth switching transistor T30 is turned off, the twenty-ninth switching transistor T29 is turned on, and the fifth node N5 is set to a high level.

By arranging the N-type twenty-ninth switching transistor T29 in the region-wise control sub-circuit 11, the signal of the fifth node N5 can be controlled merely using the twenty-ninth switching transistor T29 and the thirtieth switching transistor T30, so that the signal of the fifth node N5 varies according to the display mode. The region-wise control sub-circuit 11 of this type has a simple structure and a small number of transistors.

In a feasible implementation, referring to FIG. 75, the gate of the twenty-eighth switching transistor T28 is electrically connected to the shift output terminal Next.

Alternatively, the gate of the twenty-eighth switching transistor T28 is electrically connected to the second node N2.

Based on the structure of the shift control sub-circuit 10, the level states of the signals of the shift output terminal Next and the second node N2 are basically consistent with each other. Therefore, whether the gate of the twenty-eighth switching transistor T28 is electrically connected to the shift output terminal Next or the second node N2, the normal operation of the region-wise control sub-circuit 11 can be ensured.

In addition, referring to FIG. 75, the third driving module 13 may further include an eighth capacitor C8, and the eighth capacitor C8 is electrically connected between the second power terminal VGL and the gate of the twenty-ninth switching transistor T30.

In the shift unit 3, the switching transistors in the first output module 7, the second output module 9 and the third output module 14 are connected to the first power terminal VGH and/or the second power terminal VGL. The switching transistors in the first driving module 6, the second driving module 8 and the third driving module 13 are also connected to the first power terminal VGH and/or the second power terminal VGL.

In a feasible implementation, the first power terminal VGH corresponding to the output module is connected to the first power line, and the second power terminal VGL corresponding to the output module is connected to the second power line. The first power terminal VGH corresponding to the driving module is connected to the third power line, and the second power terminal VGL corresponding to the output module is connected to the fourth power line.

The line width of the first power line is greater than the line width of the third power line, and the line width of the second power line is greater than the line width of the fourth power line, thereby reducing the signal voltage drop at the power terminal corresponding to the output module and improving the accuracy of the voltage output by the output module.

In a feasible implementation, with reference to FIG. 12 and FIG. 76, where FIG. 76 is a timing diagram corresponding to FIG. 12, the pixel circuit 1 further includes a driving transistor M00.

The first transistor M1 includes a gate reset transistor M03 and a threshold compensation transistor M01, and the gate reset transistor M03 and the threshold compensation transistor M01 are N-type transistors. The gate reset transistor M03 has a gate electrically connected to the first scan line SIN, a first electrode electrically connected to the first reset line Ref1, and a second electrode electrically connected to the gate of the driving transistor M00. The threshold compensation transistor M01 has a gate electrically connected to the second scan line S2N, a first electrode electrically connected to the second electrode of the driving transistor M00, and a second electrode electrically connected to the gate of the driving transistor M00.

The second transistor M2 includes a data writing transistor M02, and the data writing transistor M02 is a P-type transistor. The data writing transistor M02 has a gate electrically connected to the third scan line SP, a first electrode electrically connected to the data line, and a second electrode electrically connected to the first electrode of the driving transistor M00.

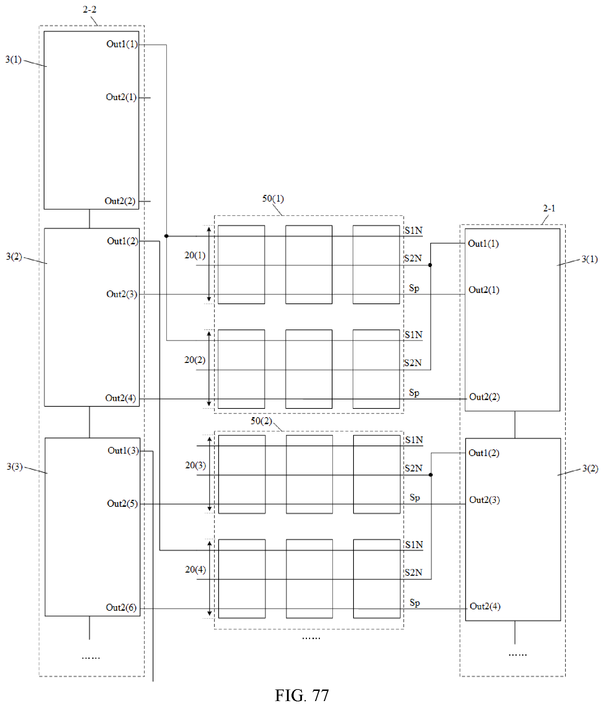

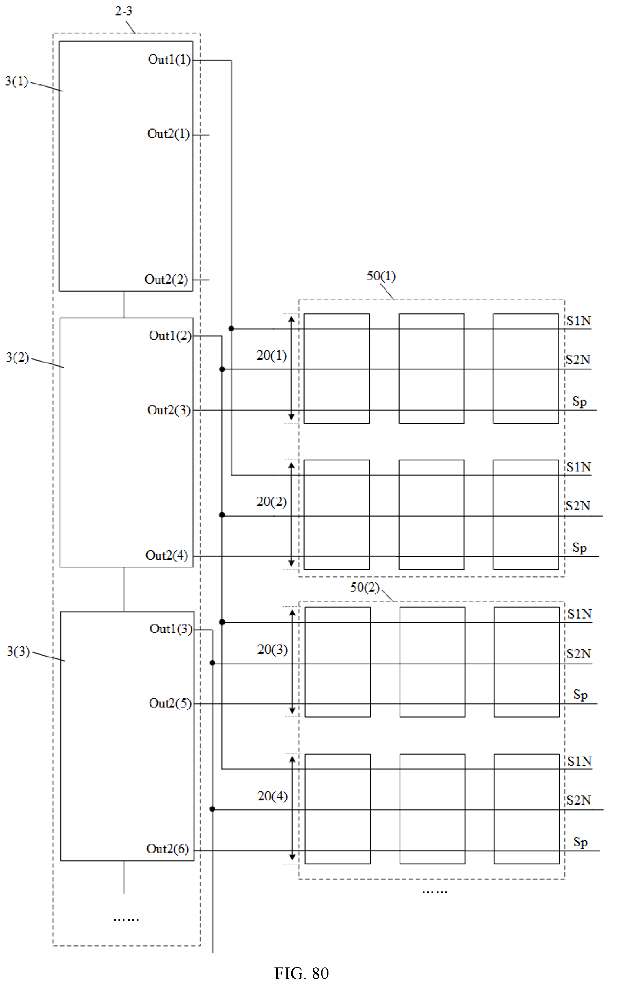

With reference to FIG. 77 and FIG. 80, the first terminals Outl of at least a subset of the shift units 3 are electrically connected to the first scan line S1N and/or the second scan line S2N, and the second terminals Out2 of at least a subset of the shift units 3 are electrically connected to the third scan line SP.

In such structure, the first terminal Outl of the shift unit 3 outputs a first scan signal s1n and/or a second scan signal s2n with an active level being a high level, for driving the gate reset transistor M03 and/or the threshold compensation transistor M01 in the pixel circuit 1. The second terminal Out2 of the shift unit 3 outputs a third scan signal sp with an active level being a low level, for driving the data writing transistor M02 in the pixel circuit 1.

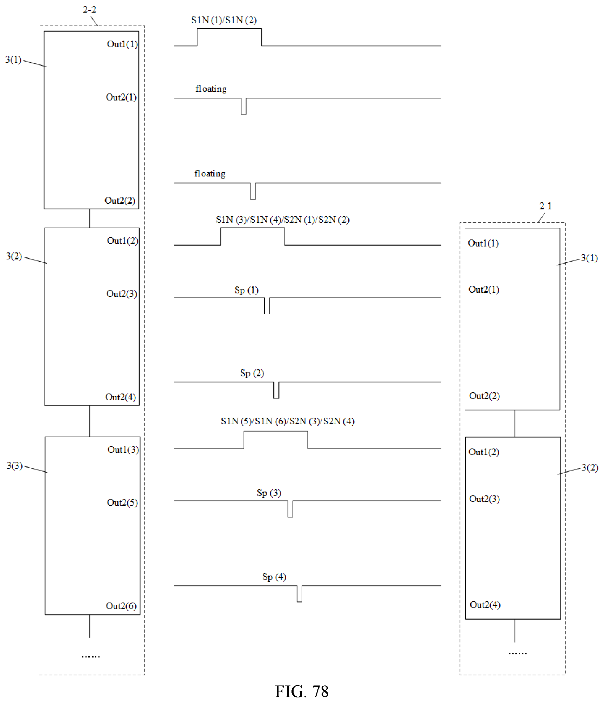

In a feasible implementation, as shown in FIG. 77 and FIG. 78, where FIG. 77 is another structural schematic diagram of a display panel according to an embodiment of the present disclosure, and FIG. 78 is a timing diagram corresponding to FIG. 77, the shift register 2 includes a first shift register 2-1 and a second shift register 2-2.

The first terminal Out1 of the shift unit 3 in the first shift register 2-1 is electrically connected to the second scan line S2N, and the second terminal Out2 of the shift unit 3 in the first shift register 2-1 is electrically connected to the third scan line SP.

The shift register 2 further includes a second shift register 2-2. The first terminal Outl of the shift unit 3 in the second shift register 2-2 is electrically connected to the first scan line SIN, and a second terminal Out2 of a subset of the shift units 3 in the second shift register 2-2 is electrically connected to the third scan line SP.

The shift unit 3 includes m second terminals Out2, and m≥2.

The pixel circuit 1 includes a plurality of circuit groups 50 arranged along a first direction. The circuit group 50 includes m circuit rows 20 arranged along the first direction, and the circuit row 20 includes a plurality of pixel circuits 1 arranged along a second direction. The first direction intersects with the second direction.

For ease of understanding, in the drawings of the embodiments of the present disclosure, the i-th circuit group is marked with reference sign 50(i), and the i-th circuit row is marked with reference sign 20(i).

In the first shift register 2-1, the m second terminals Out2 of the a1-th-stage shift unit 3 are respectively electrically connected to the third scan lines SP corresponding to the m circuit rows 20 in the a1-th circuit group 50, and the first terminal Outl of the a1-th-stage shift unit 3 is electrically connected to the second scan line S2N corresponding to the al-th circuit group 50, where a1≥1.

In the second shift register 2-2, the m second terminals Out2 of the a2-th-stage shift unit 3 are respectively electrically connected to the third scan lines SP corresponding to the m circuit rows 20 in the al-th circuit group 50, and the first terminal Out1 of the a2-th-stage shift unit 3 is electrically connected to the first scan line SIN corresponding to the a3-th circuit group 50, where a2>a1, and a3>al.

The embodiments of the present disclosure are described by taking a2=a1+1 and a3=a1+1 as an example. It may be understood that, according to different timing designs, the difference between a2 and a1 and the difference between a3 and a1 may also be other values.

For ease of understanding, the following explanation is given by taking a1=1 and a2=2 for example.

In such structure, for the first circuit group 50(1), the corresponding third scan signal sp is provided by the first-stage shift unit 3(1) in the second shift register 2-2 and the second-stage shift unit 3(2) in the first shift register 2-1. This means that the first-stage shift unit 3(1) in the second shift register 2-2 and the second-stage shift unit 3(2) in the first shift register 2-1 output pulses synchronously, which further means that the first-stage shift unit 3(1) in the first shift register 2-1 outputs pulses earlier than the first-stage shift unit 3(1) in the second shift register 2-2.

The first-stage shift unit 3(1) in the first shift register 2-1 provides the first scan signal s1n required by the first circuit group 50(1), and the first-stage shift unit 3(1) in the second shift register 2-2 provides the second scan signal s2n for the first circuit group 50(1), so that the pulse of the second scan signal s2n corresponding to the first circuit group 50(1) is later than the pulse of the first scan signal s1n corresponding to the first circuit group 50(1), and the first scan signal s1n, the second scan signal s2n and the third scan signal sp that correspond to the first circuit group 50(1) have correct timings.

Based on the connection relationship between the first shift register 2-1, the second shift register 2-2, and the scan lines that corresponds to the circuit row 20, while ensuring the normal output timing of the first scan signal s1n, the second scan signal s2n and the third scan signal sp in the pixel circuits 1 of each row, the first shift register 2-1 and the second shift register 2-2 also perform double-sided driving on the third scan line SP, thereby improving the charging effect of the pixel circuits 1 of each row.

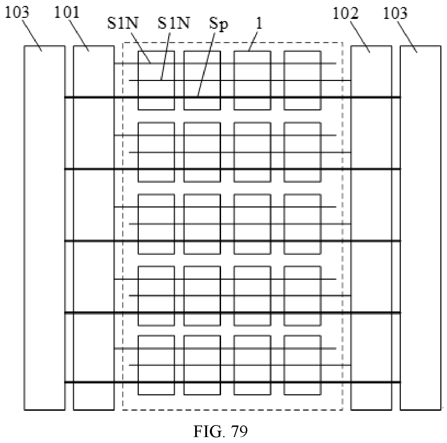

In addition, in the related art, when the signals of the first scan line S1N and the second scan line S2N are provided by different shift registers, when the third scan line SP is subject to double-sided driving, two groups of shift registers are generally respectively arranged on both sides of the display area. That is, as shown in FIG. 79, which is a structural schematic diagram of a display panel in the related art, the display panel includes a shift register 101, a shift register 102, and two shift registers 103. The shift register 101 is configured to provide a signal to the first scan line S1N, the shift register 102 is configured to provide a signal to the second scan line S2N, and the shift registers 103 are configured to provide a signal to the third scan line SP. The shift register 101 and one shift register 103 are located on one side of the display area, and the shift register 102 and the other shift register 103 are located on the other side of the display area.

In the embodiments of the present disclosure, the shift register 101 and one shift register 103 may be merged into the shift register 2-2, and the shift register 102 and the other shift register 103 may be merged into the shift register 2-1, so that only one shift register is provided on each side of the display area, thereby reducing the number of shift registers and greatly narrowing the bezel space occupied by the shift registers.

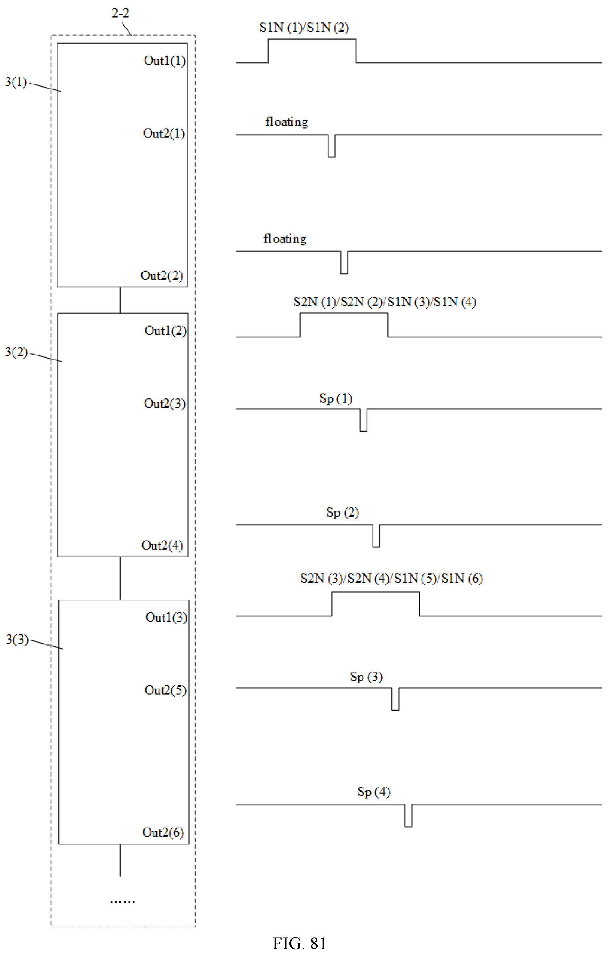

Alternatively, in another feasible implementation, as shown in FIG. 80 and FIG. 81, where FIG. 80 is another structural schematic diagram of a display panel according to an embodiment of the present disclosure, and FIG. 81 is a timing diagram corresponding to FIG. 80, the shift register 2 includes a third shift register 2-3. A first terminal Out1 of the shift unit 3 in the third shift register 2-3 is electrically connected to the first scan line SIN and the second scan line S2N, and second terminals Out2 of a subset of shift units 3 in the third shift register 2-3 are electrically connected to the third scan line SP and the second scan line S2N.

The shift unit 3 includes m second terminals Out2, and m≥2.

The pixel circuit 1 includes a plurality of circuit groups 50 arranged along a first direction. The circuit group 50 includes m circuit rows 20 arranged along the first direction, and the circuit row 20 includes a plurality of pixel circuits 1 arranged along a second direction. The first direction intersects with the second direction.

For the b-th circuit group 50, the third scan lines SP corresponding to the m circuit rows 20 of the b-th circuit group 50 are respectively electrically connected to the m second terminals Out2 of the c1-th-stage shift unit 3 in the third shift register 2-3. The second scan lines S2N corresponding to the b-th circuit group 50 are electrically connected to the first terminal Out1 of the c1-th-stage shift unit 3 in the third shift register 2-3. The first scan lines S1N corresponding to the b-th circuit group 50 is electrically connected to the first terminal Out1 of the c2-th-stage shift unit 3 in the third shift register 2-3, where b≥1, c1>b, and c2<c1.

The embodiments of the present disclosure are described by taking c1=b+1 and c2=b as an example. It may be understood that, according to different timing designs, the difference between c1 and b and the difference between c2 and c1 may be other values.

For ease of understanding, the following explanation is given by taking b=1, c1=2, and c2=1 for example.

In such structure, for the first circuit group 50(1), the third scan signal sp corresponding to the first circuit group 50(1) is provided by the second terminal Out2 of the second-stage shift unit 3(2) of the third shift register 2-3. The second scan signal s2n corresponding to the first circuit group 50(1) is provided by the first terminal Out1 of the second-stage shift unit 3(2) of the third shift register 2-3. The first scan signal s1n corresponding to the first circuit group 50(1) is provided by the first terminal Out1 of the first-stage shift unit 3(1) of the third shift register 2-3. Since the first-stage shift unit 3(1) outputs a pulse earlier than the second-stage shift unit 3(2), the pulse of the first scan signal s1n of the first circuit group 50(1) is earlier than the pulse of the second scan signal s2n of the first circuit group 50(1), and the timings of the first scan signal s1n, the second scan signal s2n and the third scan signal sp of the first circuit group 50(1) are thus correct.

The first terminal Out1 of the first-stage shift unit 3(1) of the third shift register 2-3 is only connected to the first scan line S1N of the first circuit group 50(1) but not to the second scan line S2N of the first circuit group 50(1). The second terminal of the first-stage shift unit 3(1) of the third shift register 2-3 is floating and is not connected to the third scan line SP.

In such structure, the first terminal Out1 of the shift unit 3 being electrically connected to the first scan line SIN and the second scan line S2N refers to that the first terminal Out1 is electrically connected to the first scan line SIN and the second scan line S2N that correspond to different circuit groups 50.

Based on the connection relationship between the third shift register 2-3 and the scan lines corresponding to the circuit rows 20, the normal output timings of the first scan signal s1n, the second scan signal s2n, and the third scan signal sp in the pixel circuits 1 of each row can be ensured.

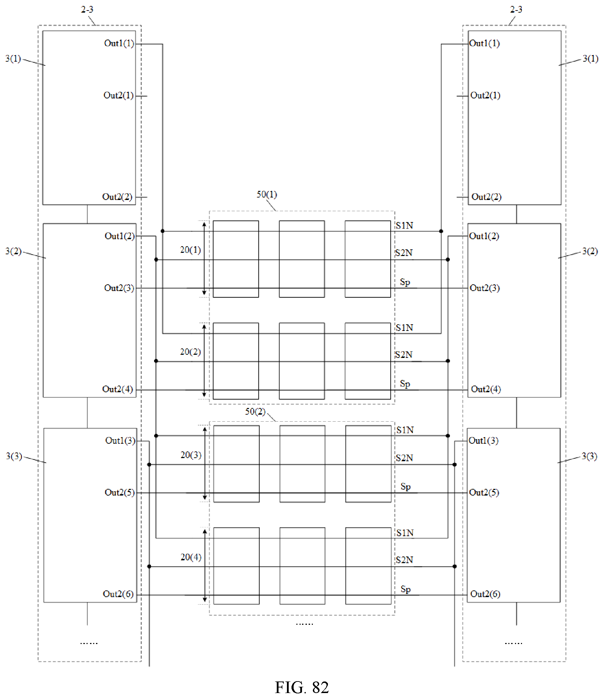

Further, as shown in FIG. 82, which is another structural schematic diagram of a display panel according to an embodiment of the present disclosure, the display panel may include two third shift registers 2-3. The two third shift registers 2-3 are located on opposite sides of the display area, to perform double-sided driving on the first scan line SIN, the second scan line S2N and the third scan line SP, thereby improving signal performance.

In some embodiments of the present disclosure, referring to FIG. 12, the pixel circuit 1 may further include an anode reset transistor M05, a first light-emitting control transistor M06, a second light-emitting control transistor M07 and a storage capacitor Cst.

The anode reset transistor M05 has a gate electrically connected to the third scan line SP, a first electrode electrically connected to the second reset line Ref2, and a second electrode electrically connected to a light-emitting element D.

The first light-emitting control transistor M06 has a gate electrically connected to the light-emitting control signal line Emit, a first electrode electrically connected to the power line PVDD, and a second electrode electrically connected to the first electrode of the driving transistor M00.

The second light-emitting control transistor M07 has a gate electrically connected to the light-emitting control signal line Emit, a first electrode electrically connected to the second electrode of the driving transistor M00, and a second electrode electrically connected to the light-emitting element D driven by the driving transistor M00.

The storage capacitor Cst has a first plate electrically connected to the power line PVDD, and a second plate electrically connected to the gate of the driving transistor M00.

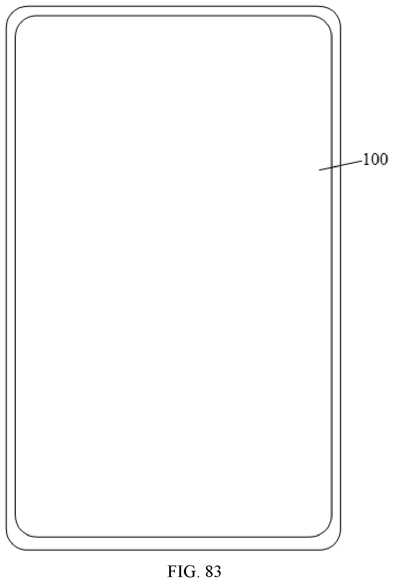

Based on the same inventive idea, an embodiment of the present disclosure further provides a display device. As shown in FIG. 83, which is a structural diagram of a display device according to an embodiment of the present disclosure, the display device includes the above-described display panel 100. It is understood that, the display device shown in FIG. 83 is merely illustrative, and the display device may be any electronic device having a display function, such as a mobile phone, a tablet computer, a notebook computer, an e-book or a television.

The above description merely illustrates some preferred embodiments of the present disclosure and is not intended to limit the present disclosure, and any modification, equivalent substitution, improvement and the like made within a spirit and a principle of the present disclosure shall fall with a scope of the present disclosure.

As above, it should be noted that, the above-described embodiments are merely for illustrating the present disclosure but not intended to provide any limitation. Although the present disclosure has been described in detail with reference to the above-described embodiments, it should be understood by those skilled in the art that, it is still possible to modify the technical solutions described in the above embodiments or to equivalently replace some or all of the technical features therein, but these modifications or replacements do not cause the essence of corresponding technical solutions to depart from the scope of the present disclosure.

## Claims

1. A display panel, comprising:
a pixel circuit comprising a first transistor and a second transistor; and
a shift register comprising a plurality of cascaded shift units, wherein the shift unit comprise a first terminal and at least one second terminal, the first terminal and the second terminal are configured to respectively output signals different from each other, the first terminal is electrically connected to a gate of the first transistor, and the second terminal is electrically connected to a gate of the second transistor.

2. The display panel according to claim 1, wherein the shift unit comprises a first circuit and a second circuit, the first circuit comprises the first terminal, and the second circuit comprises the second terminal,
wherein the first circuit comprises a first driving module and a first output module, wherein the first output module is configured to output a signal in response to voltages of a first node and a second node, and the first driving module is configured to control signals of the first node and the second node; and the second circuit comprises a second driving module and at least one second output module, wherein the second output module is configured to output a voltage of a first power terminal to the second terminal in response to a voltage of a third node, and output a voltage of a first clock terminal to the second terminal in response to a voltage of a fourth node,
wherein the third node is electrically connected to the first circuit, and within at least a subset of time periods, level states of signals of the third node and the second node are consistent; and the second driving module is configured to control a signal of the fourth node.

3. The display panel according to claim 2, wherein the first circuit comprises a shift control sub-circuit and a region-wise control sub-circuit,
wherein the shift control sub-circuit comprises the first driving module and the first output module, the first driving module comprises a shift input terminal, the first output module comprises a shift output terminal, and in two consecutive shift units, the shift output terminal of an upstream shift unit is electrically connected to the shift input terminal of a downstream shift unit; and the region-wise control sub-circuit comprises the first terminal, and the region-wise control sub-circuit is configured to output a signal to the first terminal in response to a region-wise control signal, and
the third node is electrically connected to the shift output terminal.

4. The display panel according to claim 3, wherein the pixel circuit further comprises a driving transistor, and
the first transistor comprises a threshold compensation transistor electrically connected between a second electrode and a gate of the driving transistor, and the first terminal of at least one shift register is electrically connected to a gate of the threshold compensation transistor; or
the first transistor comprises a data writing transistor electrically connected between a data line and a first electrode of the driving transistor, and the first terminal of at least one shift register is electrically connected to a gate of the data writing transistor.

5. The display panel according to claim 2, wherein the second driving module comprises:
a first switching transistor that is an N-type transistor, wherein the first switching transistor has a gate electrically connected to the third node, a first electrode electrically connected to a second power terminal, and a second electrode electrically connected to the fourth node; and
a second switching transistor that is a P-type transistor, wherein the second switching transistor has a gate electrically connected to the third node, a first electrode electrically connected to the first power terminal, and a second electrode electrically connected to the fourth node.

6. The display panel according to claim 5, wherein the second electrode of the first switching transistor is electrically connected to the fourth node through a third switching transistor,
wherein the gate of the first switching transistor in an i-th-stage shift unit is electrically connected to the third node in the i-th-stage shift unit, and a gate of the third switching transistor in the i-th-stage shift unit is electrically connected to the third node in an i0-th-stage shift unit, where i≠i0, and
during a time period in which the first switching transistor and the third switching transistor in the i-th-stage shift unit are simultaneously turned on, the first clock terminal connected to the i-th-stage shift unit provides an active pulse.

7. The display panel according to claim 6, wherein the second driving module further comprises a fourth switching transistor that is an N-type transistor, wherein the fourth switching transistor has a gate electrically connected to the gate of the third switching transistor, a first electrode electrically connected to the first power terminal, and a second electrode electrically connected to the fourth node.

8. The display panel according to claim 2, wherein the second output module is configured to output a voltage of the first power terminal to the second terminal in response to a first level of the third node, and output a voltage of the first clock terminal to the second terminal in response to a first level of the fourth node; and
the second driving module comprises a fifth switching transistor, and the fifth switching transistor has a gate electrically connected to a second clock terminal, and a second electrode electrically connected to the fourth node,
wherein a first electrode of the fifth switching transistor in an i-th-stage shift unit is electrically connected to the second terminal of an (i-1)-th-stage shift unit; and for a same shift unit, during a time period in which the third node is at a second level, the second terminal connected to the fifth switching transistor outputs a first level, and the first level overlaps with a first level provided by the second clock terminal connected to the fifth switching transistor.

9. The display panel according to claim 8, wherein the pixel circuit comprises a plurality of circuit rows arranged along a first direction, the circuit row comprises a plurality of pixel circuits arranged along a second direction, and the first direction intersects with the second direction; and
the second circuit comprises m second output modules, where m≥2, wherein the m second output modules are electrically connected to second transistors in m circuit rows through m second terminals respectively, and the m second output modules are further electrically connected to m first clock terminals respectively,
wherein a first second terminal to a m-th second terminal in an (i-1)-th-stage shift unit are electrically connected to a j-th circuit row to a (j+(m-1))-th circuit row respectively, where j≥1, and the fifth switching transistor in the i-th-stage shift unit is electrically connected to the m-th second terminal in the (i-1)-th-stage shift unit.

10. The display panel according to claim 9, wherein m=2; and
the display panel comprises a first clock line, a second clock line, a third clock line and a fourth clock line,
wherein the second clock terminal corresponding to an odd-stage shift unit is electrically connected to the first clock line, and two first clock terminals corresponding to the odd-stage shift unit are electrically connected to the second clock line and the third clock line respectively; and
the second clock terminal corresponding to an even-stage shift unit is electrically connected to the third clock line, and two first clock terminals corresponding to the even-stage shift unit are electrically connected to the fourth clock line and the first clock line respectively.

11. The display panel according to claim 9, wherein m=2; and
the display panel comprises a first clock line, a second clock line and a third clock line, wherein the second clock terminal corresponding to a (3x-2)-th-stage shift unit is electrically connected to the first clock line, and two first clock terminals corresponding to the (3x-2)-th-stage shift unit are electrically connected to the second clock line and the third clock line respectively, where x is a positive integer;
the second clock terminal corresponding to a (3x-1)-th-stage shift unit is electrically connected to the third clock line, and two first clock terminals corresponding to the (3x-1)-th-stage shift unit are electrically connected to the first clock line and the second clock line respectively; and
the second clock terminal corresponding to a 3x-th-stage shift unit is electrically connected to the second clock line, and two first clock terminals corresponding to the 3x-th-stage shift unit are electrically connected to the third clock line and the first clock line respectively.

12. The display panel according to claim 9, wherein m=2; and
the display panel comprises a first clock line, a second clock line, a third clock line, a fourth clock line and a fifth clock line,
wherein the second clock terminal corresponding to a (5x-4)-th-stage shift unit is electrically connected to the first clock line, and two first clock terminals corresponding to the (5x-4)-th-stage shift unit are electrically connected to the second clock line and the third clock line respectively, where x is a positive integer of 1, 2, 3, ...;
the second clock terminal corresponding to a (5x-3)-th-stage shift unit is electrically connected to the third clock line, and two first clock terminals corresponding to the (5x-3)-th-stage shift unit are electrically connected to the fourth clock line and the fifth clock line respectively;
the second clock terminal corresponding to a (5x-2)-th-stage shift unit is electrically connected to the fifth clock line, and two first clock terminals corresponding to the (5x-2)-th-stage shift unit are electrically connected to the first clock line and the second clock line respectively;
the second clock terminal corresponding to a (5x-1)-th-stage shift unit is electrically connected to the second clock line, and two first clock terminals corresponding to the (5x-1)-th-stage shift unit are electrically connected to the third clock line and the fourth clock line respectively; and
the second clock terminal corresponding to a 5x-th-stage shift unit is electrically connected to the fourth clock line, and two first clock terminals corresponding to the 5x-th-stage shift unit are electrically connected to the fifth clock line and the first clock line respectively.

13. The display panel according to claim 2, wherein the second circuit further comprises a sixth switching transistor, the second driving module is electrically connected to the fourth node through the sixth switching transistor, and a gate of the sixth switching transistor is electrically connected to a second power terminal; or
the second circuit further comprises at least one sixth switching transistor, the at least one sixth switching transistor and the at least one second output module are in a one-to-one correspondence with each other, the sixth switching transistor is electrically connected between the fourth node and a respective second output module, and a gate of the sixth switching transistor is electrically connected to the second power terminal.

14. The display panel according to claim 2, wherein the second circuit comprises m second output modules, where m≥2, the m second output modules are electrically connected to m second terminals respectively and electrically connected to m first clock terminals respectively, and the m first clock terminals are configured to sequentially provide active pulses.

15. The display panel according to claim 2, wherein the first driving module comprises:
a seventh switching transistor, wherein the seventh switching transistor has a gate electrically connected to a third clock terminal, a first electrode electrically connected to a shift input terminal, and a second electrode electrically connected to the second node; and
a first control unit configured to control a signal of the first node.

16. The display panel according to claim 15, wherein the first control unit comprises:
an eighth switching transistor that is an N-type transistor, wherein the eighth switching transistor has a gate electrically connected to the second node, a first electrode electrically connected to a second power terminal, and a second electrode electrically connected to the first node; and
a ninth switching transistor that is a P-type transistor, wherein the ninth switching transistor has a gate electrically connected to the second node, a first electrode electrically connected to the third clock terminal, and a second electrode electrically connected to the first node,
wherein the first output module is configured to output a signal of the third clock terminal in response to a voltage of the first node.

17. The display panel according to claim 15, wherein the first control unit comprises:
an eighth switching transistor that is an N-type transistor, wherein the eighth switching transistor has a gate electrically connected to the second node, a first electrode electrically connected to a second power terminal, and a second electrode electrically connected to the first node; and
a ninth switching transistor that is a P-type transistor, wherein the ninth switching transistor has a gate electrically connected to the second node, a first electrode electrically connected to the first power terminal, and a second electrode electrically connected to the first node,
wherein the first output module is configured to output a signal of the first power terminal in response to a voltage of the first node.

18. The display panel according to claim 16 or 17, wherein the first electrode of the eighth switching transistor is electrically connected to the second power terminal through a tenth switching transistor, and a gate of the tenth switching transistor is electrically connected to the second power terminal.

19. The display panel according to claim 16 or 17, wherein the second electrode of the ninth switching transistor and the second electrode of the eighth switching transistor are electrically connected to the first node through an eleventh switching transistor, and a gate of the eleventh switching transistor is electrically connected to the second power terminal.

20. The display panel according to claim 15, wherein the first driving module further comprises a twelfth switching transistor, and the twelfth switching transistor has a gate electrically connected to the second node, a first electrode electrically connected to a fourth clock terminal, and a second electrode electrically connected to the second node through a first capacitor.

21. The display panel according to claim 15, wherein the first driving module further comprises:
a thirteenth switching transistor, wherein the thirteenth switching transistor has a gate electrically connected to the third clock terminal and a first electrode electrically connected to the shift input terminal;
a fourteenth switching transistor, wherein the fourteenth switching transistor has a gate and a first electrode both electrically connected to a second electrode of the thirteenth switching transistor, and a second electrode electrically connected to the second node; and
a fifteenth switching transistor, wherein the fifteenth switching transistor has a gate electrically connected to the second electrode of the thirteenth switching transistor, a first electrode electrically connected to a fourth clock terminal, and a second electrode electrically connected to the gate of the fourteenth switching transistor through a second capacitor.

22. The display panel according to claim 21, wherein the first driving module further comprises:
a sixteenth switching transistor, wherein the sixteenth switching transistor has a gate electrically connected to the first node, a first electrode electrically connected to the first power terminal, and a second electrode electrically connected to the second electrode of the fifteenth switching transistor.

23. The display panel according to claim 15, wherein the first control unit comprises:
a seventeenth switching transistor, wherein the seventeenth switching transistor has a gate electrically connected to the shift input terminal, a first electrode electrically connected to the first power terminal, and a second electrode electrically connected to a third clock terminal through a third capacitor;
an eighteenth switching transistor, wherein the eighteenth switching transistor has a gate electrically connected to the second electrode of the seventeenth switching transistor, a first electrode electrically connected to the third clock terminal, and a second electrode electrically connected to the first node; and
a nineteenth switching transistor, wherein the nineteenth switching transistor has a gate electrically connected to the second node, a first electrode electrically connected to the first power terminal, and a second electrode electrically connected to the first node,
wherein the second output module is configured to output a voltage of the first power terminal to the second terminal in response to a first level of the third node, and output a voltage of the first clock terminal to the second terminal in response to a first level of the fourth node,
wherein the second driving module comprises a fifth switching transistor, and the fifth switching transistor has a gate electrically connected to a second clock terminal, and a second electrode electrically connected to the fourth node,
wherein a first electrode of the fifth switching transistor in an i-th-stage shift unit is electrically connected to the second terminal of an (i-1)-th-stage shift unit; and for a same shift unit, during a time period in which the third node is at a second level, the second terminal connected to the fifth switching transistor outputs a first level, and the first level overlaps with a first level provided by the second clock terminal connected to the fifth switching transistor, and
wherein the third clock terminal and the second clock terminal are electrically connected to a same first signal pin.

24. The display panel according to claim 15, wherein the first control unit comprises:
a seventeenth switching transistor, wherein the seventeenth switching transistor has a gate electrically connected to the shift input terminal, a first electrode electrically connected to the first power terminal, and a second electrode electrically connected to a fourth clock terminal through a third capacitor;
an eighteenth switching transistor, wherein the eighteenth switching transistor has a gate electrically connected to the second electrode of the seventeenth switching transistor, a first electrode electrically connected to the fourth clock terminal, and a second electrode electrically connected to the first node; and
a nineteenth switching transistor, wherein the nineteenth switching transistor has a gate electrically connected to the second node, a first electrode electrically connected to the first power terminal, and a second electrode electrically connected to the first node.

25. The display panel according to claim 24, wherein the second output module is configured to output a voltage of the first power terminal to the second terminal in response to a first level of the third node, and output a voltage of the first clock terminal to the second terminal in response to a first level of the fourth node; and
the second driving module comprises a fifth switching transistor, and the fifth switching transistor has a gate electrically connected to a second clock terminal, and a second electrode electrically connected to the fourth node,
wherein a first electrode of the fifth switching transistor in an i-th-stage shift unit is electrically connected to the second terminal of an (i-1)-th-stage shift unit; and for a same shift unit, during a time period in which the third node is at a second level, the second terminal connected to the fifth switching transistor outputs a first level, and the first level overlaps with a first level provided by the second clock terminal connected to the fifth switching transistor, and
wherein the third clock terminal and the second clock terminal are electrically connected to a same first signal pin, and the fourth clock terminal and one first clock terminal are electrically connected to a same second signal pin.

26. The display panel according to claim 15, wherein the third node is electrically connected to the second node; or
the seventh switching transistor is electrically connected to the second node through a first protection switching transistor, a gate of the first protection switching transistor is electrically connected to a second power terminal, and the third node is electrically connected to the second electrode of the seventh switching transistor.

27. The display panel according to claim 15, wherein the first output module comprises:
a twentieth switching transistor, wherein the twentieth switching transistor has a gate electrically connected to the first node, a first electrode electrically connected to the third clock terminal or the first power terminal, and a second electrode electrically connected to an output terminal; and
a twenty-first switching transistor, wherein the twenty-first switching transistor has a gate electrically connected to the second node, a first electrode electrically connected to a second power terminal, and a second electrode electrically connected to the output terminal.

28. The display panel according to claim 2, wherein the first output module comprises the first terminal and is configured to provide a signal to the first terminal.

29. The display panel according to claim 2, wherein the first circuit comprises a shift control sub-circuit and a region-wise control sub-circuit,
wherein the shift control sub-circuit comprises the first driving module and the first output module, the first driving module comprises a shift input terminal, the first output module comprises a shift output terminal, and in two consecutive shift units, the shift output terminal of an upstream shift unit is electrically connected to the shift input terminal of a downstream shift unit; and
the region-wise control sub-circuit comprises the first terminal, and the region-wise control sub-circuit is configured to output a signal to the first terminal based on a region-wise control signal.

30. The display panel according to claim 29, wherein the region-wise control sub-circuit comprises:
a twenty-second switching transistor, wherein the twenty-second switching transistor has a gate electrically connected to the first node, a first electrode electrically connected to a region-wise control terminal, and a second electrode electrically connected to the first terminal; and
a twenty-third switching transistor, wherein the twenty-third switching transistor has a gate electrically connected to the second node, a first electrode electrically connected to a second power terminal, and a second electrode electrically connected to the first terminal.

31. The display panel according to claim 30, wherein the first output module is configured to output a signal of a third clock terminal in response to a voltage of the first node; and
the display panel comprises a first region and a second region,
wherein in a first display mode, a driving frequency of the first region is same as a driving frequency of the second region, and a level state of a signal provided by the region-wise control terminal is consistent with a level state of a signal provided by the third clock terminal; and
in a second display mode, the driving frequency of the second region is less than the driving frequency of the first region, and in a subset of frames, when driving the second region, the region-wise control terminal provides a level for controlling the first transistor to be turned off.

32. The display panel according to claim 30, wherein the first output module is configured to output a signal of the first power terminal in response to a voltage of the first node; and
the display panel comprises a first region and a second region,
wherein in a first display mode, a driving frequency of the first region is same as a driving frequency of the second region, and the region-wise control terminal provides a level for controlling the first transistor to be turned on; and
in a second display mode, the driving frequency of the second region is less than the driving frequency of the first region, and in a subset of frames, when driving the second region, the region-wise control terminal provides a level for controlling the first transistor to be turned off.

33. The display panel according to claim 30, wherein the region-wise control sub-circuit comprises a third driving module and a third output module,
wherein the third output module is configured to output a level for controlling the first transistor to be turned on to the first terminal in response to a voltage of a fifth node, and output a level for controlling the first transistor to be turned off to the first terminal in response to a voltage of the second node; and
the third driving module comprises a twenty-fourth switching transistor and a second control unit, wherein the twenty-fourth switching transistor has a gate electrically connected to the shift control sub-circuit, a first electrode electrically connected to the second power terminal, and a second electrode electrically connected to the fifth node, and within at least a subset of time periods, a level state of a signal at the gate of the twenty-fourth switching transistor is consistent with a level state of a signal at the second node; and the second control unit is electrically connected to a region-wise control terminal and the first driving module, and the second control unit is configured to control a signal of the fifth node.

34. The display panel according to claim 33, wherein the second control unit comprises:
a twenty-fifth switching transistor, wherein the twenty-fifth switching transistor has a gate electrically connected to the region-wise control terminal, a first electrode electrically connected to the first node, and a second electrode electrically connected to the fifth node.

35. The display panel according to claim 34, wherein the shift register comprises at least two cascaded unit groups, and the unit group comprises a plurality of cascaded shift units; and
in two consecutive unit groups, the region-wise control terminals of the shift units in one unit group are electrically connected to a first control line, and the region-wise control terminals of the shift units in the other unit group are electrically connected to a second control line.

36. The display panel according to claim 33, wherein the second control unit comprises:
a twenty-sixth switching transistor, wherein the twenty-sixth switching transistor has a gate electrically connected to the shift control sub-circuit, a first electrode electrically connected to the region-wise control terminal, and within at least a subset of time periods, a level state of a signal at the gate of the twenty-sixth switching transistor is consistent with a level state of a signal at the second node; and
a twenty-seventh switching transistor, wherein the twenty-seventh switching transistor has a gate electrically connected to a second electrode of the twenty-sixth switching transistor, a first electrode electrically connected to the first node, and a second electrode electrically connected to the fifth node.

37. The display panel according to claim 36, wherein the gate of the twenty-sixth switching transistor is electrically connected to the second node, or the gate of the twenty-sixth switching transistor is electrically connected to the shift output terminal.

38. The display panel according to claim 33, wherein the gate of the twenty-fourth switching transistor is electrically connected to the second node.

39. The display panel according to claim 29, wherein the region-wise control sub-circuit comprises a third driving module and a third output module,
wherein the third output module is configured to output a level for controlling the first transistor to be turned on to the first terminal in response to a first level of a fifth node, and output a level for controlling the first transistor to be turned off to the first terminal in response to a voltage of the second node; and
the first driving module comprises a twenty-eighth switching transistor and a third control unit, wherein the twenty-eighth switching transistor has a gate electrically connected to the shift control sub-circuit, a first electrode electrically connected to the region-wise control terminal, and within at least a subset of time periods, a level state of a signal at the gate of the twenty-eighth switching transistor is consistent with a level state of a signal at the second node; and a control terminal of the third control unit is electrically connected to a second electrode of the twenty-eighth switching transistor, and the third control unit, when turned on, provides a second level to the fifth node.

40. The display panel according to claim 39, wherein the second control unit comprises a twenty-ninth switching transistor that is an N-type transistor and a thirtieth switching transistor that is a P-type transistor,
wherein a gate of the twenty-ninth switching transistor and a gate of the thirtieth switching transistor are both electrically connected to the second electrode of the twenty-eighth switching transistor, and a second electrode of the twenty-ninth switching transistor and a second electrode of the thirtieth switching transistor are both electrically connected to the fifth node, and
a first electrode of the twenty-ninth switching transistor is electrically connected to the first node, and a first electrode of the thirtieth switching transistor is electrically connected to the first power terminal; or the first electrode of the twenty-ninth switching transistor is electrically connected to the first power terminal, and the first electrode of the thirtieth switching transistor is electrically connected to the first node.

41. The display panel according to claim 39, wherein the gate of the twenty-eighth switching transistor is electrically connected to the shift output terminal or the second node.

42. The display panel according to claim 1, wherein the pixel circuit further comprises a driving transistor;
the first transistor comprises a gate reset transistor and a threshold compensation transistor that are N-type transistors, wherein the gate reset transistor has a gate electrically connected to a first scan line, a first electrode electrically connected to a first reset line, and a second electrode electrically connected to a gate of the driving transistor; and the threshold compensation transistor has a gate electrically connected to a second scan line, a first electrode electrically connected to a second electrode of the driving transistor, and a second electrode electrically connected to the gate of the driving transistor;
the second transistor comprises a data writing transistor that is a P-type transistor, wherein the data writing transistor has a gate electrically connected to a third scan line, a first electrode electrically connected to a data line, and a second electrode electrically connected to a first electrode of the driving transistor; and
the first terminals of at least a subset of the shift units are electrically connected to the first scan line and/or the second scan line, and the second terminals of at least a subset of the shift units are electrically connected to the third scan line.

43. The display panel according to claim 42, wherein the shift register comprises a first shift register, wherein the first terminal of a shift unit in the first shift register is electrically connected to the second scan line, and the second terminal of the shift unit in the first shift register is electrically connected to the third scan line;
the shift register further comprises a second shift register, wherein the first terminal of a shift unit in the second shift register is electrically connected to the first scan line, and the second terminals of a subset of the shift units in the second shift register are electrically connected to the third scan line;
the shift unit comprises m second terminals, where m≥2; and
the pixel circuit comprises a plurality of circuit groups arranged along a first direction, the circuit group comprises m circuit rows arranged along the first direction, the circuit row comprises a plurality of pixel circuits arranged along a second direction, and the first direction intersects with the second direction,
wherein in the first shift register, the m second terminals of an a1-th-stage shift unit are electrically connected to third scan lines corresponding to the m circuit rows in an a1-th circuit group respectively, and the first terminal of the a1-th-stage shift unit is electrically connected to second scan lines corresponding to the a1-th circuit group, where a1≥1; and
wherein in the second shift register, the m second terminals of an a2-th-stage shift unit are electrically connected to the third scan lines corresponding to the m circuit rows in an a1-th circuit group respectively, and the first terminal of the a2-th-stage shift unit is electrically connected to the first scan line corresponding to an a3-th circuit group, where a2>a1, and a3>a1.

44. The display panel according to claim 42, wherein the shift register comprises a third shift register, wherein the first terminal of a shift unit in the third shift register is electrically connected to the first scan line and the second scan line, and the second terminals of a subset of the shift units in the third shift register are electrically connected to the third scan line and the second scan line;
the shift unit comprises m second terminals, where m≥2; and
the pixel circuit comprises a plurality of circuit groups arranged along a first direction, the circuit groups comprises m circuit rows arranged along the first direction, the circuit row comprises a plurality of pixel circuits arranged along a second direction, and the first direction intersects with the second direction,
wherein for a b-th circuit group, third scan lines corresponding to the m circuit rows are respecively connected to the m second terminals of a c1-th-stage shift unit in the third shift register, second scan lines corresponding to the m circuit rows are electrically connected to the first terminal of the c1-th-stage shift unit in the third shift register, and first scan lines corresponding to the m circuit rows are electrically connected to the first terminal of a c2-th-stage shift unit in the third shift register, where b≥1, c1>b, and c2<c1.

45. A display device, comprising the display panel according to any one of claims 1 to 44.
